# EUROPEAN PATENT APPLICATION

(11) **EP 4 838 513 A1**
(43) Date of publication of application: **11.11.2026**
(21) Application number: 25832044.9
(22) Date of filing: 18.06.2025
(51) Int. Cl.: G09G 3/3208

(54) **DISPLAY SUBSTRATE AND PREPARATION METHOD THEREFOR, AND DISPLAY APPARATUS**

(30) Priority: 01.07.2024 CN 202410875079
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: LIU, Biao, Beijing 100176 (CN); YU, Ziyang, Beijing 100176 (CN); WANG, Miao, Beijing 100176 (CN); ZHANG, Yi, Beijing 100176 (CN); SONG, Gukhwan, Beijing 100176 (CN); QING, Haigang, Beijing 100176 (CN); WANG, Mengqi, Beijing 100176 (CN); LIU, Tingliang, Beijing 100176 (CN); XU, Peng, Beijing 100176 (CN); LIAO, Maoying, Beijing 100176 (CN)
(74) Representative: Durán-Corretjer, S.L.P.
(86) International application number: PCT/CN2025/101615
(87) International publication number: WO 2026/007690

(57) **Abstract**

A display substrate and a preparation method therefor, and a display apparatus. The display substrate comprises a plurality of circuit units. Each circuit unit comprises a pixel drive circuit, a first initial signal line, a second initial signal line and a third initial signal line, wherein the pixel drive circuit at least comprises a first transistor, a seventh transistor and an eighth transistor, the first initial signal line is connected to a first electrode of the first transistor, the second initial signal line is connected to a first electrode of the seventh transistor, and the third initial signal line is connected to a first electrode of the eighth transistor; and in at least one unit row, the pixel drive circuits in at least two adjacent circuit units share the first electrode of the first transistor, the pixel drive circuits in at least two adjacent circuit units share the first electrode of the seventh transistor, and the pixel drive circuits in at least two adjacent circuit units share the first electrode of the eighth transistor. In the present disclosure, pixel drive circuits share nodes, which is conductive to achieving a high resolution.

## Description

The present application claims the priority to Chinese Patent Application No. 202410875079.6 filed to the CNIPA on July 01, 2024 and entitled "Display Substrate and Preparation method Therefor, and Display Apparatus", contents of which should be construed as being incorporated into the present application by reference.

### Technical Field

The present disclosure relates to, but is not limited to, the field of display technologies, and particularly to a display substrate and a preparation method therefor, and a display apparatus.

### Background

An Organic Light Emitting Diode (OLED) and a Quantum dot Light Emitting Diode (QLED) are active light emitting display devices and have advantages of self-illumination, a wide viewing angle, a high contrast ratio, low power consumption, an extremely high reaction speed, lightness and thinness, flexibility, and a low cost, etc. With constant development of display technologies, a flexible display apparatus (Flexible Display) in which an OLED or a QLED is used as a light emitting device and signal control is performed through a Thin Film Transistor (TFT) has become a mainstream product in the field of display at present.

### Summary

The following is a summary of subject matters described herein in detail. This summary is not intended to limit the protection scope of claims.

In one aspect, the present disclosure provides a display substrate including a drive structure layer disposed on a base substrate and a light emitting structure layer disposed at a side of the drive structure layer away from the base substrate, wherein the drive structure layer includes a plurality of circuit units forming a plurality of unit rows and a plurality of unit columns, and at least one circuit unit includes a pixel drive circuit, a first initial signal line, a second initial signal line, and a third initial signal line; the pixel drive circuit includes at least a first transistor as a first initialization transistor, a seventh transistor as a second initialization transistor, and an eighth transistor as a third initialization transistor, wherein the first initial signal line is connected with a first electrode of the first transistor, the second initial signal line is connected with a first electrode of the seventh transistor, and the third initial signal line is connected with a first electrode of the eighth transistor; in at least one unit row, pixel drive circuits in at least two adjacent circuit units share the first electrode of the first transistor, the pixel drive circuits in at least two adjacent circuit units share the first electrode of the seventh transistor, and the pixel drive circuits in at least two adjacent circuit units share the first electrode of the eighth transistor.

In an exemplary implementation mode, the first transistor includes at least a first active layer, and the first initial signal line is connected with a first region of the first active layer through a sixth connection electrode; and in at least one unit row, pixel drive circuits in adjacent circuit units share the sixth connection electrode.

In an exemplary implementation mode, the seventh transistor includes at least a seventh active layer, and the second initial signal line is connected with a first region of the seventh active layer through a second initial connection block; in at least one unit row, pixel drive circuits in adjacent circuit units share the second initial connection block.

In an exemplary implementation mode, the eighth transistor includes at least an eighth active layer, and the third initial signal line is connected with a first region of the eighth active layer through a seventh connection electrode; in at least one unit row, pixel drive circuits in adjacent circuit units share the seventh connection electrode.

In an exemplary implementation mode, the first initial signal line, the second initial signal line, and the third initial signal line extend along a first direction, and the drive structure layer further includes a first initial connection line, a second initial connection line, and a third initial connection line extending along a second direction, the first direction intersects with the second direction. The first initial connection line is connected with the first initial signal line through a sixth connection electrode to form a mesh communication structure for transmitting a first initial signal, or the second initial connection line is connected with the second initial signal line through an eighth connection electrode to form a mesh communication structure for transmitting a second initial signal, or the third initial connection line is connected with the third initial signal line through a seventh connection electrode to form a mesh communication structure for transmitting a third initial signal.

In an exemplary implementation mode, the first initial connection line, the second initial connection line, and the third initial connection line are respectively disposed between adjacent unit columns, and the first initial connection line, the second initial connection line, the third initial connection line, and the second initial connection line are periodically disposed in the first direction.

In an exemplary implementation mode, the light emitting structure layer includes at least a plurality of red light emitting units that emit red light, a plurality of blue light emitting units that emit blue light, a plurality of first green light emitting units that emit green light, and a plurality of second green light emitting units that emit green light, wherein a red light emitting unit of the red light emitting units includes at least a first anode, a blue light emitting unit of the blue light emitting units includes at least a second anode, a first green light emitting unit of the first green light emitting units includes at least a third anode, and a second green light emitting unit of the second green light emitting units includes at least a fourth anode. At least one of the first anode, the second anode, the third anode, and the fourth anode includes a main body portion and a connection portion that are connected with each other, a first end of the connection portion is connected with the main body portion, and a second end of the connection portion is connected with an anode connection electrode in the pixel drive circuit through an anode via. Orthographic projections of a main body portion of the third anode and a main body portion of the fourth anode on the base substrate are at least partially overlapped with an orthographic projection of the first initial connection line on the base substrate, or orthographic projections of a main body portion of the third anode and a main body portion of the fourth anode on the base substrate are at least partially overlapped with an orthographic projection of the second initial connection line on the base substrate, or orthographic projections of a main body portion of the third anode and a main body portion of the fourth anode on the base substrate are at least partially overlapped with an orthographic projection of the third initial connection line on the base substrate.

In an exemplary implementation mode, in a direction perpendicular to the base substrate, the drive structure layer includes at least a first conductive layer disposed on the base substrate, a second conductive layer disposed at a side of the first conductive layer away from the base substrate, a third conductive layer disposed at a side of the second conductive layer away from the base substrate, and a fourth conductive layer disposed at a side of the third conductive layer away from the base substrate, the first initial signal line, the second initial signal line, and the third initial signal line are respectively disposed in at least one of the second conductive layer and the third conductive layer, and the first initial connection line, the second initial connection line, and the third initial connection line are disposed in the fourth conductive layer.

In an exemplary implementation mode, the drive structure layer further includes a first planarization layer disposed at a side of the third conductive layer away from the base substrate, and the fourth conductive layer is disposed at a side of the first planarization layer away from the base substrate. The at least one circuit unit further includes a connection via, and the third initial connection line is connected with the seventh connection electrode through the connection via, and at least another circuit unit further includes a dummy via, and the first initial connection line and/or the second initial connection line are at least partially disposed within the dummy via.

In an exemplary implementation mode, the light emitting structure layer includes at least a plurality of red light emitting units that emit red light, a plurality of blue light emitting units that emit blue light, a plurality of first green light emitting units that emit green light, and a plurality of second green light emitting units that emit green light. A red light emitting unit of the red light emitting units includes at least a first anode, a blue light emitting unit of the blue light emitting units includes at least a second anode, a first green light emitting unit of the first green light emitting units includes at least a third anode, and a second green light emitting unit of the second green light emitting units includes at least a fourth anode. At least one of the first anode, the second anode, the third anode, and the fourth anode includes a main body portion and a connection portion that are interconnected, wherein a first end of the connection portion is connected with the main body portion, and a second end of the connection portion is electrically connected with an anode connection electrode in the pixel drive circuit via an anode via. An orthographic projection of a main body portion of the third anode on the base substrate is at least partially overlapped with an orthographic projection of the connection via on the base substrate and an orthographic projection of a main body portion of the fourth anode on the base substrate is at least partially overlapped with an orthographic projection of the dummy via on the base substrate; or an orthographic projection of a main body portion of the third anode on the base substrate is at least partially overlapped with an orthographic projection of the dummy via on the base substrate and an orthographic projection of a main body portion of the fourth anode on the base substrate is at least partially overlapped with an orthographic projection of the connection via on the base substrate.

In an exemplary implementation mode, the light emitting structure layer includes at least a plurality of red light emitting units that emit red light, a plurality of blue light emitting units that emit blue light, a plurality of first green light emitting units that emit green light, and a plurality of second green light emitting units that emit green light. A red light emitting unit of the red light emitting units includes at least a first anode, a blue light emitting unit of the blue light emitting units includes at least a second anode, a first green light emitting unit of the first green light emitting units includes at least a third anode, and a second green light emitting unit of the second green light emitting units includes at least a fourth anode. At least one of the first anode, the second anode, the third anode, and the fourth anode includes a main body portion and a connection portion that are interconnected. A first end of the connection portion is connected with the main body portion and a second end of the connection portion is connected with an anode connection electrode in the pixel drive circuit via an anode via. An orthographic projection of a main body portion of the third anode on the base substrate is at least partially non-overlapped with an orthographic projection of the connection via on the base substrate and an orthographic projection of a main body portion of the fourth anode on the base substrate is at least partially non-overlapped with an orthographic projection of the dummy via on the base substrate; or an orthographic projection of a main body portion of the third anode on the base substrate is at least partially non-overlapped with an orthographic projection of the dummy via on the base substrate and an orthographic projection of a main body portion of the fourth anode on the base substrate is at least partially non-overlapped with an orthographic projection of the connection via on the base substrate.

In an exemplary implementation mode, the eighth connection electrode includes a connection electrode strip and a connection electrode block, the connection electrode strip has a strip shape extending along the second direction and the connection electrode block has a block shape, a first end of the connection electrode strip is connected with the second initial signal line, a second end of the connection electrode strip extends along a direction away from the second initial signal line and is connected with the connection electrode block, and the second initial connection line is connected with the connection electrode block through a via. The at least one circuit unit further includes a dummy electrode strip, a first end of the dummy electrode strip is connected with the second initial signal line, a second end of the dummy electrode strip extends along the direction away from the second initial signal line, and the connection electrode strip and the dummy electrode strip are alternately disposed in the first direction.

In an exemplary implementation mode, the at least one circuit unit further includes a dummy electrode block and a dummy via, the dummy electrode block is in a block shape and is connected with the second end of the dummy electrode strip, an orthographic projection of the dummy via on the base substrate is within a range of an orthographic projection of the dummy electrode block on the base substrate, and the first initial connection line and/or the third initial connection line are at least partially disposed within the dummy via.

In an exemplary implementation mode, the connection electrode block and the dummy electrode block are located on one straight line extending along the first direction.

In an exemplary implementation mode, the light emitting structure layer includes at least a plurality of red light emitting units that emit red light, a plurality of blue light emitting units that emit blue light, a plurality of first green light emitting units that emit green light, and a plurality of second green light emitting units that emit green light, a red light emitting unit of the red light emitting units includes at least a first anode, a blue light emitting unit of the blue light emitting units includes at least a second anode, a first green light emitting unit of the first green light emitting units includes at least a third anode, and a second green light emitting unit of the second green light emitting units includes at least a fourth anode. At least one of the first anode, the second anode, the third anode, and the fourth anode includes a main body portion and a connection portion that are interconnected. A first end of the connection portion is connected with the main body portion, and a second end of the connection portion is connected with an anode connection electrode in the pixel drive circuit through an anode via. An orthographic projection of a main body portion of the third anode on the base substrate is at least partially overlapped with an orthographic projection of the connection electrode strip on the base substrate and an orthographic projection of a main body portion of the fourth anode on the base substrate is at least partially overlapped with an orthographic projection of the dummy electrode strip on the base substrate; or, an orthographic projection of a main body portion of the third anode on the base substrate is at least partially overlapped with an orthographic projection of the dummy electrode strip on the base substrate and an orthographic projection of a main body portion of the fourth anode on the base substrate is at least partially overlapped with an orthographic projection of the connection electrode strip on the base substrate.

In an exemplary implementation mode, the pixel drive circuit further includes a second transistor as a compensation transistor and a third transistor as a drive transistor, wherein a first electrode of the second transistor is connected with a second electrode of the first transistor and a gate electrode of the third transistor, respectively, and a second electrode of the second transistor is connected with a second electrode of the third transistor, and the first transistor and the second transistor are of a dual-gate structure.

In an exemplary implementation mode, the drive structure layer further includes a plurality of data signal lines extending along a second direction, a plurality of first connection lines extending along a first direction, and a plurality of second connection lines extending along the second direction, wherein the first direction intersects with the second direction; at least one data signal line is connected with a plurality of pixel drive circuits of one unit column, first ends of the plurality of first connection lines are correspondingly connected with the plurality of data signal lines, and second ends of the plurality of first connection lines are correspondingly connected with the plurality of second connection lines.

In an exemplary implementation mode, the light emitting structure layer includes at least a plurality of red light emitting units that emit red light, a plurality of blue light emitting units that emit blue light, a plurality of first green light emitting units that emit green light, and a plurality of second green light emitting units that emit green light, wherein a red light emitting unit of the red light emitting units includes at least a first anode, a blue light emitting unit of the blue light emitting units includes at least a second anode, a first green light emitting unit of the first green light emitting units includes at least a third anode, and a second green light emitting unit of the second green light emitting unit includes at least a fourth anode. At least one of the first anode, the second anode, the third anode, and the fourth anode includes a main body portion and a connection portion that are interconnected. A first end of the connection portion is connected with the main body portion, and a second end of the connection portion is connected with an anode connection electrode in the pixel drive circuit through an anode via, and orthographic projections of a main body portion of the first anode and a main body portion of the second anode on the base substrate are at least partially overlapped with an orthographic projection of a second connection line of the second connection lines on the base substrate.

In an exemplary implementation mode, the drive structure layer further includes a data connection electrode, and the second connection line is connected with the data connection electrode through a via, an orthographic projection of the data connection electrode on the base substrate is within a range of an orthographic projection of a main body portion of the first anode on the base substrate, and/or the orthographic projection of the data connection electrode on the base substrate is within a range of an orthographic projection of a main body portion of the second anode on the base substrate.

In another aspect, the present disclosure further provides a display substrate including a plurality of circuit units forming a plurality of unit rows and a plurality of unit columns, at least one circuit unit includes a pixel drive circuit and at least one initial signal line. The pixel drive circuit includes at least one initialization transistor, and the initial signal line is connected with the initialization transistor through a connection electrode. In at least one unit row, two initialization transistors in adjacent circuit units are connected with the connection electrode through a same via, or two connection electrodes in adjacent circuit units are connected with the initial signal line through a same via.

In yet another aspect, the present disclosure further provides a display apparatus, including the aforementioned display substrate.

In yet another aspect, the present disclosure further provides a preparation method of a display substrate, including: forming a drive structure layer on a base substrate; wherein the drive structure layer includes a plurality of circuit units forming a plurality of unit rows and a plurality of unit columns, and at least one circuit unit includes a pixel drive circuit, a first initial signal line, a second initial signal line, and a third initial signal line; the pixel drive circuit includes at least a first transistor as a first initialization transistor, a seventh transistor as a second initialization transistor, and an eighth transistor as a third initialization transistor, wherein the first initial signal line is connected with a first electrode of the first transistor, the second initial signal line is connected with a first electrode of the seventh transistor, and the third initial signal line is connected with a first electrode of the eighth transistor; in at least one unit row, pixel drive circuits in at least two adjacent circuit units share the first electrode of the first transistor, the pixel drive circuits in at least two adjacent circuit units share the first electrode of the seventh transistor, and the pixel drive circuits in at least two adjacent circuit units share the first electrode of the eighth transistor; and forming, on the drive structure layer, a light emitting structure layer.

After drawings and detailed description are read and understood, other aspects may be understood.

### Brief Description of Drawings

Accompanying drawings are used to provide an understanding of technical solutions of the present disclosure, and constitute a part of the specification. The accompanying drawings, together with embodiments of the present disclosure, are used to explain the technical solutions of the present disclosure, and do not constitute limitations on the technical solutions of the present disclosure.
FIG. 1 is a schematic diagram of a structure of a display apparatus.
FIG. 2 is a schematic diagram of a structure of a display substrate.
FIG. 3 is a schematic diagram of a planar structure of a display region in a display substrate.
FIG. 4 is a schematic diagram of a cross-sectional structure of a display region in a display substrate.
FIG. 5 is an equivalent circuit diagram of a pixel drive circuit.
FIG. 6 is a schematic diagram of a structure of a data connection line according to an exemplary embodiment of the present disclosure.
FIG. 7 is a schematic diagram of a structure of a display substrate according to an exemplary embodiment of the present disclosure.
FIG. 8 is a schematic diagram of a structure of another display substrate according to an exemplary embodiment of the present disclosure.
FIG. 9 is a schematic diagram after a pattern of a semiconductor layer is formed according to an embodiment of the present disclosure.
FIGs. 10A and 10B are schematic diagrams after a pattern of a first conductive layer is formed according to an embodiment of the present disclosure.
FIGs. 11A and 11B are schematic diagrams after a pattern of a second conductive layer is formed according to an embodiment of the present disclosure.
FIG. 12 is a schematic diagram after a pattern of a fourth insulation layer is formed according to an embodiment of the present disclosure.
FIGs. 13A, 13B, and 13C are schematic diagrams after a pattern of a third conductive layer is formed according to an embodiment of the present disclosure.
FIG. 14 is a schematic diagram after patterns of a fifth insulation layer and a first planarization layer are formed according to an embodiment of the present disclosure.
FIGs. 15A and 15B are schematic diagrams after a pattern of a fourth conductive layer is formed according to an embodiment of the present disclosure.
FIG. 16 is a schematic diagram after a pattern of a second planarization layer is formed according to an embodiment of the present disclosure.
FIGs. 17A and 17B are schematic diagrams after a pattern of an anode conductive layer is formed according to an embodiment of the present disclosure.
FIG. 17C is a schematic diagram of a positional relationship between the anode conductive layer and a third conductive layer in FIG. 17A.

Reference signs are described as follows.

| | | | | | |
|---|---|---|---|---|---|
| 11- | first active layer; | 12- | second active layer; | 13- | third active layer; |
| 14- | fourth active layer; | 15- | fifth active layer; | 16- | sixth active layer; |
| 17- | seventh active layer; | 18- | eighth active layer; | 21- | first scan signal line; |
| 22- | second scan signal line; | 23- | third scan signal line; | 24- | light emitting signal line; |
| 31- | first electrode plate; | 32- | second electrode plate; | 33- | opening; |
| 34- | plate connection strip; | 41- | first initial signal line; | 42- | second initial signal line; |
| 43- | third initial signal line ; | 51- | first connection electrode; | 52- | second connection electrode; |
| 53- | third connection electrode; | 54- | fourth connection electrode; | 55- | fifth connection electrode; |
| 56- | sixth connection electrode; | 57- | seventh connection electrode; | 58- | eighth connection electrode; |
| 59- | dummy electrode strip; | 61- | first shield electrode; | 62- | second shield electrode; |
| 63- | third shield electrode; | 64- | fourth shield electrode; | 71- | first power supply line; |
| 72- | data signal line; | 73- | anode connection electrode; | 80- | data leading-out line; |
| 81- | first connection line; | 82- | second connection line; | 83- | data connection electrode; |
| 84- | data connection block; | 90A- | first anode; | 90B- | second anode; |
| 90C- | third anode; | 90D- | fourth anode; | 91- | first initial connection line; |
| 92- | second initial connection line; | 93- | third initial connection line; | 100- | display region; |
| 101- | base substrate; | 102- | drive structure layer; | 103- | light emitting structure layer; |
| 104- | encapsulation structure layer; | 200- | bonding region; | 300- | bezel region. |

### Detailed Description

To make objectives, technical solutions, and advantages of the present disclosure clearer, the embodiments of the present disclosure will be described in detail below with reference to the accompanying drawings. It is to be noted that implementation modes may be implemented in multiple different forms. Those of ordinary skills in the art may easily understand such a fact that modes and contents may be transformed into various forms without departing from the purpose and scope of the present disclosure. Therefore, the present disclosure should not be explained as being limited to contents recorded in following implementation modes only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third" and the like in the specification are set not to form limits in quantity but only to avoid confusion between constituent elements.

In the specification, for convenience, expressions "central", "above", "below", "front", "back", "vertical", "horizontal", "top", "bottom", "inside", "outside" and the like for indicating directional or positional relationships are used to illustrate positional relationships between the constituent elements with reference to the accompanying drawings, not to indicate or imply that a referred apparatus or element must have a specific orientation or be structured and operated in the specific orientation but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, a connection may be a fixed connection, or a detachable connection, or an integral connection; it may be a mechanical connection or an electrical connection; it may be a direct connection, or an indirect connection through a middleware, or internal communication between two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as a "source terminal" and a "drain terminal", are interchangeable in the specification.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, other elements with various functions, etc.

In the specification, "parallel" refers to a state in which an angle formed by two straight lines is above -10° and below 10°, and thus also includes a state in which the angle is above -5° and below 5°. In addition, "perpendicular" refers to a state in which an angle formed by two straight lines is above 80° and below 100°, and thus also includes a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

A triangle, rectangle, trapezoid, pentagon, hexagon, or the like in the specification is not strictly defined, and it may be an approximate triangle, rectangle, trapezoid, pentagon, hexagon, or the like. There may be some small deformations caused by tolerance, and there may be a chamfer, an arc edge, deformation, etc. In the present disclosure, "about" means that a boundary is not defined so strictly and numerical values within process and measurement error ranges are allowed.

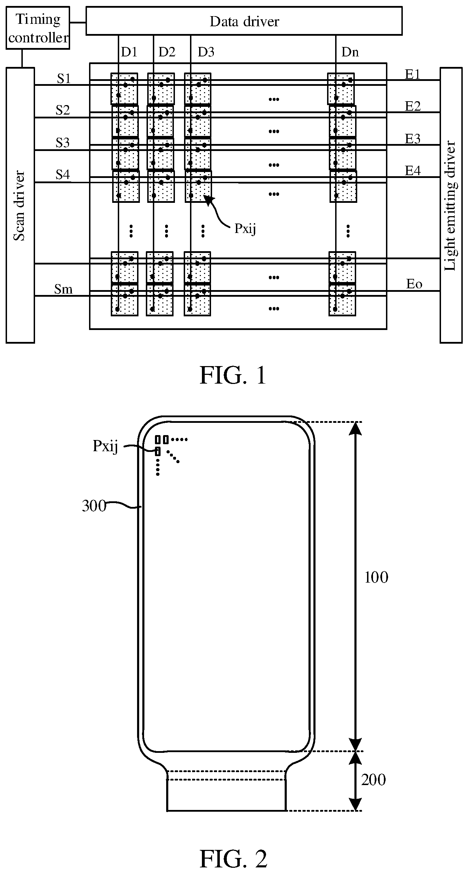

FIG. 1 is a schematic diagram of a structure of a display apparatus. As shown in FIG. 1, the display apparatus may include a timing controller, a data driver, a scan driver, a light emitting driver, and a pixel array. The timing controller is connected with the data driver, the scan driver, and the light emitting driver, respectively, the data driver is connected with a plurality of data signal lines (D1 to Dn) respectively, the scan driver is connected with a plurality of scan signal lines (S1 to Sm) respectively, and the light emitting driver is connected with a plurality of light emitting signal lines (E1 to Eo) respectively. The pixel array may include a plurality of sub-pixels Pxij, i and j may be natural numbers, at least one sub-pixel Pxij may include a circuit unit and a light emitting unit, the circuit unit may include, at least, a pixel drive circuit connected with a scan signal line, a light emitting signal line, and a data signal line, respectively. The light emitting unit may include a light emitting device connected with the pixel drive circuit of the circuit unit. In an exemplary implementation mode, the timing controller may provide the data driver with a grayscale value and a control signal which are suitable for a specification of the data driver, provide the scan driver with a clock signal and a scan start signal and the like which are suitable for a specification of the scan driver, and provide the light emitting driver with a clock signal and an emission stop signal and the like which are suitable for a specification of the light emitting driver. The data driver may generate a data voltage to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines D1 to Dn by taking a pixel row as a unit, wherein n may be a natural number. The scan driver may generate a scan signal to be provided to the scan signal lines S1, S2, S3, ..., and Sm by receiving the clock signal and the scan start signal and the like from the timing controller. For example, the scan driver may sequentially provide a scan signal with an on-level pulse to the scan signal lines S1 to Sm. For example, the scan driver may be constructed in a form of a shift register and may generate a scan signal in a manner in which a scan start signal provided in a form of an on-level pulse is transmitted to a next-stage circuit sequentially under control of the clock signal, wherein m may be a natural number. The light emitting driver may receive a clock signal, an emission stop signal, etc., from the timing controller to generate an emission signal to be provided to the light emitting signal lines E1, E2, E3, ..., and Eo. For example, the light emitting driver may sequentially provide an emission signal with an off-level pulse to the light emitting signal lines EM1 to Eo. The light emitting driver may be constructed in a form of a shift register and generate an emission signal in a manner of sequentially transmitting an emission stop signal provided in a form of an off-level pulse to a next-stage circuit under control of the clock signal, wherein o may be a natural number. In an exemplary implementation mode, the pixel array may be disposed on a display substrate.

FIG. 2 is a schematic diagram of a structure of a display substrate. As shown in FIG. 2, the display substrate may include a display region 100, a bonding region 200 located at a side of the display region 100, and a bezel region 300 located at other sides of the display region 100. In an exemplary implementation mode, the display region 100 may be a flat region, including multiple sub-pixels Pxij that form a pixel array, wherein the multiple sub-pixels Pxij are configured to display a dynamic picture or a static image, and the display region 100 may be referred to as an Active Area (AA). In an exemplary implementation mode, the display substrate may be a flexible substrate, so that the display substrate may be deformable, for example, be curled, bent, folded, or rolled.

In an exemplary implementation mode, the bonding region 200 may include a leading-out line region, a bending region, a drive chip region, and a bonding pin region, which are sequentially disposed along a direction away from the display region, and the leading-out line region is connected to the display region 100, and at least includes a data leading-out line. The bending region is connected to the leading-out line region and may at least include a composite insulation layer provided with a groove, the groove is configured to enable the bonding region to be bent to a back of the display region. The drive chip region may include an Integrated Circuit (IC for short), and the Integrated Circuit is configured to be connected with a plurality of data leading-out lines. The bonding pin region may include a Bonding Pad, and the Bonding Pad is configured to be bonded and connected with an external Flexible Printed Circuit (FPC for short).

In an exemplary implementation mode, the bezel region 300 may include a circuit region, a power supply line region, a crack dam region, and a cutting region which are sequentially disposed along the direction away from the display region 100. The circuit region is connected to the display region100 and may at least include a gate drive circuit connected with a scan signal line and a light emitting signal line in the display region 100. The power supply line region is connected to the circuit region and may at least include a bezel power supply lead, wherein the bezel power supply lead extends along a direction parallel to an edge of the display region and is connected with a cathode in the display region 100. The crack dam region is connected to the power supply line region and may at least include a plurality of cracks disposed on the composite insulation layer. The cutting region is connected to the crack dam region and may at least include a cutting groove disposed on the composite insulation layer, wherein the cutting groove is configured such that cutting is performed along the cutting groove by a cutting device respectively after all film layers of the display substrate are prepared.

In an exemplary implementation mode, the leading-out line region in the bonding region 200 and the power supply line region in the bezel region 300 may be provided with a dam spacer, the dam spacer may extend along a direction parallel to an edge of the display region to form an annular structure surrounding the display region 100, wherein the edge of the display region is an edge of the display region at a side of the bonding region or the bezel region.

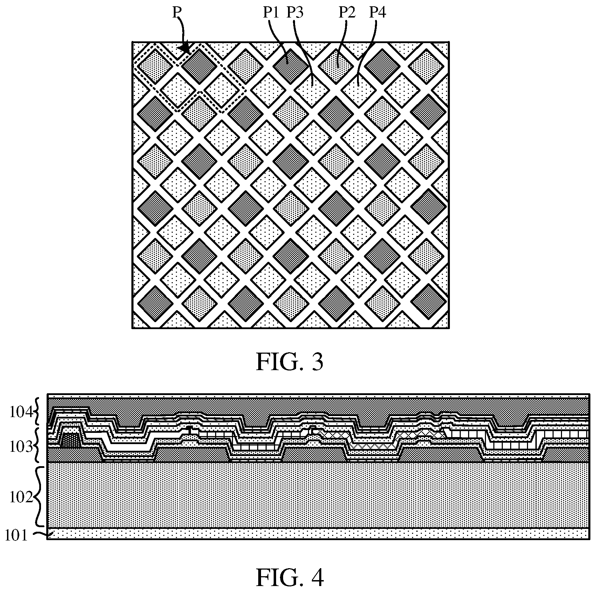

FIG. 3 is a schematic diagram of a planar structure of a display region in a display substrate. As shown in FIG. 3, the display region may include a plurality of pixel units P arranged in a matrix, and at least one of the pixel units P may include a first sub-pixel P1, a second sub-pixel P2, a third sub-pixel P3, and a fourth sub-pixel P4. Each sub-pixel may include a circuit unit and a light emitting unit. The circuit unit may at least include a pixel drive circuit, the pixel drive circuit is connected with a scan signal line, a light emitting signal line, and a data signal line respectively, and the pixel drive circuit is configured to receive a data voltage transmitted by the data signal line and output a corresponding current to the light emitting unit under control of the scan signal line and the light emitting signal line. The light emitting unit may include a light emitting device connected with a pixel drive circuit of a sub-pixel where the light emitting device is located, and the light emitting device is configured to emit light with corresponding brightness in response to a current output by the pixel drive circuit of the sub-pixel where the light emitting device is located.

In an exemplary implementation mode, the first sub-pixel P1 may be a red sub-pixel (R) emitting red light, the second sub-pixel P2 may be a blue sub-pixel (B) emitting blue light, the third sub-pixel P3 may be a first green sub-pixel (G1) emitting green light, and the fourth sub-pixel P4 may be a second green sub-pixel (G2) emitting green light. In an exemplary implementation mode, a sub-pixel may be in a shape of a rectangle, a diamond, a pentagon, or a hexagon. The four sub-pixels may be arranged in an RGBG manner.

In another exemplary implementation mode, the pixel unit may include three sub-pixels, wherein the three sub-pixels may be arranged side by side horizontally or side by side vertically, etc., which is not limited here in the present disclosure.

FIG. 4 is a schematic diagram of a cross-sectional structure of a display region in a display substrate, illustrating a structure of four sub-pixels in the display region. As shown in FIG. 4, on a plane perpendicular to the display substrate, the display region may include a drive structure layer 102 disposed on a base substrate 101, a light emitting structure layer 103 disposed at a side of the drive structure layer 102 away from the base substrate 101, and an encapsulation structure layer 104 disposed at a side of the light emitting structure layer 103 away from the base substrate 101. In some possible implementation modes, the display region may include other film layers, such as a touch structure layer, which is not limited here in the present disclosure.

In an exemplary implementation mode, the base substrate 101 may be a flexible base substrate, or may be a rigid base substrate. The drive structure layer 102 may include a plurality of circuit units, each circuit unit may at least include a pixel drive circuit formed by a plurality of transistors and a storage capacitor. The light emitting structure layer 103 may include a plurality of light emitting units. Each light emitting unit may include a light emitting device, and the light emitting device may at least include an anode, an organic emitting layer, and a cathode. The anode is connected with a pixel drive circuit. The organic emitting layer is connected with the anode. The cathode is connected with the organic emitting layer. The organic emitting layer emits light of a corresponding color under drive of the anode and the cathode. The encapsulation structure layer 104 may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is disposed between the first encapsulation layer and the third encapsulation layer to form a stacked structure of an inorganic material/an organic material/an inorganic material, which may ensure that external moisture cannot enter the light emitting structure layer 103.

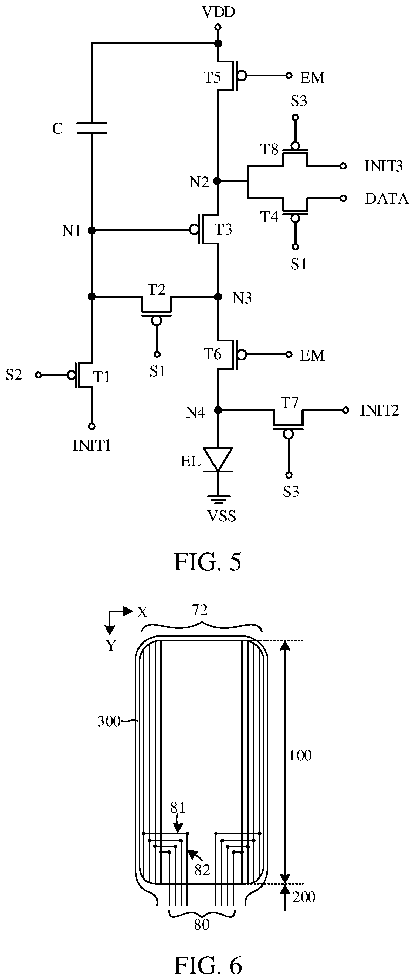

FIG. 5 is an equivalent circuit diagram of a pixel drive circuit. In an exemplary implementation mode, the pixel drive circuit may have a structure of 3T1C, 4T1C, 5T1C, 5T2C, 6T1C, 7T1C, or 8T1C, etc. As shown in FIG. 5, the pixel drive circuit may include eight transistors (a first transistor T1 to an eighth transistor T8) and one storage capacitor C, and the pixel drive circuit is connected with 9 signal lines (a first scan signal line S1, a second scan signal line S2, a third scan signal line S3, a light emitting signal line EM, a first initial signal line INIT1, a second initial signal line INIT2, a third initial signal line INIT3, a data signal line DATA, and a first power supply line VDD), respectively.

In an exemplary implementation mode, the pixel drive circuit may include a first node N1, a second node N2, a third node N3, and a fourth node N4. Herein, the first node N1 is connected with a second electrode of the first transistor, a first electrode of the second transistor T2, a gate electrode of the third transistor T3, and a first terminal of the storage capacitor C, respectively, the second node N2 is connected with a first electrode of the third transistor T3, a second electrode of the fourth transistor T4, a second electrode of the fifth transistor T5, and a second electrode of the eighth transistor T8, respectively, the third node N3 is connected with a second electrode of the second transistor T2, a second electrode of the third transistor T3, and a first electrode of the sixth transistor T6, respectively, and the fourth node N4 is connected with a second electrode of the sixth transistor T6 and a second electrode of the seventh transistor T7, respectively.

In an exemplary implementation mode, the first terminal of the storage capacitor C is connected with the first node N1, and a second terminal of the storage capacitor C is connected with the first power supply line VDD.

In an exemplary implementation mode, a gate electrode of the first transistor T1 is connected with the second scan signal line S2, a first electrode of the first transistor T1 is connected with the first initial signal line INIT1, and the second electrode of the first transistor is connected the first node N1.

In an exemplary implementation mode, a gate electrode of the second transistor T2 is connected with the first scan signal line S1, the first electrode of the second transistor T2 is connected with the first node N1, and the second electrode of the second transistor T2 is connected with the third node N3.

In an exemplary implementation mode, the gate electrode of the third transistor T3 is connected with the first node N1, the first electrode of the third transistor T3 is connected with the second node N2, and the second electrode of the third transistor T3 is connected with the third node N3.

In an exemplary implementation mode, a gate electrode of the fourth transistor T4 is connected with the first scan signal line S1, a first electrode of the fourth transistor T4 is connected with the data signal line DATA, and the second electrode of the fourth transistor T4 is connected with the second node N2.

In an exemplary implementation mode, a gate electrode of the fifth transistor T5 is connected with the light emitting signal line EM, a first electrode of the fifth transistor T5 is connected with the first power supply line VDD, and the second electrode of the fifth transistor T5 is connected with the second node N2.

In an exemplary implementation mode, a gate electrode of the sixth transistor T6 is connected with the light emitting signal line EM, the first electrode of the sixth transistor T6 is connected with the third node N3, and the second electrode of the sixth transistor T6 is connected with the fourth node N4.

In an exemplary implementation mode, a gate electrode of the seventh transistor T7 is connected with the third scan signal line S3, a first electrode of the seventh transistor T7 is connected with the second initial signal line INIT2, and the second electrode of the seventh transistor T7 is connected with the fourth node N4.

In an exemplary implementation mode, a gate electrode of the eighth transistor T8 is connected with the third scan signal line S3, a first electrode of the eighth transistor T8 is connected with the third initial signal line INIT3, and the second electrode of the eighth transistor T8 is connected with the second node N2.

In an exemplary implementation mode, the pixel drive circuit may achieve normal drive and low-frequency drive, and in scenarios with low refresh rate requirements, low-frequency refresh may be adopted to save power consumption. During normal drive, a drive time sequence of the pixel drive circuit may include four stages of initialization, compensation, data writing, and light emission, and during low-frequency drive, a drive time sequence of the pixel drive circuit may include six stages of initialization, compensation, data writing, light emission, adjustment, and re-emission. During the adjustment stage, a third initial signal (bias voltage) is written into the first electrode of the third transistor T3 by using the eighth transistor T8, so that a bias state of the third transistor T3 may be enabled to be consistent with a bias state when a data signal is just written, which may not only improve stability of a working state of the drive transistor and improve low-frequency flicker, but also may effectively improve a hysteresis situation of the third transistor, which is beneficial for improving residual images and enhancing a display effect.

In an exemplary implementation mode, a first electrode of a light emitting device EL is connected with the fourth node N4, and a second electrode of the light emitting device EL is connected with a second power supply line VSS. The light emitting device EL may be an OLED, including a first electrode (an anode), an organic emitting layer, and a second electrode (an cathode) which are stacked, or may be a QLED including a first electrode (an anode), a quantum dot emitting layer, and a second electrode (a cathode) which are stacked.

In an exemplary implementation mode, the first power supply line VDD is configured to provide a constant first power supply signal to the pixel drive circuit, the second power supply line VSS is configured to provide a constant second power supply signal to the light emitting device, and the first power supply signal is a high-level signal and the second power supply signal is a low-level signal. The first initial signal line INIT1, the second initial signal line INIT2, and the third initial signal line INIT3 are configured to provide a first initial signal, a second initial signal, and a third initial signal which are constant, respectively, to the pixel drive circuit, and the present disclosure is not limited here.

In an exemplary implementation mode, the first transistor T1 to the eighth transistor T8 in the pixel drive circuit may be P-type transistors or may be N-type transistors. Use of a same type of transistors in a pixel drive circuit may simplify a process flow, reduce a process difficulty of a display panel, and improve a product yield. In some possible implementation modes, the first transistor T1 to the eighth transistor T8 may include a P-type transistor and an N-type transistor.

In an exemplary implementation mode, for the first transistor T1 to the eighth transistor T8, a low temperature poly silicon transistor may be adopted, or an oxide transistor may be adopted, or a low temperature poly silicon transistor and an oxide transistor may be adopted. An active layer of a low temperature poly silicon transistor is made of Low Temperature Poly Silicon (LTPS), and an active layer of an oxide transistor is made of an oxide semiconductor (Oxide). The low temperature poly silicon transistor has advantages such as a high migration rate and fast charging, and the oxide transistor has advantages such as a low leakage current. The low temperature poly silicon transistor and the oxide transistor are integrated on one display substrate to form a Low Temperature Polycrystalline + Oxide (LTPO) display substrate, so that advantages of the low temperature poly silicon transistor and the oxide transistor may be utilized, low-frequency drive may be achieved, power consumption may be reduced, and display quality may be improved.

With development of OLED display technologies, consumers have higher and higher requirements on display effects and display quality of display products. Narrow bezels have become a new trend in development of display products, hence narrowing a bezel or even a borderless design has attracted more and more attention in designs of OLED display products. In a display substrate, a data signal of an integrated circuit in a bonding region needs to be introduced into a relatively wide display region in a fanout manner through a data leading-out line, so that a leading-out line region occupies relatively large space, resulting in a relatively large width of a lower bezel.

In order to reduce the width of the lower bezel, an exemplary embodiment of the present disclosure provides a display substrate in which a Fanout in Panel (FIP) structure is adopted. A plurality of data connection lines are disposed in a display region, the data connection lines may include a first connection line and a second connection line, first ends of a plurality of first connection lines are correspondingly connected with a plurality of data signal lines in the display region, second ends of the plurality of first connection lines are correspondingly connected with first ends of a plurality of second connection lines, and second ends of the plurality of second connection lines are correspondingly connected with an integrated circuit through a plurality of leading-out lines in a leading-out line region after extending to a bonding region. Since there is no need to dispose a fan-shaped oblique line in the leading-out line region, a width of the leading-out line region is reduced, and thus the width of the lower bezel is reduced.

FIG. 6 is a schematic diagram of a structure of a data connection line according to an exemplary embodiment of the present disclosure, and a FIP structure is adopted for the data connection line. As shown in FIG. 6, in a plane parallel to a display substrate, the display substrate may include a display region 100, a bonding region 200 located at a side of the display region 100, and a bezel region 300 located at other sides of the display region 100. A drive structure layer of the display region 100 may include a plurality of circuit units forming a plurality of unit rows and a plurality of unit columns, a plurality of data signal lines 72, a plurality of first connection lines 81, and a plurality of second connection lines 82, wherein at least one circuit unit may include a pixel drive circuit, and the pixel drive circuit is configured to output a corresponding current to a connected light emitting device. A light emitting structure layer of the display region 100 may include a plurality of light emitting units, at least one light emitting unit may include a light emitting device, the light emitting device is connected with a pixel drive circuit of a corresponding circuit unit, and the light emitting device is configured to emit light with corresponding brightness in response to a current outputted by the connected pixel drive circuit.

In an exemplary implementation mode, circuit units mentioned in the present disclosure refer to regions divided according to pixel drive circuits, and light emitting units mentioned in the present disclosure refer to regions divided according to light emitting devices. In an exemplary implementation mode, a position of an orthographic projection of a light emitting unit on a base substrate may correspond to a position of an orthographic projection of a circuit unit on the base substrate, or the position of the orthographic projection of the light emitting unit on the base substrate may not correspond to the position of the orthographic projection of the circuit unit on the base substrate.

In an exemplary implementation mode, a plurality of circuit units sequentially disposed along a first direction X may be referred to as a unit row, and a plurality of circuit units sequentially disposed along a second direction Y may be referred to as a unit column. A plurality of unit rows and a plurality of unit columns form a circuit unit array arranged in an array, and the first direction X intersects with the second direction Y.

In an exemplary implementation mode, the first direction X may be a unit row direction, the second direction Y may be a unit column direction, and the first direction X may be perpendicular to the second direction Y.

In an exemplary implementation mode, a shape of a first connection line 81 may be a straight line or a polyline extending along the first direction X, and shapes of a data signal line 72 and a second connection line 82 may be straight lines or polylines extending along the second direction Y. A plurality of data signal lines 72 are sequentially disposed at set intervals in the first direction X, at least one data signal line 72 is connected with a plurality of pixel drive circuits in one unit column, and the data signal line 72 is configured to provide a data signal to the connected pixel drive circuits. A first end of at least one first connection line 81 is connected with one data signal line 72, a second end thereof is connected with a first end of one second data connection line 82, and a second end of the second connection line 82 is connected with one data leading-out line 80 after extending to the bonding region, so that the data signal line 72 in the display region is connected with the data leading-out line 80 in the bonding region 200 through the first connection line 81 and the second connection line 82, to form a FIP structure (also referred to as a Fanout in AA (FIAA) structure). In an exemplary implementation mode, the first connection line 81 and the second connection line 82 are collectively referred to as data connection lines.

In an exemplary implementation mode, the bonding region 200 may include a leading-out line region, a bending region, a drive chip region, and a bonding pin region which are sequentially disposed along a direction away from the display region, wherein the leading-out line region is connected to the display region, and the bending region is connected to the leading-out line region. A plurality of data leading-out lines 80 may be disposed in the leading-out line region, the plurality of data leading-out lines 80 extend along the direction away from the display region, first ends of a part of the data leading-out lines 80 are connected correspondingly with second connection lines 82 in the display region 100, first ends of the other part of the data leading-out lines 80 are connected correspondingly with data signal lines 72 in the display region 100, and second ends of all data leading-out lines 80 cross the bending region along the second direction Y and then are connected with an integrated circuit of the drive chip region, so that the integrated circuit applies a data signal to a data signal line through a data leading-out line and a data connection line. Since the first connection line 81 and the second connection line 82 are disposed in the display region, a length of the leading-out region in the second direction Y may be effectively reduced, a width of a lower bezel may be greatly reduced, a screen ratio may be increased, and it is beneficial to achieve full-screen display.

In an exemplary implementation mode, a quantity of data connection lines in the display region may be the same as a quantity of data signal lines, each of the data signal lines is correspondingly connected with one leading-out line through one data connection line. Or, the quantity of data connection lines in the display region may be less than the quantity of data signal lines, and some of the data signal lines in the display region are connected with leading-out lines correspondingly through data connection lines, and the other data signal lines are directly connected with leading-out lines, which is not limited here in the present disclosure.

An exemplary embodiment of the present disclosure provides a display substrate including a drive structure layer disposed on a base substrate and a light emitting structure layer disposed at a side of the drive structure layer away from the base substrate, the drive structure layer includes a plurality of circuit units forming a plurality of unit rows and a plurality of unit columns, and at least one circuit unit includes a pixel drive circuit, a first initial signal line, a second initial signal line, and a third initial signal line. The pixel drive circuit includes a first transistor as a first initialization transistor, a seventh transistor as a second initialization transistor, and an eighth transistor as a third initialization transistor, the first initial signal line is connected with a first electrode of the first transistor, the second initial signal line is connected with a first electrode of the seventh transistor, and the third initial signal line is connected with a first electrode of the eighth transistor. In at least one unit row, pixel drive circuits in at least two adjacent circuit units share the first electrode of the first transistor, the pixel drive circuits in at least two adjacent circuit units share the first electrode of the seventh transistor, and the pixel drive circuits in at least two adjacent circuit units share the first electrode of the eighth transistor.

In an exemplary implementation mode, the first transistor includes at least a first active layer, and the first initial signal line is connected with a first region of the first active layer through a sixth connection electrode. In at least one unit row, pixel drive circuits in adjacent circuit units share the sixth connection electrode.

In an exemplary implementation mode, the seventh transistor includes at least a seventh active layer, and the second initial signal line is connected with a first region of the seventh active layer through a second initial connection block. In at least one unit row, the pixel drive circuits in adjacent circuit units share the second initial connection block.

In an exemplary implementation mode, the eighth transistor includes at least an eighth active layer, and the third initial signal line is connected with a first region of the eighth active layer through a seventh connection electrode. In at least one unit row, the pixel drive circuits in adjacent circuit units share the seventh connection electrode.

In an exemplary implementation mode, the pixel drive circuit further includes a second transistor as a compensation transistor and a third transistor as a drive transistor, wherein a first electrode of the second transistor is connected with a second electrode of the first transistor and a gate electrode of the third transistor, respectively, and a second electrode of the second transistor is connected with a second electrode of the third transistor, and the first transistor and the second transistor have a dual-gate structure.

In an exemplary implementation mode, the drive structure layer further includes a plurality of data signal lines extending along a second direction, a plurality of first connection lines extending along a first direction, and a plurality of second connection lines extending along the second direction, wherein the first direction intersects with the second direction. At least one data signal line is connected with a plurality of pixel drive circuits of one unit column, first ends of the plurality of first connection lines are correspondingly connected with the plurality of data signal lines, and second ends of the plurality of first connection lines are correspondingly connected with the plurality of second connection lines.

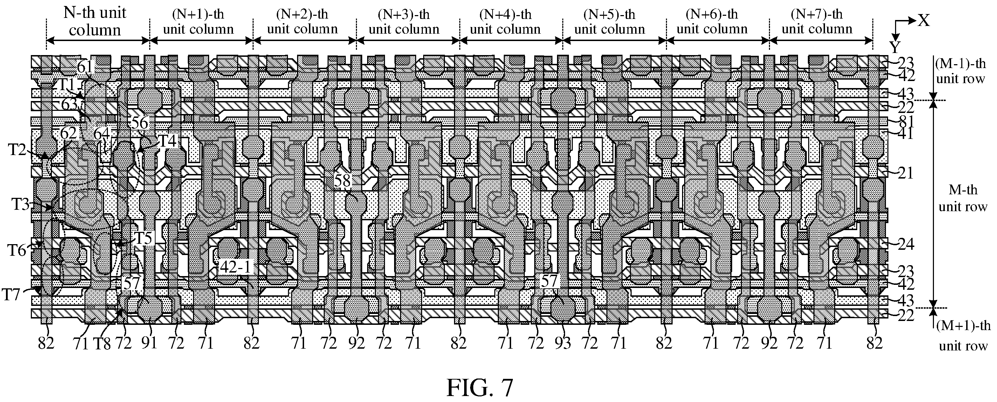

FIG. 7 is a schematic diagram of a structure of a display substrate according to an exemplary embodiment of the present disclosure, and illustrates a structure of eight circuit units with one circuit row (an M-th unit row) and eight circuit columns (an N-th unit column to an (N+7)-th unit column). As shown in FIG. 7, in a direction perpendicular to the display substrate, the display substrate may include at least a drive structure layer disposed on a base substrate and a light emitting structure layer disposed at a side of the drive structure layer away from the base substrate. The drive structure layer may include a plurality of circuit units constituting a plurality of unit rows and a plurality of unit columns in a plane parallel to the base substrate, and at least one circuit unit may include a pixel drive circuit that may be connected with a first scan signal line 21, a second scan signal line 22, a third scan signal line 23, a light emitting signal line 24, a first initial signal line 41, a second initial signal line 42, a third initial signal line 43, a first power supply line 71, and a data signal line 72, respectively. The first scan signal line 21 to the third scan signal line 23 are configured to provide a first scan signal to a third scan signal to a pixel drive circuit respectively. The light emitting signal line 24 is configured to provide a light emitting control signal to the pixel drive circuit. The first initial signal line 41 to the third initial signal line 43 are configured to provide a first initial signal to a third initial signal to the pixel drive circuit, respectively. The first power supply line 71 is configured to provide a first power supply signal to the pixel drive circuit, and the data signal line 72 is configured to provide a data signal to the pixel drive circuit. Herein, a plurality of signal lines connected with the pixel drive circuit may be located in a circuit unit.

In an exemplary implementation mode, the first scan signal line 21, the second scan signal line 22, the third scan signal line 23, the light emitting signal line 24, the first initial signal line 41, the second initial signal line 42, and the third initial signal line 43 may be in a shape of a straight line or a polyline with a main body portion extending along the first direction X, and the first power supply line 71 and the data signal line 72 may be in a shape of a straight line or a polyline with a main body portion extending along the second direction Y.

In the present disclosure, A extends along a B direction, which refers to that A may include a main portion and a secondary portion connected with the main portion, wherein the main portion is a line, a line segment, or a strip-shaped body, the main portion extends along the B direction, and a length of the main portion extending along the B direction is greater than a length of the secondary portion extending along another direction. In following description, "A extends along a B direction" means "a main body portion of A extends along the B direction".

In an exemplary implementation mode, the pixel drive circuit may include at least a storage capacitor and 8 poly silicon transistors. The eight poly silicon transistors may include a first transistor T1 as a first initialization transistor, a second transistor T2 as a compensation transistor, a third transistor T3 as a drive transistor, a fourth transistor T4 as a data writing transistor, a fifth transistor T5 as a first light emitting control transistor, a sixth transistor T6 as a second light emitting control transistor, a seventh transistor T7 as a second initialization transistor, and an eighth transistor T8 as a third initialization transistor, and the storage capacitor may include a first electrode plate and a second electrode plate which are stacked.

In an exemplary implementation mode, the first transistor T1 and the second transistor T2 may be transistors with a double-gate structure.

In an exemplary implementation mode, a gate electrode of the first transistor T1 is connected with the second scan signal line 22, a first electrode of the first transistor T1 is connected with the first initial signal line 41, and a second electrode of the first transistor T1 is respectively connected with a first electrode of the second transistor T2 and the first electrode plate (which is also a gate electrode of the third transistor T3) of the storage capacitor. A gate electrode of the second transistor T2 is connected with the first scan signal line 21, and a second electrode of the second transistor T2 is respectively connected with a second electrode of the third transistor T3 and a first electrode of the sixth transistor T6. A gate electrode of the fourth transistor T4 is connected with the first scan signal line 21, a first electrode of the fourth transistor T4 is connected with the data signal line 72, and a second electrode of the fourth transistor T4 is respectively connected with a first electrode of the third transistor T3, a second electrode of the fifth transistor T5, and a second electrode of the eighth transistor T8. A gate electrode of the fifth transistor T5 is connected with the light emitting signal line 24, and a first electrode of the fifth transistor T5 is connected with the first power supply line 71. A gate electrode of the sixth transistor T6 is connected with the light emitting signal line 24, and a second electrode of the sixth transistor T6 is connected with a second electrode of the seventh transistor T7. A gate electrode of the seventh transistor T7 is connected with the third scan signal line 23, and a first electrode of the seventh transistor T7 is connected with the second initial signal line 42. A gate electrode of the eighth transistor T8 is connected with the third scan signal line 23, and a first electrode of the seventh transistor T8 is connected with the third initial signal line 43.

In an exemplary implementation mode, in at least one circuit unit, the first scan signal line 21 may be disposed at a side of the storage capacitor (the third transistor T3) in an opposite direction of the second direction Y, the first initial signal line 41 may be disposed at a side of the first scan signal line 21 away from the storage capacitor, and the second scan signal line 22 may be disposed at a side of the first initial signal line 41 away from the storage capacitor, that is, the first initial signal line 41 is disposed between the first scan signal line 21 and the second scan signal line 22. The light emitting signal line 24 may be disposed at a side of the storage capacitor in the second direction Y, the third scan signal line 23 may be disposed at a side of the light emitting signal line 24 away from the storage capacitor, the second initial signal line 42 may be disposed at a side of the third scan signal line 23 away from the storage capacitor, and the third initial signal line 43 may be disposed at a side of the second initial signal line 42 away from the storage capacitor, that is, both the second initial signal line 42 and third initial signal line 43 are disposed at a side of the third scan signal line 23 away from the storage capacitor.

In an exemplary implementation mode, in at least one unit row, pixel drive circuits in adjacent circuit units may be disposed symmetrically with respect to a column center line, and the column center line may be a straight line located between two adjacent unit columns and extending along the second direction Y. For example, pixel drive circuits in an N-th unit column and an (N+1)-th unit column may be disposed symmetrically with respect to a column center line. For another example, pixel drive circuits in the (N+1)-th unit column and an (N+2)-th unit column may be disposed symmetrically with respect to a column center line. In an exemplary implementation mode, N may be a positive integer greater than 1.

In an exemplary implementation mode, in at least one unit row, pixel drive circuits in adjacent circuit units may share a first electrode of the first transistor T1, pixel drive circuits in adjacent circuit units may share a first electrode of the seventh transistor T7, and pixel drive circuits in adjacent circuit units may share a first electrode of the eighth transistor T8. For example, the pixel drive circuits in the N-th unit column and the (N+1)-th unit column may share the first electrode of the first transistor T1. The pixel drive circuits in the (N+1)-th unit column and the (N+2)-th unit column may share the first electrode of the seventh transistor T7, and the pixel drive circuits in the N-th unit column and the (N+1)-th unit column may share the first electrode of the eighth transistor T8.

In an exemplary implementation mode, in at least one circuit unit, the first transistor T1 may include at least a first active layer, the first initial signal line 41 may be connected with a first region of the first active layer through a sixth connection electrode 56, and the sixth connection electrode 56 may serve as a first electrode of the first transistor T1. In at least one unit row, first active layers in adjacent circuit units may be of an interconnected integral structure, pixel drive circuits in the adjacent circuit units share first regions of the first active layers, and the pixel drive circuits in the adjacent circuit units share a sixth connection electrode 56.

In an exemplary implementation mode, in at least one circuit unit, the seventh transistor T7 may include at least a seventh active layer, and the second initial signal line 42 may be connected with a first region of the seventh active layer through a second initial connection block 42-1, and the second initial connection block 42-1 may serve as a first electrode of the seventh transistor T7. In at least one unit row, seventh active layers in adjacent circuit units may be of an interconnected integral structure, pixel drive circuits in the adjacent circuit units share first regions of the seventh active layers, and the pixel drive circuits in the adjacent circuit units share a second initial connection block 42-1.

In an exemplary implementation mode, in at least one circuit unit, the eighth transistor T8 may include at least an eighth active layer, the third initial signal line 43 may be connected with a first region of the eighth active layer through a seventh connection electrode 57, and the seventh connection electrode 57 may serve as a first electrode of the eighth transistor T8. In at least one unit row, first regions of eighth active layers in adjacent circuit units may be symmetrically disposed with respect to a column center line, seventh connection electrodes 57 in the adjacent circuit units may be symmetrically disposed with respect to a column center line, and the seventh connection electrodes 57 in the adjacent circuit units may be of an interconnected integral structure.

In an exemplary implementation mode, the drive structure layer may further include at least one first initial connection line 91, at least one second initial connection line 92, and at least one third initial connection line 93, the first initial connection line 91, the second initial connection line 92, and the third initial connection line 93 may be in a shape of a straight line or a polyline extending along the second direction Y, and may be respectively disposed between data signal lines 72 of some adjacent unit columns, and two data signal lines 72 in adjacent unit columns may be disposed symmetrically with respect to a corresponding initial connection line.

In an exemplary implementation mode, the first initial connection line 91 may be connected with the first initial signal line 41 through a sixth connection electrode 56 to form a mesh communication structure for transmitting a first initial signal. The second initial connection line 92 may be connected with the second initial signal line 42 through an eighth connection electrode 58 to form a mesh communication structure for transmitting a second initial signal. The third initial connection line 93 may be connected with the third initial signal line 43 through a seventh connection electrode 57 to form a mesh communication structure for transmitting a third initial signal.

In an exemplary implementation mode, the first initial connection line 91, the second initial connection line 92, the third initial connection line 93, and the second initial connection line 92 may be periodically disposed in the first direction X. For example, the first initial connection line 91 may be disposed between data signal lines 72 of an N-th unit column and an (N+1)-th unit column, the second initial connection line 92 may be disposed between data signal lines 72 of an (N+2)-th unit column and an (N+3)-th unit column, and between data signal lines 72 of an (N+6)-th unit column and an (N+7)-th unit column, and the third initial connection line 93 may be disposed between data signal lines 72 of an (N+4)-th unit column and an (N+5)-th unit column.

In an exemplary implementation mode, two second initial connection lines 92 and one third initial connection line 93 may be disposed between two adjacent first initial connection lines 91 in the first direction X, one first initial connection line 91 or one third initial connection line 93 may be disposed between two adjacent second initial connection lines 92 in the first direction X, and one first initial connection line 91 and two second initial connection lines 92 may be disposed between two adjacent third initial connection lines 93 in the first direction X.

In an exemplary implementation mode, the drive structure layer may further include at least one first connection line 81 and at least one second connection line 82, a shape of the first connection line 81 may be a straight line or a polyline extending along the first direction X, and a shape of the second connection line 82 may be a straight line or a polyline extending along the second direction Y. At least one first connection line 81 is connected with the data signal line 72 and the second connection line 82, respectively, forming a structure in which a data connection line is located in the display region.

In an exemplary implementation mode, at least one first connection line 81 may be disposed between the second scan signal line 22 and the first initial signal line 41 in the second direction Y. In the first direction X, at least one second connection line 82 may be disposed between first power supply lines 71 of some adjacent unit columns, and two first power supply lines 71 in adjacent unit columns may be disposed symmetrically with respect to a second connection line 82.

In an exemplary implementation mode, two circuit units may be spaced between adjacent second connection lines 82 in the first direction X. For example, a second connection line 82 may be disposed between first power supply lines 71 of the N-th unit column and an (N-1)-th unit column. For another example, a second connection line 82 may be disposed between first power supply lines 71 of the (N+1)-th unit column and the (N+2)-th unit column. For another example, a second connection line 82 may be disposed between first power supply lines 71 of the (N+3)-th unit column and the (N+4)-th unit column. For another example, a second connection line 82 may be disposed between first power supply lines 71 of the (N+5)-th unit column and the (N+6)-th unit column. For another example, a second connection line 82 may be disposed between first power supply lines 71 of the (N+7)-th unit column and an (N+8)-th unit column.

In an exemplary implementation mode, second connection lines 82 and initial connection lines (the first initial connection line 91, the second initial connection line 92, and the third initial connection line 93) may be alternately disposed in the first direction X.

In an exemplary implementation mode, the at least one circuit unit may further include a first shield electrode 61, and the first shield electrode 61 may be connected with the third initial signal line 43. An orthographic projection of the first shield electrode 61 on the base substrate is at least partially overlapped with an orthographic projection of a first active layer between two gate electrodes in the first transistor T1 on the base substrate, and the first shield electrode 61 and the first active layer between the two gate electrodes in the first transistor T1 form a coupling capacitance.

In an exemplary implementation mode, the at least one circuit unit may further include a second shield electrode 62 connected with the first initial signal line 41. An orthographic projection of the second shield electrode 62 on the base substrate is at least partially overlapped with an orthographic projection of a second active layer between two gate electrodes in the second transistor T2 on the base substrate, the second shield electrode 62 and the second active layer between the two gate electrodes in the second transistor T2 forming a coupling capacitance.

In an exemplary implementation mode, the at least one circuit unit may further include a third shield electrode 63 connected with the first initial signal line 41. An orthographic projection of the third shield electrode 63 on the base substrate is at least partially overlapped with an orthographic projection of a second region of the first active layer on the base substrate, and the orthographic projection of the third shield electrode 63 on the base substrate is at least partially overlapped with an orthographic projection of the first connection line 81 on the base substrate. The orthographic projection of the first connection line 81 on the base substrate may have an overlapping region with the orthographic projection of the second region of the first active layer on the base substrate, and the orthographic projection of the third shield electrode 63 on the base substrate may contain this overlapping region.

In an exemplary implementation mode, the at least one circuit unit may further include a fourth shield electrode 64 connected with the first initial signal line 41. In the first direction X, the fourth shield electrode 64 may be located between the first electrode of the second transistor T2 (also the second electrode of the first transistor T1) and the first electrode of the fourth transistor T4.

In an exemplary implementation mode, in a direction perpendicular to the base substrate, the drive structure layer may include at least a first conductive layer disposed on the base substrate, a second conductive layer disposed at a side of the first conductive layer away from the base substrate, a third conductive layer disposed at a side of the second conductive layer away from the base substrate, and a fourth conductive layer disposed at a side of the third conductive layer away from the base substrate. The first initial signal line 41 and the second initial signal line 42 may be disposed in the second conductive layer, the third initial signal line 43 and the first connection line 81 may be disposed in the third conductive layer, and the second connection line 82, the first initial connection line 91, the second initial connection line 92, and the third initial connection line 93 may be disposed in the fourth conductive layer.

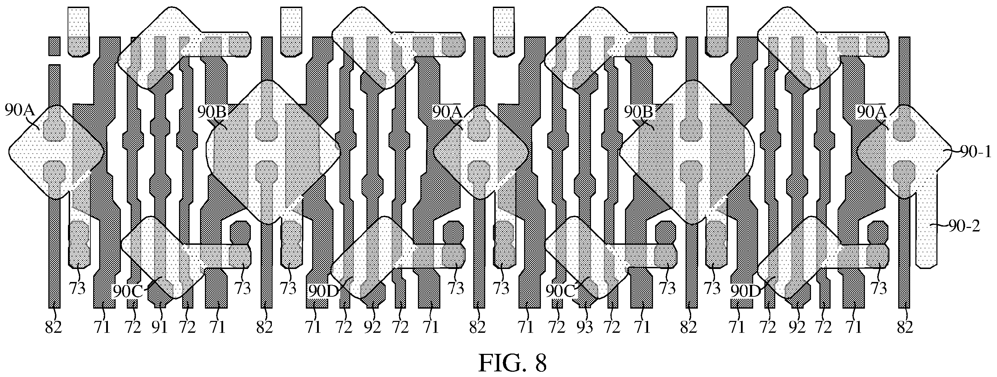

FIG. 8 is a schematic diagram of a structure of another display substrate according to an exemplary embodiment of the present disclosure, and illustrates a structure of a fourth conductive layer and an anode conductive layer. As shown in FIG. 8, in a direction perpendicular to the display substrate, a light emitting structure layer may include at least an anode conductive layer disposed at a side of a drive structure layer away from a base substrate, a pixel definition layer disposed at a side of the anode conductive layer away from the base substrate, an organic emitting layer disposed at a side of the pixel definition layer away from the base substrate, a cathode layer disposed at a side of the organic emitting layer away from the base substrate, and an encapsulation structure layer disposed at a side of the cathode layer away from the base substrate. In a direction parallel to the display substrate, the light emitting structure layer may include at least a plurality of red light emitting units emitting red light, a plurality of blue light emitting units emitting blue light, a plurality of first green light emitting units emitting green light, and a plurality of second green light emitting units emitting green light. A red light emitting unit may include at least a first anode 90A, a blue light emitting unit may include at least a second anode 90B, a first green light emitting unit may include at least a third anode 90C, a second green light emitting unit may include at least a fourth anode 90D, and the first anode 90A, the second anode 90B, the third anode 90C, and the fourth anode 90D may be all disposed in the anode conductive layer.

In an exemplary implementation mode, at least one of the first anode 90A, the second anode 90B, the third anode 90C, and the fourth anode 90D may include a main body portion 90-1 and a connection portion 90-2 connected with each other, wherein a first end of the connection portion 90-2 is connected with the main body portion 90-1, and a second end of the connection portion 90-2 is connected with an anode connection electrode 73 in a pixel drive circuit through an anode via after extending toward a direction away from the main body portion 90-1.

In an exemplary implementation mode, orthographic projections of a main body portion of the first anode 90A and a main body portion of the second anode 90B on the base substrate are at least partially overlapped with an orthographic projection of a second connection line 82 on the base substrate, while orthographic projections of a main body portion of the third anode 90C and a main body portion of the fourth anode 90D on the base substrate are not overlapped with the orthographic projection of the second connection line 82 on the base substrate, that is, the second connection line 82 is disposed only below anodes of the red light emitting units and the blue light emitting units.

In an exemplary implementation mode, orthographic projections of the main body portion of the third anode 90C and the main body portion of the fourth anode 90D on the base substrate are at least partially overlapped with an orthographic projection of an initial connection line on the base substrate, while orthographic projections of the main body portion of the first anode 90A and the main body portion of the second anode 90B on the base substrate are not overlapped with the orthographic projection of the initial connection line on the base substrate, that is, the initial connection line is disposed only below anodes of the first green light emitting units and the second green light emitting units. Herein, the initial connection line may be the first initial connection line 91, or the second initial connection line 92, or the third initial connection line 93.

Exemplary description is made below through a preparation process of the display substrate according to the exemplary embodiment. A "patterning process" mentioned in the present disclosure includes treatments such as deposition of a film layer, photoresist coating on a film layer, mask exposure, development, etching, and photoresist stripping for a metal material, an inorganic material, or a transparent conductive material, and includes treatments such as coating an organic material, mask exposure, and development for an organic material. Deposition may be any one or more of sputtering, evaporation, and chemical vapor deposition; coating may be any one or more of spray coating, spin coating, and inkjet printing; and etching may be any one or more of dry etching and wet etching, which is not limited in present disclosure. A "thin film" refers to a layer of thin film made of a certain material on a base substrate using deposition, coating, or other processes. If the "thin film" does not need to be processed through a patterning process in an entire manufacturing process, the "thin film" may also be called a "layer". If the "thin film" need to be processed through the patterning process in the entire manufacturing process, the "thin film" is called a "thin film" before the patterning process is performed and is called a "layer" after the patterning process is performed. At least one "pattern" is contained in the "layer" after the patterning process. "A and B are disposed in a same layer" in the present disclosure means that A and B are formed simultaneously through a same patterning process, and a "thickness" of a film layer is a dimension of the film layer in a direction perpendicular to the display substrate. In an exemplary implementation mode of the present disclosure, "an orthographic projection of B is located within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A is overlapped with the boundary of the orthographic projection of B.

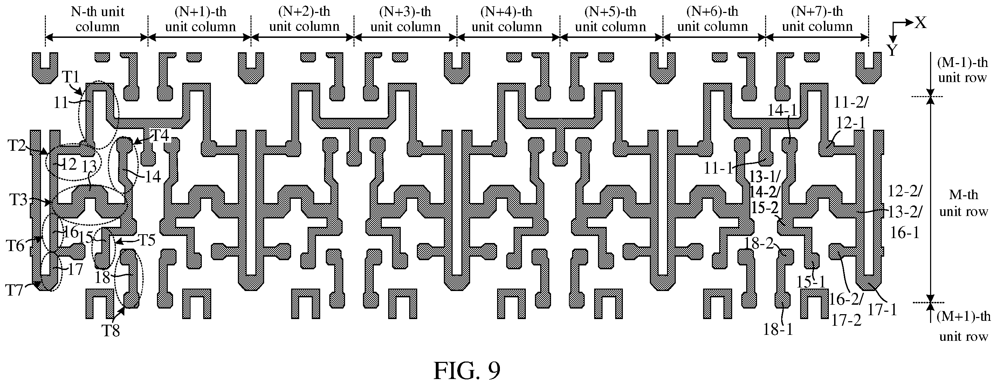

In an exemplary implementation mode, taking eight circuit units with one unit row and eight unit columns as an example, a preparation process of the display substrate according to the present embodiment may include following operations.
(1) A pattern of a semiconductor layer is formed. In an exemplary implementation mode, forming the pattern of the semiconductor layer may include: depositing sequentially a first insulation thin film and a semiconductor thin film on a base substrate, and patterning the semiconductor thin film through a patterning process to form a first insulation layer disposed on the base substrate and the pattern of the semiconductor layer disposed on the first insulation layer, as shown in FIG. 9.

In an exemplary implementation mode, the pattern of the semiconductor layer of each circuit unit may include, at least, a first active layer 11 of the first transistor T1 to an eighth active layer 18 of the eighth transistor T8, the first active layer 11 to the seventh active layer 17 may be of an interconnected integral structure, and the eighth active layer 18 is separately disposed.

In an exemplary implementation mode, in the second direction Y, the first active layer 11, the second active layer 12, and the fourth active layer 14 may be located at a side of the third active layer 13 in an opposite direction of the second direction Y, and the fifth active layer 15, the sixth active layer 16, the seventh active layer 17, and the eighth active layer 18 may be located at a side of the third active layer 13 in the second direction Y.

In an exemplary implementation mode, the third active layer 13 may be in a shape of a "Ω", the first active layer 11 may be in a shape of an "n", the second active layer 12, the fifth active layer 15, the sixth active layer 16, and the seventh active layer 17 may be in a shape of an "L", and the fourth active layer 14 and the eighth active layer 18 may be in a shape of an "I".

In an exemplary implementation mode, each of the first active layer 11 to the eighth active layer 18 may include a first region, a second region, and a channel region located between the first region and the second region. In an exemplary implementation mode, a second region 11-2 of the first active layer and a first region 12-1 of the second active layer may be connected with each other, and the second region 11-2 of the first active layer may act as the first region 12-1 of the second active layer. A first region 13-1 of the third active layer, a second region 14-2 of the fourth active layer, and a second region 15-2 of the fifth active layer may be connected with each other, and the first region 13-1 of the third active layer may simultaneously serve as the second region 14-2 of the fourth active layer and the second region 15-2 of the fifth active layer. A second region 12-2 of the second active layer, a second region 13-2 of the third active layer, and a first region 16-1 of the sixth active layer may be connected with each other, and the second region 12-2 of the second active layer may simultaneously serve as the second region 13-2 of the third active layer and the first region 16-1 of the sixth active layer. A second region 16-2 of the sixth active layer and a second region 17-2 of the seventh active layer may be connected with each other, and the second region 16-2 of the sixth active layer may serve as the second region 17-2 of the seventh active layer. A first region 11-1 of the first active layer, a first region 14-1 of the fourth active layer, a first region 15-1 of the fifth active layer, a first region 17-1 of the seventh active layer, a first region 18-1 of the eighth active layer, and a first region 18-2 of the eighth active layer may be disposed separately.

In an exemplary implementation mode, patterns of semiconductor layers of adjacent unit columns may be disposed in mirror symmetry with respect to a column center line. For example, first active layers 11 to eighth active layers 18 in the N-th unit column and the (N+1)-th unit column may be disposed in mirror symmetry with respect to a column center line. For another example, first active layers 11 to eighth active layers 18 in the (N+1)-th unit column and the (N+2)-th unit column may be disposed in mirror symmetry with respect to a column center line.

In an exemplary implementation mode, positions and shapes of first active layers 11 to eighth active layers 18 of adjacent unit rows may be substantially the same.

In an exemplary implementation mode, in at least one unit row, first active layers 11 in some adjacent circuit units may be of an interconnected integral structure, and first active layers 11 in two circuit units may share a first region 11-1 of a same first active layer. For example, two circuit units in the N-th unit column and the (N+1)-th unit column may share a first region 11-1 of a same first active layer. For another example, two circuit units in the (N+2)-th unit column and the (N+3)-th unit column may share a first region 11-1 of a same first active layer. For another example, two circuit units in the (N+4)-th unit column and the (N+5)-th unit column may share a first region 11-1 of a same first active layer. In the present disclosure, by disposing first transistors T1 in adjacent circuit units to be disposed in mirror symmetry and share a first region of a first active layer, lateral wiring space may be effectively reduced, quantities of vias and connection electrodes may be reduced, and an occupied area of a pixel drive circuit may be reduced, which is beneficial to achieving a high resolution.

In an exemplary implementation mode, the first region of the first active layer may serve as the first electrode of the first transistor T1, and the first electrode of the first transistor T1 shared by pixel drive circuits in adjacent circuit units may be the first region of the first active layer shared by pixel drive circuits in adjacent circuit units.

In an exemplary implementation mode, in at least one unit row, seventh active layers 17 in some adjacent circuit units may be of an interconnected integral structure, and seventh active layers 17 in two circuit units may share a first region 17-1 of a same seventh active layer. For example, two circuit units in the (N+1)-th unit column and the (N+2)-th unit column may share a first region 17-1 of a same seventh active layer. For another example, two circuit units in the (N+3)-th unit column and the (N+4)-th unit column may share a first region 17-1 of a same seventh active layer. For another example, two circuit units in the (N+5)-th unit column and the (N+6)-th unit column may share a first region 17-1 of a same seventh active layer. In the present disclosure, by disposing seventh transistors T7 in adjacent circuit units to be disposed in mirror symmetry and share a first region of a seventh active layer, lateral wiring space may be effectively reduced, quantities of vias and connection electrodes may be reduced, and an occupied area of a pixel drive circuit may be reduced, which is beneficial to achieving a high resolution.

In an exemplary implementation mode, the first region of the seventh active layer may be the first electrode of the seventh transistor T7, and the first electrode of the seventh transistor T7 shared by pixel drive circuits in adjacent circuit unit may be the first region of the seventh active layer shared by the pixel drive circuits in the adjacent circuit units.

In an exemplary implementation mode, in at least one unit row, eighth active layers 18 in some adjacent circuit units may be disposed in mirror symmetry with respect to a column center line, and all of them are close to the column center line, which is beneficial for the adjacent circuit units to share the first electrode of the eighth transistor T8, which may effectively reduce lateral wiring space, reduce a quantity of vias, reduce an occupied area of a pixel drive circuit, which is beneficial to achieving a high resolution.

In an exemplary implementation mode, the semiconductor layer may be made of poly silicon (p-Si), that is, the first transistor T1 to the eighth transistor T8 are LTPS transistors. In an exemplary implementation mode, patterning the semiconductor thin film through the patterning process may include: an amorphous silicon (a-si) thin film is formed on the first insulation thin film, the amorphous silicon thin film is dehydrogenated, and the dehydrogenated amorphous silicon thin film is crystallized to form a poly silicon thin film. Subsequently, the poly silicon thin film is patterned to form the pattern of the semiconductor layer.

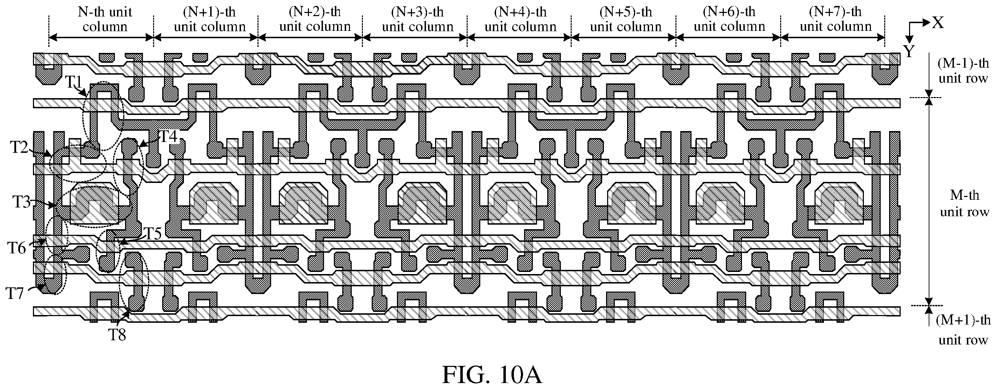

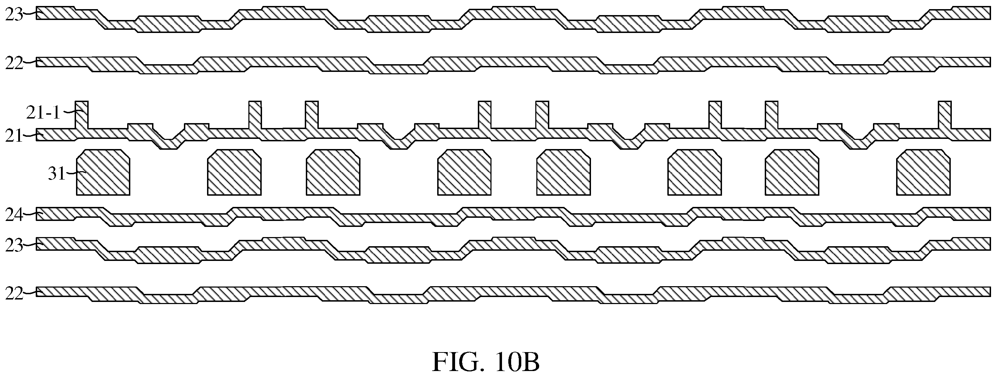

(2) A pattern of a first conductive layer is formed. In an exemplary implementation mode, forming the pattern of the first conductive layer may include: depositing sequentially a second insulation thin film and a first conductive thin film on the base substrate on which the aforementioned pattern is formed, and patterning the first conductive thin film through a patterning process to form a second insulation layer that covers the semiconductor layer and form the pattern of the first conductive layer disposed on the second insulation layer, as shown in FIG. 10A and FIG. 10B. FIG. 10B is a planar schematic diagram of the first conductive layer in FIG. 10A. In an exemplary implementation mode, the first conductive layer may be referred to as a first gate metal (GATE1) layer.

In an exemplary implementation mode, the pattern of the first conductive layer of each circuit unit in the display substrate may at least include: a first scan signal line 21, a second scan signal line 22, a third scan signal line 23, a light emitting signal line 24, and a first electrode plate 31 of a storage capacitor.

In an exemplary implementation mode, a shape of the first electrode plate 31 of the storage capacitor may be a shape of a rectangle, corners of the rectangle may be chamfered or provided with grooves, an orthographic projection of the first electrode plate 31 on the base substrate is at least partially overlapped with an orthographic projection of the third active layer on the base substrate, and the first electrode plate 31 may simultaneously serve as a lower electrode plate of the storage capacitor and a gate electrode of the third transistor T3.

In an exemplary implementation mode, the first scan signal line 21 may be in a shape of a straight line or a polyline extending along the first direction X, may be disposed at a side of the first electrode plate 31 in an opposite direction of the second direction Y, and a region where the first scan signal line 21 is overlapped with the fourth active layer may serve as a gate electrode of the fourth transistor T4. Therefore, it is achieved that the first scan signal line 21 may control the fourth transistor T4 to be turned on or turned off.

In an exemplary implementation mode, a gate block 21-1 may be disposed on the first scan signal line 21, a shape of the gate block 21-1 may be a strip shape extending along the second direction Y, a first end of the gate block 21-1 is connected with a side of the first scan signal line 21 away from the first electrode plate 31, and a second end of the gate block 21-1 extends toward a direction away from the first electrode plate 31. A region where the first scan signal line 21 and the gate block 21-1 are overlapped with the second active layer may serve as a gate electrode of the second transistor T2 having a double-gate structure, thereby achieving that the first scan signal line 21 may control the second transistor T2 to be turned on or turned off. In an exemplary implementation mode, the second transistor T2 with the double-gate structure may reduce leakage of the second transistor T2, which is beneficial to achieve low-frequency drive of a pixel drive circuit.

In an exemplary implementation mode, the second scan signal line 22 may be in a shape of a straight line or a polyline extending along the first direction X, may be disposed at a side of the first scan signal line 21 away from the first electrode plate 31, and a region where the second scan signal line 22 is overlapped with the first active layer may serve as a gate electrode of the first transistor T1 with a dual-gate structure. Therefore, it is achieved that the second scan signal line 22 may control the first transistor T1 to be turned on or turned off. In an exemplary implementation mode, the first transistor T1 with the dual-gate structure may reduce leakage of the first transistor T1, which is beneficial to achieve low-frequency drive of a pixel drive circuit.

In an exemplary implementation mode, the third scan signal line 23 may be in a shape of a straight line or a polyline extending along the first direction X, may be disposed at a side of the first electrode plate 31 in the second direction Y, a region where the third scan signal line 23 is overlapped with the seventh active layer may serve as a gate electrode of the seventh transistor T7, and a region where the third scan signal line 23 is overlapped with the eighth active layer may serve as a gate electrode of the eighth transistor T8. Therefore, it is achieved that the third scan signal line 23 may control the seventh transistor T7 and the eighth transistor T8 to be turned on or turned off.

In an exemplary implementation mode, the light emitting signal line 24 may be in a shape of a straight line or a polyline extending along the first direction X, may be disposed between the third scan signal line 23 and the first electrode plate 31, a region where the light emitting signal line 24 is overlapped with the fifth active layer may serve as a gate electrode of the fifth transistor T5, and a region where the light emitting signal line 24 is overlapped with the sixth active layer may serve as a gate electrode of the sixth transistor T6. Therefore, it is achieved that the light emitting signal line 24 may control the fifth transistor T5 and the sixth transistor T6 to be turned on or turned off.

In an exemplary implementation mode, the first scan signal line 21, the second scan signal line 22, the third scan signal line 23, and light emitting signal line 24 may be polylines with unequal widths, and widths of positions where the first scan signal line 21, the second scan signal line 22, the third scan signal line 23, and light emitting signal line 24 are overlapped with the semiconductor layer may be larger than widths of other positions.

In an exemplary implementation mode, patterns of first conductive layers of adjacent unit columns may be disposed in mirror symmetry with respect to a column center line. For example, positions and shapes of first conductive layers in the N-th unit column and the (N+1)-th unit column may be disposed in mirror symmetry with respect to a column center line. For another example, positions and shapes of first conductive layers in the (N+1)-th unit column and the (N+2)-th unit column may be disposed in mirror symmetry with respect to a column center line.

In an exemplary implementation mode, positions and shapes of first conductive layers of adjacent unit rows may be substantially the same.

In an exemplary implementation mode, after the pattern of the first conductive layer is formed, conductive processing may be performed on the first semiconductor layer by using the first conductive layer as a shield. A region of the first semiconductor layer, which is shielded by the first conductive layer, forms channel regions of the first transistor T1 to the eighth transistor T8, and a region of the first semiconductor layer, which is not shielded by the first conductive layer, is made to be conductive, that is, first regions and second regions of the first active layer to the eighth active layer are all made to be conductive.

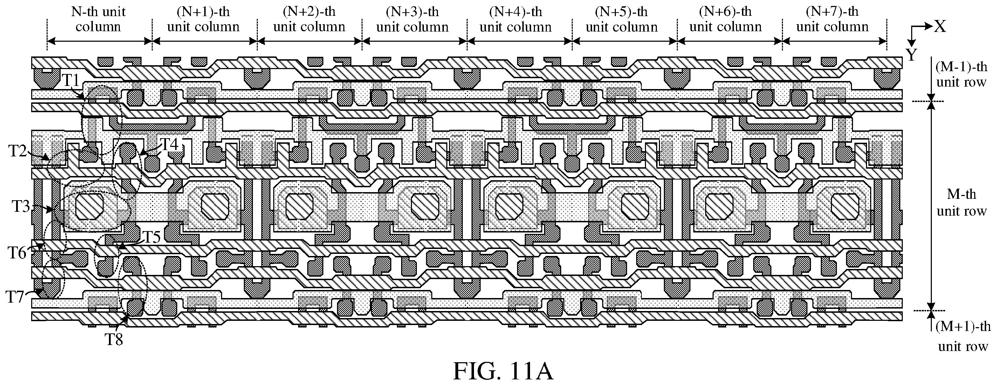

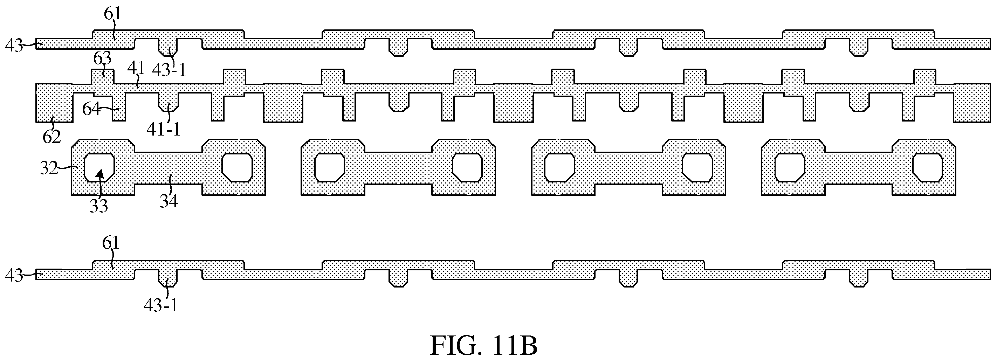

(3) A pattern of a second conductive layer is formed. In an exemplary implementation mode, forming the pattern of the second conductive layer may include: depositing sequentially a third insulation thin film and a second conductive thin film on the base substrate on which the aforementioned patterns are formed, and patterning the second conductive thin film through a patterning process, to form a third insulation layer that covers the pattern of the first conductive layer, and the pattern of the second conductive layer disposed on the third insulation layer, as shown in FIG. 11A and FIG. 11B. FIG. 11B is a schematic plan diagram of the second conductive layer in FIG. 11A. In an exemplary implementation mode, the second conductive layer may be referred to as a second gate metal (GATE2) layer.

In an exemplary implementation mode, the pattern of the second conductive layer of each circuit unit in the display substrate includes, at least, a second electrode plate 32 of the storage capacitor, a first initial signal line 41, a third initial signal line 43, a first shield electrode 61, a second shield electrode 62, a third shield electrode 63, and a fourth shield electrode 64.

In an exemplary implementation mode, a profile of the second electrode plate 32 of the storage capacitor may be in a shape of a rectangle, corners of the rectangle may be chamfered or provided with grooves, an orthographic projection of the second electrode plate 32 on the base substrate is at least partially overlapped with an orthographic projection of the first electrode plate 31 on the base substrate, the second electrode plate 32 may serve as an upper electrode plate of the storage capacitor, and the first electrode plate 31 and the second electrode plate 32 form the storage capacitor.

In an exemplary implementation mode, the second electrode plate 32 is provided with an opening 33. The opening 33 may have a shape of a block (such as a rectangle) and may be located in a middle region of the second electrode plate 32, so that the second electrode plate 32 forms an annular shape. The opening 33 exposes the third insulation layer covering the first electrode plate 31, and an orthographic projection of the first electrode plate 31 on the base substrate contains an orthographic projection of the opening 33 on the base substrate. In an exemplary implementation mode, the opening 33 is configured to accommodate a tenth via to be formed subsequently, and the tenth via is located within the opening 33 and exposes the first electrode plate 31, so that a first connection electrode to be formed subsequently is connected with the first electrode plate 31.

In an exemplary implementation mode, the second electrode plate 32 may be provided with a plate connection strip 34. The plate connection strip 34 may be in a shape of a straight line or a polyline extending along the first direction X, the plate connection strip 34 may be disposed at a side of the second electrode plate 32 in the first direction X or in an opposite direction of the first direction X. A first end of the plate connection strip 34 is connected with a second electrode plate 32 in a present circuit unit, and a second end of the plate connection strip 34 is connected with a second electrode plate 32 in an adjacent circuit unit in the first direction X.

In an exemplary implementation mode, in at least one circuit unit, the second electrode plate 32 and the plate connection strip 34 may be of an interconnected integral structure.

In an exemplary implementation mode, in one unit row, second electrode plates 32 in some adjacent circuit units may be of an interconnected integral structure. For example, a second electrode plate 32 of the N-th unit column and a second electrode plate 32 of the (N+1)-th unit column are connected with each other through a plate connection strip 34, to form an interconnected integral structure. For another example, a second electrode plate 32 of the (N+2)-th unit column and a second electrode plate 32 of the (N+3)-th unit column are connected with each other through a plate connection strip 34, to form an interconnected integral structure. For example, a second electrode plate 32 of the (N+4)-th unit column and a second electrode plate 32 of the (N+5)-th unit column are connected with each other through a plate connection strip 34, to form an interconnected integral structure. Since a second electrode plate 32 in each circuit unit is connected with a first power supply line formed subsequently, by forming second electrode plates 32 of some adjacent circuit units into an interconnected integral structure, the second electrode plates of the integral structure may be multiplexed as a power supply signal line, which may ensure that second electrode plates of adjacent circuit units have a same potential, which is beneficial to improving uniformity of a panel, avoiding poor display of the display substrate, and ensuring a display effect of the display substrate.

In an exemplary implementation mode, the first initial signal line 41 may be in a shape of a straight line or a polyline extending along the first direction X, and may be disposed between the second scan signal line 22 and the first scan signal line 21. A first initial connection block 41-1 may be disposed on the first initial signal line 41, and a shape of the first initial connection block 41-1 may be a shape of a block (such as a rectangle). In the first direction X, the first initial connection block 41-1 may be disposed between some adjacent circuit units, and in the second direction Y, the first initial connection block 41-1 may be disposed at a side of the first initial signal line 41 close to the first scan signal line 21 and connected with the first initial signal line 41. In an exemplary implementation mode, the first initial connection block 41-1 is configured to be connected with the first region of the first active layer through a sixth connection electrode to be formed subsequently.

In an exemplary implementation mode, in one unit row, a first initial signal line 41 and a plurality of first initial connection blocks 41-1 may be of an interconnected integral structure.

In an exemplary implementation mode, some adjacent two circuit units in one unit row may share a same first initial connection block 41-1. For example, two circuit units in the N-th unit column and the (N+1)-th unit column may share a same first initial connection block 41-1. For another example, two circuit units of the (N+2)-th unit column and the (N+3)-th unit column may share a same first initial connection block 41-1. For another example, two circuit units of the (N+4)-th unit column and the (N+5)-th unit column may share a same first initial connection block 41-1. In the present disclosure, by disposing some adjacent circuit units to share a first initial connection block 41-1, lateral wiring space may be effectively reduced, quantities of vias and connection electrodes may be reduced, and an occupied area of a pixel drive circuits may be reduced, which is beneficial to achieving a high resolution.

In an exemplary implementation mode, the third initial signal line 43 may be in a shape of a straight line or a polyline extending along the first direction X, and may be disposed at a side of the third scan signal line 23 away from the second electrode plate 32. A third initial connection block 43-1 may be disposed on the third initial signal line 43, and a shape of the third initial connection block 43-1 may be a shape of a block (for example, a rectangle). In the first direction X, the third initial connection block 43-1 may be disposed between some adjacent circuit units, and in the second direction Y, the third initial connection block 43-1 may be disposed at a side of the third initial signal line 43 away from the second electrode plate 32 and connected with the third initial signal line 43. In an exemplary implementation mode, the third initial connection block 43-1 is configured to be connected with the first region of the eighth active layer through a seventh connection electrode to be formed subsequently.

In an exemplary implementation mode, in one unit row, a third initial signal line 43 and a plurality of third initial connection blocks 43-1 may be of an interconnected integral structure.

In an exemplary implementation mode, some adjacent two circuit units in one unit row may share a same third initial connection block 43-1. For example, two circuit units in the N-th unit column and the (N+1)-th unit column may share a same third initial connection block 43-1. For another example, two circuit units of the (N+2)-th unit column and the (N+3)-th unit column may share a same third initial connection block 43-1. For another example, two circuit units of the (N+4)-th unit column and the (N+5)-th unit column may share a same third initial connection block 43-1. In the present disclosure, by disposing some adjacent circuit units to share a third initial connection block 43-1, lateral wiring space may be effectively reduced, quantities of vias and connection electrodes may be reduced, and an occupied area of a pixel drive circuit may be reduced, which is beneficial to achieving a high resolution.

In an exemplary implementation mode, the first shield electrode 61 may be in a shape of a block (e.g., a rectangle), and may be disposed on the third initial signal line 43 and connected with the third initial signal line 43. An orthographic projection of the first shield electrode 61 on the base substrate is at least partially overlapped with an orthographic projection of the first active layer between two gate electrodes in the first transistor T1 on the base substrate, and the first shield electrode 61 and the first active layer between the two gate electrodes in the first transistor T1 form a coupling capacitance. In an exemplary implementation mode, the first shield electrode 61 is configured to, on one hand, shield a node between the two gate electrodes in the first transistor T1, avoid an influence of data voltage jump on the first transistor T1, reduce an influence of the data voltage jump on normal working of a pixel drive circuit, and on the other hand, reduce leakage of the first transistor T1 by using the coupling capacitance, and improve a display effect.

In an exemplary implementation mode, in at least one circuit unit, a third initial signal line 43 and a first shield electrode 61 may be of an interconnected integral structure.

In an exemplary implementation mode, the second shield electrode 62 may be in a shape of a block (such as a rectangle) and may be disposed on the first initial signal line 41, a first end of the second shield electrode 62 is connected with a side of the first initial signal line 41 close to the first scan signal line 21, a second end of the second shield electrode 62 extends toward a direction close to the first scan signal line 21. An orthographic projection of the second shield electrode 62 on the base substrate is at least partially overlapped with an orthographic projection of the second active layer between two gate electrodes in the second transistor T2 on the base substrate, and the second shield electrode 62 and the second active layer between the two gate electrodes in the second transistor T2 form a coupling capacitance. In an exemplary implementation mode, the second shield electrode 62 is configured to shield a node between the two gate electrodes in the second transistor T2, avoid an influence of data voltage jump on the second transistor T2, reduce an influence of the data voltage jump on normal working of a pixel drive circuit, and on the other hand, reduce leakage of the second transistor T2 by using the coupling capacitance and improve a display effect.

In an exemplary implementation mode, in at least one circuit unit, a first initial signal line 41 and a second shield electrode 62 may be of an interconnected integral structure.

In an exemplary implementation mode, in at least one unit row, second shield electrodes 62 in some adjacent circuit units may be connected with each other to form an interconnected integral structure. For example, a second shield electrode 62 in the (N+1)-th unit column and a second shield electrode 62 in the (N+2)-th unit column may be of an interconnected integral structure. For another example, a second shield electrode 62 in the (N+3)-th unit column and a second shield electrode 62 in the (N+4)-th unit column may be of an interconnected integral structure. For another example, a second shield electrode 62 in the (N+5)-th unit column and a second shield electrode 62 in the (N+6)-th unit column may be of an interconnected integral structure.

In an exemplary implementation mode, the third shield electrode 63 may be in a shape of a block (such as a rectangle), and may be disposed on the first initial signal line 41 and connected with the first initial signal line 41. An orthographic projection of the third shield electrode 63 on the base substrate is at least partially overlapped with an orthographic projection of the second region of the first active layer on the base substrate. In an exemplary implementation mode, the third shield electrode 63 is configured to shield a first connection line formed subsequently, avoid an influence of data voltage jump in the first connection line on the first transistor T1 and the second transistor T2, reduce an influence of the data voltage jump on normal working of a pixel drive circuit, and improve a display effect.

In an exemplary implementation mode, in at least one circuit unit, a first initial signal line 41 and a third shield electrode 63 may be of an interconnected integral structure.

In an exemplary implementation mode, a shape of the fourth shield electrode 64 may be a strip shape extending along the second direction Y, a first end of the fourth shield electrode 64 is connected with a side of the first initial signal line 41 close to the first scan signal line 21, and a second end of the fourth shield electrode 64 extends toward a direction close to the first scan signal line 21. In the first direction X, the fourth shield electrode 64 may be located between the first region of the second active layer (also the second region of the first active layer) and the first region of the fourth active layer, i.e., located between the first electrode of the second transistor T2 (also the second electrode of the first transistor T1) and the first electrode of the fourth transistor T4. In an exemplary implementation mode, since the first region of the fourth active layer is connected with a data signal line formed subsequently, and the second region of the first active layer (also the first region of the second active layer) is connected with a first connection electrode as the first node N1 formed subsequently, the fourth shield electrode 64 is disposed between the first node N1 and the data signal line, which may avoid an influence of the data signal line on the first node N1, reduce an influence of data voltage jump on normal working of a pixel drive circuit, and improve a display effect.

In an exemplary implementation mode, in at least one circuit unit, a first initial signal line 41 and a second shield electrode 64 may be of an interconnected integral structure.

In an exemplary implementation mode, in at least one unit row, a first initial signal line 41, a plurality of second shield electrodes 62, a plurality of third shield electrodes 63, and a plurality of fourth shield electrodes 64 may be of an interconnected integral structure.

In an exemplary implementation mode, patterns of second conductive layers of adjacent unit columns may be disposed in mirror symmetry with respect to a column center line. For example, positions and shapes of second conductive layers in the N-th unit column and the (N+1)-th unit column may be disposed in mirror symmetry with respect to a column center line. For another example, positions and shapes of second conductive layers in the (N+1)-th unit column and the (N+2)-th unit column may be disposed in mirror symmetry with respect to a column center line.

In an exemplary implementation mode, positions and shapes of second conductive layers of adjacent unit rows may be substantially the same.

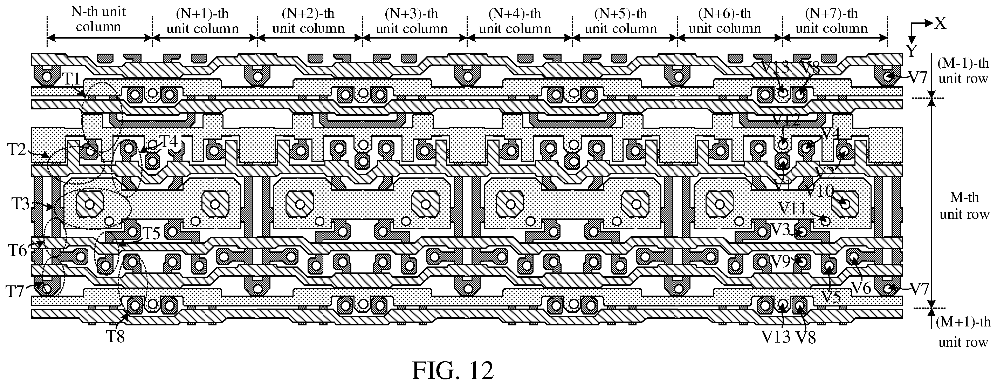

(4) A pattern of a fourth insulation layer is formed. In an exemplary implementation mode, forming the pattern of the fourth insulation layer may include: depositing a fourth insulation thin film on the base substrate on which the aforementioned patterns are formed, and patterning the fourth insulation thin film through a patterning process, to form a fourth insulation layer covering the second conductive layer, wherein a plurality of vias are disposed on the fourth insulation layer, as shown in FIG. 12.

In an exemplary implementation mode, a plurality of vias of each circuit unit in the display substrate at least include: a first via V1, a second via V2, a third via V3, a fourth via V4, a fifth via V5, a sixth via V6, a seventh via V7, an eighth via V8, a ninth via V9, a tenth via V10, an eleventh via V11, a twelfth via V12, and a thirteenth via V13.

In an exemplary implementation mode, an orthographic projection of the first via V1 on the base substrate is within a range of an orthographic projection of the first region of the first active layer on the base substrate, the second insulation layer, the third insulation layer, and the fourth insulation layer within the first via V1 are etched away to expose a surface of the first region of the first active layer, and the first via V1 is configured to enable a subsequently formed sixth connection electrode to be connected with the first region of the first active layer through the via.

In an exemplary implementation mode, since first active layers in some adjacent circuit units share a first region of a same first active layer, some adjacent two circuit units may share a same first via V1. For example, two circuit units in the N-th unit column and the (N+1)-th unit column may share a same first via V1. For another example, two circuit units in the (N+2)-th unit column and the (N+3)-th unit column may share a same first via V1. For another example, two circuit units in the (N+4)-th unit column and the (N+5)-th unit column may share a same first via V1. In the present disclosure, by disposing adjacent circuit units to share a first via V1, a quantity of vias may be effectively reduced, an occupied area of a pixel drive circuit may be reduced, which is beneficial to achieving a high resolution.

In an exemplary implementation mode, an orthographic projection of the second via V2 on the base substrate is within a range of an orthographic projection of the second region of the first active layer (also the first region of the second active layer) on the base substrate, the second insulation layer, the third insulation layer, and the fourth insulation layer within the second via V2 are etched away to expose a surface of the second region of the first active layer (also the first region of the second active layer), and the second via V2 is configured such that a first connection electrode to be formed subsequently is connected with the second region of the first active layer (also the first region of the second active layer) through this via.

In an exemplary implementation mode, an orthographic projection of the third via V3 on the base substrate is within a range of an orthographic projection of the first region of the third active layer (also the second region of the fourth active layer and the second region of the fifth active layer) on the base substrate, the second insulation layer, the third insulation layer, and the fourth insulation layer within the third via V3 are etched away to expose a surface of the first region of the third active layer (also the second region of the fourth active layer and the second region of the fifth active layer), and the third via V3 is configured so that a subsequently formed fifth connection electrode is connected with the first region of the third active layer (also the second region of the fourth active layer and the second region of the fifth active layer) through the via.

In an exemplary implementation mode, an orthographic projection of the fourth via V4 on the base substrate is within a range of an orthographic projection of the first region of the fourth active layer on the base substrate, the second insulation layer, the third insulation layer, and the fourth insulation layer within the fourth via V4 are etched away to expose a surface of the first region of the fourth active layer, and the fourth via V4 is configured to enable a subsequently formed second connection electrode to be connected with the first region of the fourth active layer through the via.

In an exemplary implementation mode, an orthographic projection of the fifth via V5 on the base substrate is within a range of an orthographic projection of the first region of the fifth active layer on the base substrate, the second insulation layer, the third insulation layer, and the fourth insulation layer within the fifth via V5 are etched away to expose a surface of the first region of the fifth active layer, and the fifth via V5 is configured to enable a subsequently formed third connection electrode to be connected with the first region of the fifth active layer through the via.

In an exemplary implementation mode, an orthographic projection of the sixth via V6 on the base substrate is within a range of an orthographic projection of the second region of the sixth active layer (also the second region of the seventh active layer) on the base substrate. The second insulation layer, the third insulation layer, and the fourth insulation layer within the sixth via V6 are etched away to expose a surface of the second region of the sixth active layer (also the second region of the seventh active layer), and the sixth via V6 is configured such that a fourth connection electrode formed subsequently is connected with the second region of the sixth active layer (also the second region of the seventh active layer) through the via.

In an exemplary implementation mode, an orthographic projection of the seventh via V7 on the base substrate is within a range of an orthographic projection of the first region of the seventh active layer on the base substrate, the second insulation layer, the third insulation layer, and the fourth insulation layer within the seventh via V7 are etched away to expose a surface of the first region of the seventh active layer, and the seventh via V7 is configured to enable a subsequently formed second initial connection block to be connected with the first region of the seventh active layer through the via.

In an exemplary implementation mode, since seventh active layers in some adjacent circuit units share a first region of a same seventh active layer, some adjacent two circuit units may share a same seventh via V7. For example, two circuit units in the (N+1)-th unit column and the (N+2)-th unit column may share a same seventh via V7. For another example, two circuit units in the (N+3)-th unit column and the (N+4)-th unit column may share a same seventh via V7. For yet another example, two circuit units in the (N+5)-th unit column and the (N+6)-th unit column may share a same seventh via V7. In the present disclosure, by disposing adjacent circuit units to share a seventh via V7, a quantity of vias may be effectively reduced, an occupied area of a pixel drive circuit may be reduced, which is beneficial to achieving a high resolution.

In an exemplary implementation mode, an orthographic projection of the eighth via V8 on the base substrate is within a range of an orthographic projection of the first region of the eighth active layer on the base substrate, the second insulation layer, the third insulation layer, and the fourth insulation layer within the eighth via V8 are etched away to expose a surface of the first region of the eighth active layer, and the eighth via V8 is configured such that a subsequently formed seventh connection electrode is connected with the first region of the eighth active layer through the via.

In an exemplary implementation mode, an orthographic projection of the ninth via V9 on the base substrate is within a range of an orthographic projection of the second region of the eighth active layer on the base substrate, the second insulation layer, the third insulation layer, and the fourth insulation layer within the ninth via V9 are etched away to expose a surface of the second region of the eighth active layer, and the ninth via V9 is configured such that a subsequently formed fifth connection electrode is connected with the second region of the eighth active layer through the via.

In an exemplary implementation mode, an orthographic projection of the tenth via V10 on the base substrate is located within a range of an orthographic projection of the opening 33 on the base substrate. The fourth insulation layer and the third insulation layer within the tenth via V10 are etched away to expose a surface of the first electrode plate 31, and the tenth via V10 is configured such that a first connection electrode formed subsequently is connected with the first electrode plate 31 through this via.

In an exemplary implementation mode, an orthographic projection of the eleventh via V11 on the base substrate is within a range of an orthographic projection of the second electrode plate 32 on the base substrate, the fourth insulation layer within the eleventh via V11 is etched away to expose a surface of the second electrode plate 32, and the eleventh via V11 is configured to enable a subsequently formed third connection electrode to be connected with the second electrode plate 32 through the via.

In an exemplary implementation mode, an orthographic projection of the twelfth via V12 on the base substrate is within a range of an orthographic projection of the first initial connection block 41-1 of the first initial signal line 41 on the base substrate. The fourth insulation layer within the twelfth via V12 is etched away to expose a surface of the first initial connection block 41-1, and the twelfth via V12 is configured such that a sixth connection electrode formed subsequently is connected with the first initial connection block 41-1 through this via.

In an exemplary implementation mode, since first initial signal lines 41 in some adjacent circuit units share a same first initial connection block 41-1, some adjacent two circuit units may share a same twelfth via V12. For example, two circuit units in the N-th unit column and the (N+1)-th unit column may share a same twelfth via V12. For another example, two circuit units in the (N+2)-th unit column and the (N+3)-th unit column may share a same twelfth via V12. For another example, two circuit units in the (N+4)-th unit column and the (N+5)-th unit column may share a same twelfth via V12. In the present disclosure, by disposing adjacent circuit units to share a twelfth via V12, a quantity of vias may be effectively reduced, an occupied area of a pixel drive circuit may be reduced, which is beneficial to achieving a high resolution.

In an exemplary implementation mode, an orthographic projection of the thirteenth via V13 on the base substrate is within an range of an orthographic projection of the third initial connection block 43-1 of the third initial signal line 43 on the base substrate, the fourth insulation layer within the thirteenth via V13 is etched away to expose a surface of the third initial connection block 43-1, and the thirteenth via V13 is configured such that a subsequently formed seventh connection electrode is connected with the third initial connection block 43-1 through the via.

In an exemplary implementation mode, since third initial signal lines 43 in some adjacent circuit units share a same third initial connection block 43-1, some adjacent two circuit units may share a same thirteenth via V13. For example, two circuit units in the N-th unit column and the (N+1)-th unit column may share a same thirteenth via V13. For another example, two circuit units in the (N+2)-th unit column and the (N+3)-th unit column may share a same thirteenth via V13. For yet another example, two circuit units in the (N+4)-th unit column and the (N+5)-th unit column may share a same thirteenth via V13. In the present disclosure, by disposing adjacent circuit units to share a thirteenth via V13, a quantity of vias may be effectively reduced, an occupied area of a pixel drive circuit may be reduced, which is beneficial to achieving a high resolution.

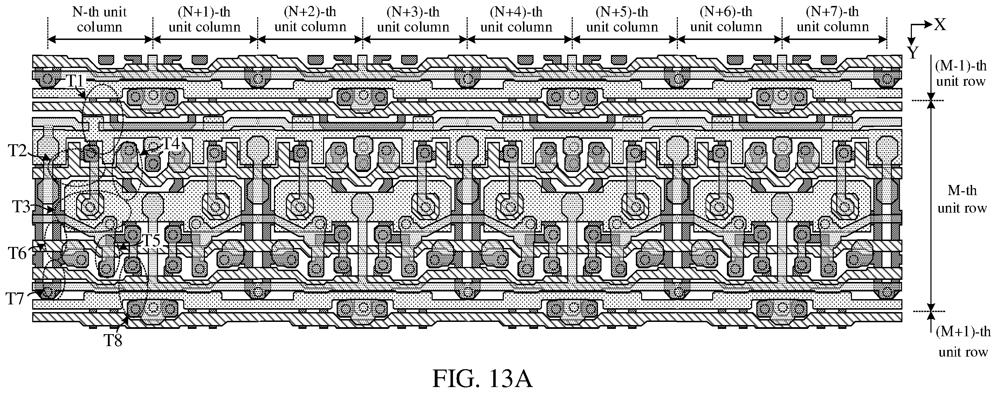

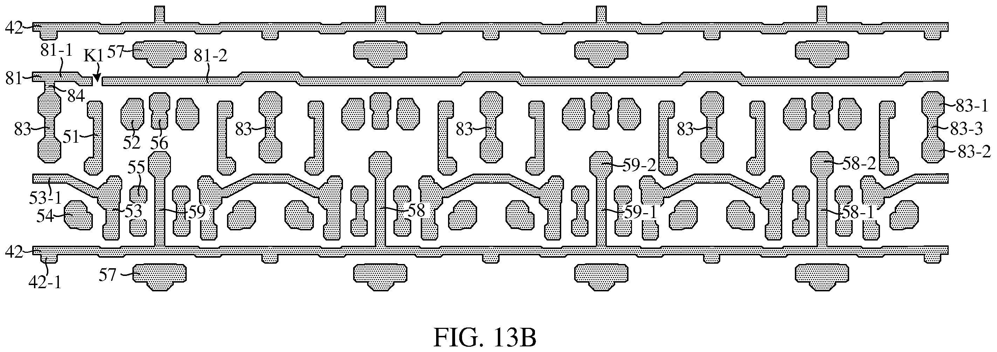

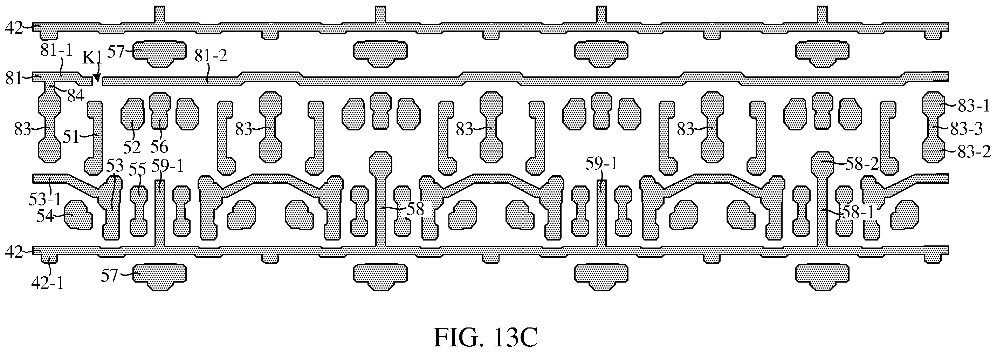

(5) A pattern of a third conductive layer is formed. In an exemplary implementation mode, forming the third conductive layer may include: depositing a third conductive thin film on the base substrate on which the aforementioned patterns are formed, and patterning the third conductive thin film through a patterning process to form a third conductive layer disposed on the fourth insulation layer, as shown in FIG. 13A, 13B, and 13C, herein FIG. 13B is a planar schematic diagram of the third conductive layer in FIG. 13A, and FIG. 13C is a planar schematic diagram of another third conductive layer in FIG. 13A. In an exemplary implementation mode, the third conductive layer may be referred to as a first source-drain metal (SD1) layer.

In an exemplary implementation mode, the third conductive layer of each circuit unit in the display substrate at least includes: a first connection electrode 51, a second connection electrode 52, a third connection electrode 53, a fourth connection electrode 54, a fifth connection electrode 55, a sixth connection electrode 56, a seventh connection electrode 57, and a second initial signal line 42.

In an exemplary implementation mode, the first connection electrode 51 may be in a shape of a strip of which a main body portion extends along the second direction Y, a first end of the first connection electrode 51 is connected with the second region of the first active layer (also the first region of the second active layer) through the second via V2, and a second end of the first connection electrode 51 is connected with the first electrode plate 31 through the tenth via V10. Since the first electrode plate 31 serves as the gate electrode of the third transistor T3, the first connection electrode 51 achieves interconnections among the second electrode of the first transistor T1, the first electrode of the second transistor T2, the gate electrode of the third transistor T3, and the first electrode plate 31 of the storage capacitor, and forms the first node N1 of the pixel drive circuit.

In an exemplary implementation mode, the second connection electrode 52 may be in a shape of a block (e.g., a rectangle), the second connection electrode 52 is connected with the first region of the fourth active layer through the fourth via V4, and the second connection electrode 52 is configured to be connected with a data signal line to be formed subsequently.

In an exemplary implementation mode, a shape of the third connection electrode 53 may be a strip extending along the second direction Y, a first terminal of the third connection electrode 53 is connected with the first region of the fifth active layer through the fifth via V5, a second terminal of the third connection electrode 53 is connected with the second electrode plate 32 through the eleventh via V11, and the third connection electrode 53 is configured to be connected with a first power supply line to be formed subsequently. In an exemplary implementation mode, the third connection electrode 53 achieves an interconnection between the first electrode of the fifth transistor T5 and the second electrode plate 32 of the storage capacitor, and the first electrode of the fifth transistor T5 and the second electrode plate 32 of the storage capacitor have a same potential.

In an exemplary implementation mode, the third connection electrode 53 may be provided with an electrode connection line 53-1. A shape of the electrode connection line 53-1 may be a straight line or a polyline extending along the first direction X, the electrode connection line 53-1 may be disposed at a side of the third connection electrode 53 in the first direction X or in an opposite direction of the first direction X. A first end of the electrode connection line 53-1 is connected with a third connection electrode 53 in a present circuit unit, and a second end of the electrode connection line 53-1 is connected with a third connection electrode 53 in an adjacent circuit unit in the first direction X.

In an exemplary implementation mode, in at least one circuit unit, a third connection electrode 53 and an electrode connection line 53-1 may be of an interconnected integral structure.

In an exemplary implementation mode, in one unit row, third connection electrodes 53 in some adjacent circuit units may be of an interconnected integral structure. For example, a third connection electrode 53 of the (N+1)-th unit column and a third connection electrode 53 of the (N+2)-th unit column are connected with each other through an electrode connection line 53-1 to form an interconnected integral structure. For another example, a third connection electrode 53 of the (N+3)-th unit column and a third connection electrode 53 of the (N+4)-th unit column are connected with each other through an electrode connection line 53-1 to form an interconnected integral structure. For another example, a third connection electrode 53 of the (N+5)-th unit column and a third connection electrode 53 of the (N+6)-th unit column are connected with each other through an electrode connection line 53-1 to form an interconnected integral structure. Since a third connection electrode 53 in each circuit unit is connected with a first power supply line formed subsequently, by forming third connection electrodes 53 of some adjacent circuit units into an interconnected integral structure, the third connection electrodes of the integral structure may be multiplexed as a power supply signal line, which may ensure that third connection electrodes of adjacent circuit units have a same potential, be beneficial to improving uniformity of a panel, avoid poor display of the display substrate, and ensure a display effect of the display substrate.

In an exemplary implementation mode, in one unit row, since second electrode plates 32 in some adjacent circuit units are connected with each other through a plate connection strip 34, third connection electrodes 53 in some adjacent circuit units are connected with each other through an electrode connection line 53-1, and the third connection electrodes 53 are connected with the second electrode plates 32, it is achieved that first electrodes of a plurality of fifth transistors T5 and second electrode plates 32 of a plurality of storage capacitors in one unit row have a same potential, uniformity of a panel is improved effectively, poor display of the display substrate is avoided, and a display effect of the display substrate is ensured.

In an exemplary implementation mode, the fourth connection electrode 54 may be in a shape of a block (e.g., a rectangle). The fourth connection electrode 54 is connected with the second region of the sixth active layer (also the second region of the seventh active layer) through the sixth via V6. The fourth connection electrode 54 is configured to be connected with an anode connection electrode to be formed subsequently.

In an exemplary implementation mode, a shape of the fifth connection electrode 55 may be a strip extending along the second direction Y, a first terminal of the fifth connection electrode 55 is connected with the first region of the third active layer (also the second region of the fourth active layer and the second region of the fifth active layer) through the third via V3, and a second terminal of the fifth connection electrode 55 is connected with the second region of the eighth active layer through the ninth via V9. In an exemplary implementation mode, the fifth connection electrode 55 achieves mutual connections among the first electrode of the third transistor T3, the second electrode of the fourth transistor T4, the second electrode of the fifth transistor T5, and the second electrode of the eighth transistor T8, forming the second node N2 of the pixel drive circuit.

In an exemplary implementation mode, the sixth connection electrode 56 may be in a shape of a strip extending along the second direction Y, a first terminal of the sixth connection electrode 56 is connected with the first region of the first active layer through the first via V1, and a second terminal of the sixth connection electrode 56 is connected with the first initial connection block 41-1 through the twelfth via V12. The sixth connection electrode 56 may serve as the first electrode of the first transistor T1, and since the first initial connection block 41-1 is connected with the first initial signal line 41, it is achieved that the first initial signal line 41 writes a first initial signal into the first region of the first active layer.

In an exemplary implementation mode, since some adjacent two circuit units share a first region of a same first active layer, share a same first initial connection block 41-1, and share a same twelfth via V12, some adjacent two circuit units may share a same sixth connection electrode 56, that is, pixel drive circuits in adjacent circuit units share a first electrode of a same first transistor T1. For example, two circuit units in the N-th unit column and the (N+1)-th unit column may share a same sixth connection electrode 56. For another example, two circuit units in the (N+2)-th unit column and the (N+3)-th unit column may share a same sixth connection electrode 56. For yet another example, two circuit units in the (N+4)-th unit column and the (N+5)-th unit column may share a same sixth connection electrode 56. In the present disclosure, by disposing adjacent circuit units to share a sixth connection electrodes 56, a quantity of connection electrodes may be effectively reduced, an occupied area of a pixel drive circuit may be reduced, which is beneficial to achieving a high resolution.

In some other implementation modes, first regions of first active layers of two adjacent circuit units may not be connected, the first active layers of the two adjacent circuit units may not be of an integral structure, that is, the first active layers of the two adjacent circuit units are disconnected, and first regions of first active layers of two circuit units may be connected through a common sixth connection electrode 56, and the sixth connection electrode 56 may be used as the first electrode of the first transistor T1, it is achieved that pixel drive circuits in adjacent circuit units share a first electrode of a same first transistor T1, and the present disclosure is not limited here.

In an exemplary implementation mode, the seventh connection electrode 57 may be in a shape of a strip extending along the first direction X, a first terminal of the seventh connection electrode 57 is connected with the first region of the eighth active layer through the eighth via V8, and a second terminal of the seventh connection electrode 57 is connected with the third initial connection block 43-1 through the thirteenth via V13. The seventh connection electrode 57 may serve as the first electrode of the eighth transistor T8, and since the third initial connection block 43-1 is connected with the third initial signal line 43, it is achieved that the third initial signal line 43 writes a third initial signal into the first region of the eighth active layer.

In an exemplary implementation mode, in at least one unit row, seventh connection electrodes 57 in some adjacent circuit units may be mirror-symmetrical with respect to a column center line, and seventh connection electrodes 57 in two circuit units may be of an interconnected integral structure, and the two circuit units may share a second terminal of a same seventh connection electrode 57, that is, pixel drive circuits in adjacent circuit units share a first electrode of an eighth transistor T8. For example, seventh connection electrodes 57 of two circuit units in the N-th unit column and the (N+1)-th unit column may be of an interconnected integral structure. For another example, seventh connection electrodes 57 of two circuit units in the (N+2)-th unit column and the (N+3)-th unit column may be of an interconnected integral structure. For another example, seventh connection electrodes 57 of two circuit units in the (N+4)-th unit column and the (N+5)-th unit column may be of an interconnected integral structure. In the present disclosure, by disposing seventh connection electrodes 57 of adjacent circuit units to be of an interconnected integral structure, occupied space of connection electrodes may be effectively reduced, an occupied area of a pixel drive circuit may be reduced, which is beneficial to achieve a high resolution.

In some other implementation modes, first regions of eighth active layer of two adjacent circuit units may be connected with each other, the eighth active layers of the two adjacent circuit units may be of an interconnected integral structure, and a first region of an eighth active layer may serve as a first electrode of an eighth transistor T8, it is achieved that pixel drive circuits in adjacent circuit units share a first electrode of a same eighth transistor T8, and the present disclosure is not limited here.

In an exemplary implementation mode, the second initial signal line 42 may be in a shape of a straight line or a polyline extending along the first direction X, and may be disposed at a side of the third initial signal line 43 close to the second electrode plate 32. A second initial connection block 42-1 may be disposed on the second initial signal line 42, and a shape of the second initial connection block 42-1 may be a shape of a block (such as a rectangle). In the first direction X, the second initial connection block 42-1 may be disposed between some adjacent circuit units, in the second direction Y, the second initial connection block 42-1 may be disposed at a side of the second initial signal line 42 away from the second electrode plate 32 and connected with the second initial signal line 42, and the second initial connection block 42-1 is connected with the first region of the seventh active layer through the seventh via V7. The second initial connection block 42-1 may serve as the first electrode of the seventh transistor T7, and since the second initial connection block 42-1 is connected with the second initial signal line 42, it is achieved that the second initial signal line 42 writes a second initial signal into the first region of the seventh active layer.

In an exemplary implementation mode, in one unit row, a second initial signal line 42 and a plurality of second initial connection blocks 42-1 may be o an interconnected integral structure.

In an exemplary implementation mode, since some adjacent two circuit units share a first region of a same seventh active layer and share a same seventh via V7, some adjacent two circuit units in one unit row may share a same second initial connection block 42-1, that is, pixel drive circuits in adjacent circuit units share a first electrode of a seventh transistor T7. For example, two circuit units in the (N+1)-th unit column and the (N+2)-th unit column may share a same second initial connection block 42-1. For another example, two circuit units in the (N+3)-th unit column and the (N+4)-th unit column may share a same second initial connection block 42-1. For another example, two circuit units in the (N+5)-th unit column and the (N+6)-th unit column may share a same second initial connection block 42-1. In the present disclosure, by disposing some adjacent circuit units to share a second initial connection block 42-1, lateral wiring space may be effectively reduced, quantities of vias and connection electrodes may be reduced, and an occupied area of a pixel drive circuit may be reduced, which is beneficial to achieving a high resolution.

In some other implementation modes, first regions of seventh active layers of two adjacent circuit units may not be connected, the seventh active layers of the two adjacent circuit units may not be of an integral structure, that is, the seventh active layers of the two adjacent circuit units are disconnected, and first regions of seventh active layers of two circuit units may be connected through a common second initial connection block 42-1, and the second initial connection block 42-1 may be used as a first electrode of a seventh transistor T7, it is achieved that pixel drive circuits in adjacent circuit units share a first electrode of a same seventh transistor T7, and the present disclosure is not limited here.

In an exemplary implementation mode, the third conductive layer may further include an eighth connection electrode 58 and a dummy connection electrode 59.

In an exemplary implementation mode, in the first direction X, the eighth connection electrode 58 may be disposed between some adjacent circuit units, and in the second direction Y, the eighth connection electrode 58 may be disposed at a side of the second initial signal line 42 close to the second electrode plate 32.

In an exemplary implementation mode, the eighth connection electrode 58 may include a connection electrode strip 58-1 and a connection electrode block 58-2. A shape of the connection electrode strip 58-1 may be a strip shape extending along the second direction Y, and a shape of the connection electrode block 58-2 may be a shape of a block (for example, a rectangle). A first terminal of the connection electrode strip 58-1 is connected with the second initial signal line 42, a second terminal of the connection electrode strip 58-1 is connected with the connection electrode block 58-2 after extending toward a direction close to the second electrode plate 32, and the connection electrode block 58-2 is configured to be connected with a second initial connection line formed subsequently.

In an exemplary implementation mode, an orthographic projection of the connection electrode block 58-2 on the base substrate is at least partially overlapped with an orthographic projection of the plate connection strip 34 on the base substrate.

In an exemplary implementation mode, in at least one circuit unit, a second initial signal line 42, a connection electrode strip 58-1, and a connection electrode block 58-2 may be of an interconnected integral structure.

In an exemplary implementation mode, four circuit units may be spaced between adjacent eighth connection electrodes 58 in the first direction X. For example, an eighth connection electrode 58 may be disposed between the (N+2)-th unit column and the (N+3)-th unit column. For another example, an eighth connection electrode 58 may be disposed between the (N+6)-th unit column and the (N+7)-th unit column.

In an exemplary implementation mode, in the first direction X, the dummy connection electrode 59 may be disposed between some adjacent circuit units, and in the second direction Y, the dummy connection electrode 59 may be disposed at a side of the second initial signal line 42 close to the second electrode plate 32.

In an exemplary implementation mode, the dummy connection electrode 59 may include a dummy electrode strip 59-1 and a dummy electrode block 59-2. A shape of the dummy electrode strip 59-1 may be a strip shape extending along the second direction Y, and a shape of the dummy electrode block 59-2 may be a shape of a block (for example, a rectangle). A first terminal of the dummy electrode strip 59-1 is connected with the second initial signal line 42, and a second terminal of the dummy electrode strip 59-1 is connected with the dummy electrode block 59-2 after extending toward a direction close to the second electrode plate 32. In an exemplary implementation mode, the dummy electrode strip 59-1 is configured to be overlapped with an anode formed subsequently to improve uniformity of the anode.

In an exemplary implementation mode, an orthographic projection of the dummy electrode block 59-2 on the base substrate is at least partially overlapped with an orthographic projection of the plate connection strip 34 on the base substrate.

In an exemplary implementation mode, in at least one circuit unit, a second initial signal line 42, a dummy electrode strip 59-1, and a dummy electrode block 59-2.

In an exemplary implementation mode, four circuit units may be spaced between adjacent dummy connection electrodes 59 in the first direction X. For example, a dummy connection electrode 59 may be disposed between the N-th unit column and the (N+1)-th unit column. For another example, a dummy connection electrode 59 may be disposed between the (N+4)-th unit column and the (N+5)-th unit column.

In an exemplary implementation mode, one dummy connection electrode 59 may be disposed between adjacent eighth connection electrodes 58 in the first direction X, and one eighth connection electrode 58 may be disposed between adjacent dummy connection electrodes 59 in the first direction X, that is, eighth connection electrodes 58 and dummy connection electrodes 59 are alternately disposed in the first direction X.

In an exemplary implementation mode, a position and a shape of an eighth connection electrode 58 in one circuit unit may be substantially the same as a position and a shape of a dummy connection electrode 59 in another circuit unit, and the connection electrode block 58-2 and the dummy electrode block 59-2 may be located on a same straight line extending along the first direction X.

In some other implementation modes, the display substrate may only be provided with the dummy electrode strip 59-1 without the dummy electrode block 59-2, as shown in FIG. 13C, and the present disclosure is not limited here.

In an exemplary implementation mode, the third conductive layer may further include a first connection line 81. The first connection line 81 may be in a shape of a straight line or a polyline extending along the first direction X, and may be located between the second scan signal line 22 and the first initial signal line 41.

In an exemplary implementation mode, an orthographic projection of the first connection line 81 on the base substrate is at least partially overlapped with an orthographic projection of the second region of the first active layer on the base substrate, and the orthographic projection of the first connection line 81 on the base substrate is at least partially overlapped with an orthographic projection of the third shield electrode 63 on the base substrate, i.e., the third shield electrode 63 is disposed between the second region of the first active layer in the semiconductor layer and the first connection line 81 in the third conductive layer.

In an exemplary implementation mode, an orthographic projection of the first connection line 81 on the base substrate and an orthographic projection of the second region of the first active layer on the base substrate have an overlapping region, and an orthographic projection of the third shield electrode 63 on the base substrate may include the overlapping region, so that the third shield electrode 63 may shield the first connection line 81, avoid an influence of data voltage jump in the first connection line 81 on the first transistor T1 and the second transistor T2, reduce an influence of the data voltage jump on normal working of a pixel drive circuit, and improve a display effect.

In an exemplary implementation mode, a first connection line 81 in at least one circuit unit may be provided with a first fracture K1, and the first fracture K1 may sever the first connection line 81, so that first connection lines 81 at two sides of the first fracture K1 are insulated from each other.

In an exemplary implementation mode, at least one first fracture K1 may be disposed in circuit units of the N-th unit column, and an orthographic projection of the first fracture K1 on the base substrate is at least partially overlapped with an orthographic projection of the third shield electrode 63 on the base substrate.

In an exemplary implementation mode, an orthographic projection of the first fracture K1 on the base substrate may be located within a range of an orthographic projection of the third shield electrode 63 on the base substrate, so that the third shield electrode 63 may raise the first fracture K1 from below, which may effectively eliminate a film layer difference in different regions, facilitate shadow elimination, and avoid poor appearance of the display substrate.

In an exemplary implementation mode, the first connection line 81 may include a first connection sub-line 81-1 located at one side of the first fracture K1 in the first direction X, and a second connection sub-line 81-2 located at the other side of the first fracture K1 in the first direction X, respectively. The first connection sub-line 81-1 is configured to be connected with one data signal line in a display region, and the second connection sub-line 81-2 is configured as a first dummy line.

In an exemplary implementation mode, the second connection sub-line 81-2, as the first dummy line, may not be connected with any signal line, or may be connected with a first power supply line, or may be connected with a second power supply line, the present disclosure is not limited here.

In an exemplary implementation mode, the third conductive layer may further include a data connection electrode 83. A shape of the data connection electrode 83 may be a strip shape extending along the second direction Y. In the first direction X, the data connection electrode 83 may be disposed between some adjacent circuit units. In the second direction Y, a data connection electrode 83 may be disposed at a side of the first connection line 81 close to the second electrode plate 32, and the data connection electrode 83 is configured to be connected with a second connection line formed subsequently.

In an exemplary implementation mode, two circuit units may be spaced between adjacent data connection electrodes 83 in the first direction X. For example, a data connection electrode 83 may be disposed between the (N-1)-th unit column and the N-th unit column. For another example, a data connection electrode 83 may be disposed between the (N+1)-th unit column and the (N+2)-th unit column. For another example, a data connection electrode 83 may be disposed between the (N+3)-th unit column and the (N+4)-th unit column. For another example, a data connection electrode 83 may be disposed between the (N+5)-th unit column and the (N+6)-th unit column. For another example, a data connection electrode 83 may be disposed between the (N+7)-th unit column and the (N+8)-th unit column.

In an exemplary implementation mode, the data connection electrode 83 may include at least a first connection sub-block 83-1, a second connection sub-block 83-2, and a connection sub-strip 83-3. The first connection sub-block 83-1 and the second connection sub-block 83-2 may be in a shape of a block (e.g., a rectangle) and be configured to be connected with a second connection line formed subsequently. The connection sub-strip 83-3 may be in a shape of a strip extending along the second direction Y, and may be disposed between the first connection sub-block 83-1 and the second connection sub-block 83-2, one end of the connection sub-strip 83-3 is connected with the first connection sub-block 83-1, and the other end of the connection sub-strip 83-3 is connected with the second connection sub-block 83-2.

In an exemplary implementation mode, in at least one circuit unit, a first connection sub-block 83-1, a second connection sub-block 83-2, and a connection sub-strip 83-3 may be of an interconnected integral structure.

In an exemplary implementation mode, an orthographic projection of the data connection electrode 83 on the base substrate is at least partially overlapped with an orthographic projection of the second shield electrode 62 on the base substrate.

In an exemplary implementation mode, an orthographic projection of the first connection sub-block 83-1 in the data connection electrode 83 on the base substrate may be within a range of an orthographic projection of the second shield electrode 62 on the base substrate.

In an exemplary implementation mode, the at least one circuit unit may further include a data connection block 84. A shape of the data connection block 84 may be a strip shape extending along the second direction Y. In the first direction X, the data connection block 84 may be disposed between some adjacent circuit units. In the second direction Y, the data connection block 84 may be disposed between the first connection sub-line 81-1 and the data connection electrode 83. A first end of the data connection block 84 is connected with the first connection sub-line 81-1, and a second end of the data connection block 84 is connected with the data connection electrode 83. Since the first connection sub-line 81-1 and the data connection electrode 83 are connected together through the data connection block 84, and the data connection electrode 83 is configured to be connected with the second connection line formed subsequently, the data connection block 84 may achieve an interconnection between the first connection sub-line 81-1 and the second connection line.

In an exemplary implementation mode, in at least one circuit unit, a first connection sub-line 81, a data connection electrode 83, and a data connection block 84 may be of an interconnected integral structure.

In an exemplary implementation mode, a data connection block 84 may be disposed between the (N-1)-th unit column and the N-th unit column, while data connection electrodes 83 between the (N+1)-th unit column and the (N+2)-th unit column, between the (N+3)-th unit column and the (N+4)-th unit column, between the (N+5)-th unit column and the (N+6)-th unit column, and between the (N+7)-th unit column and the (N+8)-th unit column are not connected with a second connection sub-line 81-2.

In an exemplary implementation mode, patterns of third conductive layers of adjacent unit columns (except for the data connection block and the first fracture) may be disposed in mirror symmetry with respect to a column center line. For example, positions and shapes of third conductive layers in the N-th unit column and the (N+1)-th unit column may be disposed in mirror symmetry with respect to a column center line. For another example, positions and shapes of second conductive layers in the (N+1)-th unit column and the (N+2)-th unit column may be disposed in mirror symmetry with respect to a column center line.

In an exemplary implementation mode, positions and shapes of third conductive layers of adjacent unit rows may be substantially the same.

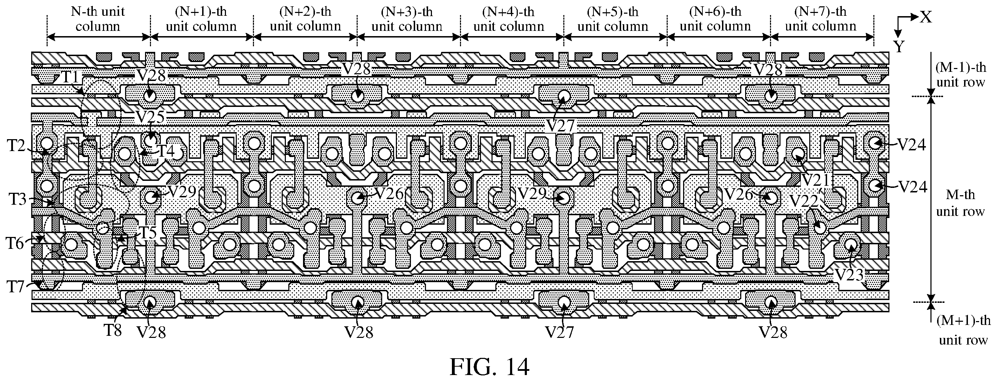

(6) Patterns of a fifth insulation layer and a first planarization layer are formed. In an exemplary implementation mode, forming a pattern of the first planarization layer may include: first depositing a fifth insulation thin film on the base substrate on which the aforementioned patterns are formed, then coating a first planarization thin film, and patterning the first planarization thin film and the fifth insulation thin film through a patterning process to form a fifth insulation layer that covers the pattern of the fourth conductive layer and the first planarization layer disposed on the fifth insulation layer, the first planarization layer and the fifth insulation layer being provided with a plurality of vias, as shown in FIG. 14.

In an exemplary implementation mode, a plurality of vias in each circuit unit in the display substrate at least include a twenty-first via V21, a twenty-second via V22, and a twenty-third via V23.

In an exemplary implementation mode, an orthographic projection of the twenty-first via V21 on the base substrate is within a range of an orthographic projection of the second connection electrode 52 on the base substrate, the first planarization layer and the fifth insulation layer within the twenty-first via V21 are removed to expose a surface of the second connection electrode 52, and the twenty-first via V21 is configured such that a data signal line formed subsequently is connected with the second connection electrode 52 through the via.

In an exemplary implementation mode, an orthographic projection of the twenty-second via V22 on the base substrate is within a range of an orthographic projection of the third connection electrode 53 on the base substrate, the first planarization layer and the fifth insulation layer within the twenty-second via V22 are removed to expose a surface of the third connection electrode 53, and the twenty-second via V22 is configured such that a first power supply line formed subsequently is connected with the third connection electrode 53 through this via.

In an exemplary implementation mode, an orthographic projection of the twenty-third via V23 on the base substrate is located within a range of an orthographic projection of the fourth connection electrode 54 on the base substrate, the first planarization layer and the fifth insulation layer within the twenty-third via V23 are removed to expose a surface of the fourth connection electrode 54, and the twenty-third via V23 is configured such that an anode connection electrode formed subsequently is connected with the fourth connection electrode 54 through this via.

In an exemplary implementation mode, the at least one circuit unit may further include a twenty-fourth via V24. An orthographic projection of the twenty-fourth via V24 on the base substrate is located within a range of an orthographic projection of the data connection electrode 83 on the base substrate, the first planarization layer and the fifth insulation layer within the twenty-fourth via V24 are etched away to expose a surface of the data connection electrode 83, and the twenty-fourth via V24 is configured such that a second connection line formed subsequently is connected with the data connection electrode 83 through this via.

In an exemplary implementation mode, two circuit units may be spaced between adjacent twenty-fourth vias V24 in the first direction X. For example, a twenty-fourth via V24 may be disposed between the (N-1)-th unit column and the N-th unit column. For another example, a twenty-fourth via V24 may be disposed between the (N+1)-th unit column and the (N+2)-th unit column. For another example, a twenty-fourth via V24 may be disposed between the (N+3)-th unit column and the (N+4)-th unit column. For another example, a twenty-fourth via V24 may be disposed between the (N+5)-th unit column and the (N+6)-th unit column. For another example, a twenty-fourth via V24 may be disposed between the (N+7)-th unit column and the (N+8)-th unit column.

In an exemplary implementation mode, a quantity of twenty-fourth vias V24 may be two. An orthographic projection of one twenty-fourth via V24 on the base substrate is within a range of an orthographic projection of the first connection sub-block 83-1 on the base substrate, and an orthographic projection of the other twenty-fourth via V24 on the base substrate is within a range of an orthographic projection of the second connection sub-block 83-2 on the base substrate.

In an exemplary implementation mode, the at least one circuit unit may further include a twenty-fifth via V25. An orthographic projection of the twenty-fifth via V25 on the base substrate is within a range of an orthographic projection of the sixth connection electrode 56 on the base substrate, the first planarization layer and the fifth insulation layer within the twenty-fifth via V25 is removed to expose a surface of the sixth connection electrode 56, and the twenty-fifth via V25 is configured such that a subsequently formed first initial connection line is connected with the sixth connection electrode 56 through the via.

In an exemplary implementation mode, eight circuit units may be spaced between adjacent twenty-fifth vias V25 in the first direction X. For example, a twenty-fifth via V25 may be disposed between the N-th unit column and the (N+1)-th unit column. For another example, a twenty-fifth via V25 may be disposed between the (N+8)-th unit column and an (N+9)-th unit column.

In an exemplary implementation mode, the at least one circuit unit may further include a twenty-sixth via V26. An orthographic projection of the twenty-sixth via V26 on the base substrate is within a range of an orthographic projection of the connection electrode block 58-2 of the eighth connection electrode 58 on the base substrate, the first planarization layer and the fifth insulation layer within the twenty-sixth via V26 are removed to expose a surface of the connection electrode block 58-2, and the twenty-sixth via V26 is configured such that a subsequently formed second initial connection line is connected with the connection electrode block 58-2 through the via.

In an exemplary implementation mode, four circuit units may be spaced between adjacent twenty-sixth vias V26 in the first direction X. For example, a twenty-sixth via V26 may be disposed between the (N+2)-th unit column and the (N+3)-th unit column. For another example, a twenty-sixth via V26 may be disposed between the (N+6)-th unit column and the (N+7)-th unit column.

In an exemplary implementation mode, the at least one circuit unit may further include a twenty-seventh via V27. An orthographic projection of the twenty-seventh via V27 on the base substrate is within a range of an orthographic projection of the seventh connection electrode 57 on the base substrate, the first planarization layer and the fifth insulation layer within the twenty-seventh via V27 are removed to expose a surface of the seventh connection electrode 57, and the twenty-seventh via V27 is configured such that a subsequently formed third initial connection line is connected with the seventh connection electrode 57 through the via.

In an exemplary implementation mode, eight circuit units may be spaced between adjacent twenty-seventh vias V27 in the first direction X. For example, a twenty-seventh via V27 may be disposed between the (N+4)-th unit column and the (N+5)-th unit column. For another example, a twenty-seventh via V27 may be disposed between an (N+12)-th unit column and an (N+13)-th unit column.

In an exemplary implementation mode, the at least one circuit unit may further include a twenty-eighth via V28. An orthographic projection of the twenty-eighth via V28 on the base substrate is within a range of an orthographic projection of the seventh connection electrode 57 on the base substrate, the first planarization layer within the twenty-eighth via V28 is removed to expose a surface of the fifth insulation layer covering the seventh connection electrode 57, and the twenty-eighth via V28 is configured to enable morphology of a first initial connection line and a second initial connection line formed subsequently to be substantially the same as morphology of a third initial connection line formed subsequently, which may not only improve uniformity of an etching process, but also improve uniformity of an anode formed subsequently.

In an exemplary implementation mode, the twenty-seventh via V27 may be referred to as a connection via, the twenty-eighth via V28 may be referred to as a dummy via, and a position and a shape of a twenty-seventh via V27 in one circuit unit may be substantially the same as a position and a shape of a twenty-eighth via V28 in another circuit unit, except that the first planarization layer and the fifth insulation layer within the twenty-seventh via V27 are removed to expose a surface of the seventh connection electrode 57, which may achieve a connection between the third initial connection line and the seventh connection electrode 57, while only the first planarization layer within the twenty-eighth via V28 is removed and the seventh connection electrode 57 is still covered by the fifth insulation layer, thus the first initial connection line or the second initial connection line formed subsequently will not be connected with the seventh connection electrode 57.

In an exemplary implementation mode, the twenty-seventh via V27 and the twenty-eighth via V28 may be located on a same straight line extending along the first direction X.

In an exemplary implementation mode, for a layout in which a twenty-seventh via V27 is disposed between the (N+4)-th unit column and the (N+5)-th unit column, twenty-eighth vias V28 may be disposed between the N-th unit column and the (N+1) unit column, between the (N+2)-th unit column and the (N+3)-th unit column, and between the (N+6)-th unit column and the (N+7)-th unit column, respectively.

In an exemplary implementation mode, the at least one circuit unit may further include a twenty-ninth via V29. An orthographic projection of the twenty-ninth via V29 on the base substrate is within a range of an orthographic projection of the dummy electrode block 59-2 of the dummy connection electrode 59 on the base substrate, the first planarization layer within the twenty-ninth via V29 is removed to expose a surface of the fifth insulation layer covering the dummy electrode block 59-2, and the twenty-ninth via V29 is configured to enable morphology of the first initial connection line and the third initial connection line formed subsequently to be essentially the same as morphology of the second initial connection line formed subsequently, which may not only improve uniformity of an etching process, but also improve uniformity of an anode formed subsequently.

In an exemplary implementation mode, four circuit units may be spaced between adjacent twenty-ninth vias V29 in the first direction X. For example, a twenty-ninth via V29 may be disposed between the N-th unit column and the (N+1)-th unit column. For another example, a twenty-ninth via V29 may be disposed between the (N+4)-th unit column and the (N+5)-th unit column.

In an exemplary implementation mode, the twenty-sixth via V26 may be referred to as a connection via, the twenty-ninth via V29 may be referred to as a dummy via, and a position and a shape of a twenty-sixth via V26 in one circuit unit may be substantially the same as a position and a shape of a twenty-ninth via V29 in another circuit unit, except that the first planarization layer and the fifth insulation layer within the twenty-sixth via V26 are removed to expose a surface of the eighth connection electrode 58, which may achieve a connection between the second initial connection line and the eighth connection electrode 58, while only the first planarization layer within the twenty-ninth via V29 is removed and the dummy connection electrode 59 is still covered by the fifth insulation layer, thus the first initial connection line or the third initial connection line formed subsequently will not be connected with the dummy connection electrode 59.

In an exemplary implementation mode, the twenty-sixth via V26 and the twenty-ninth via V29 may be located on a same straight line extending along the first direction X.

In some other implementation modes, the display substrate may not be provided with the fifth insulation layer, and the present disclosure is not limited here. For a case where the fifth insulation layer is not provided in the display substrate, a present process may include: directly coating the first planarization thin film on the base substrate on which the aforementioned patterns are formed, and patterning the first planarization thin film through a patterning process of halftone or gray tone to form a first planarization layer covering the pattern of the fourth conductive layer, wherein the first planarization layer is provided with a plurality of vias. The first planarization layer within the twenty-sixth via V26 and the twenty-seventh via V27, which are used as connection vias, is completely removed to expose surfaces of the seventh connection electrode 57 and the eighth connection electrode 58, respectively, so that corresponding initial connection lines may be connected with the seventh connection electrode 57 and the eighth connection electrode 58, respectively. The first planarization layer within the twenty-eighth via V28 and the twenty-ninth via V29, which are used as dummy vias, is partially removed, and the seventh connection electrode 57 and the dummy connection electrode 59 are still covered by the first planarization layer, so that corresponding initial connection lines formed subsequently are not connected with the seventh connection electrode 57 or the dummy connection electrode 59. Herein, the patterning process of halftone or gray tone may achieve that the first planarization layer with part of thickness is retained within the dummy vias, while the first planarization layer within other vias is completely removed.

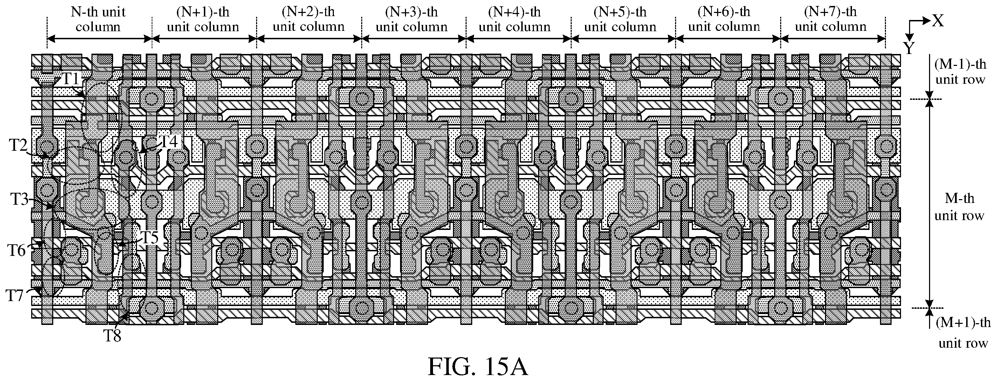

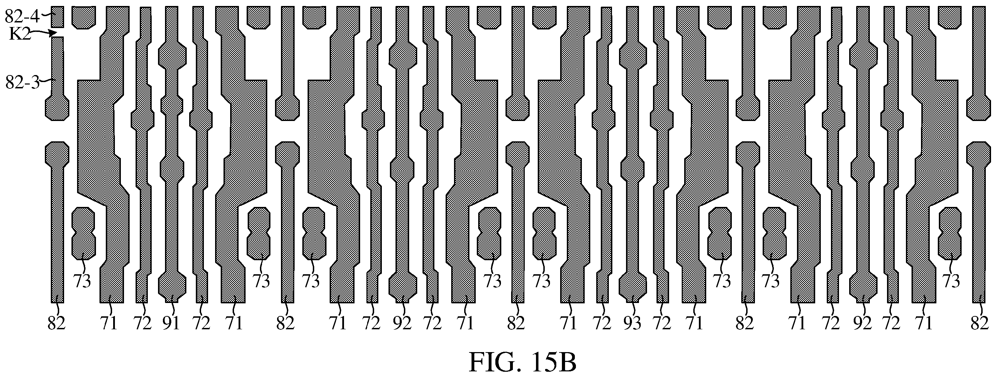

(7) A pattern of a fourth conductive layer is formed. In an exemplary implementation mode, forming the fourth conductive layer may include: depositing a fourth conductive thin film on the base substrate on which the aforementioned patterns are formed, and patterning the fourth conductive thin film through a patterning process to form a fourth conductive layer disposed on the first planarization layer, as shown in FIG. 15A and FIG. 15B. FIG. 15B is a planar schematic diagram of the fourth conductive layer in FIG. 15A. In an exemplary implementation mode, the fourth conductive layer may be referred to as a second source-drain metal (SD2) layer.

In an exemplary implementation mode, the fourth conductive layer of each circuit unit in the display substrate includes, at least, a first power supply line 71, a data signal line 72, and an anode connection electrode 73.

In an exemplary implementation mode, the first power supply line 71 may be in a shape of a straight line or a polyline of which a main body portion extends along the second direction Y, and the first power supply line 71 is connected with the third connection electrode 53 through the twenty-second via V22. Since the third connection electrode 53 is respectively connected with the first region of the fifth active layer and the second electrode plate 32 through vias, it is achieved that a first power supply signal may be written by the first power supply line 71 into the second electrode plate 32 and the first electrode of the fifth transistor T5.

In an exemplary implementation mode, the first power supply line 71 may be a polyline with variable widths, and an orthographic projection of the first power supply line 71 on the base substrate is at least partially overlapped with an orthographic projection of the first connection electrode 51 on the base substrate. Since the first connection electrode 51 serves as the first node N1 of the pixel drive circuit, the first power supply line 71 having a constant potential may shield the first node N1, which may avoid an influence of data voltage jump on the first node N1, improve working stability of the pixel drive circuit, and improve a display effect.

In an exemplary implementation mode, the orthographic projection of the first power supply line 71 on the base substrate may contain the orthographic projection of the first connection electrode 51 on the base substrate, that is, the first power supply line 71 may completely cover the first connection electrode 51.

In an exemplary implementation mode, the orthographic projection of the first power supply line 71 on the base substrate may contain an orthographic projection of the first fracture K1 on the base substrate, so that the first power supply line 71 may shield the first fracture K1 from above, which may effectively eliminate a film layer difference in different regions, facilitate shadow elimination, and avoid poor appearance of the display substrate.

In the exemplary implementation mode, the data signal line 72 may have a shape of a straight line or a polyline of which a main body portion extends along the second direction Y, and the data signal line 72 is connected with the second connection electrode 52 through the twenty-first via V21. Since the second connection electrode 52 is connected with the first region of the fourth active layer through a via, it is achieved that the data signal line 72 may write a data signal into the first electrode of the fourth transistor T4.

In an exemplary implementation mode, an orthographic projection of the data signal line 72 on the base substrate is not overlapped with orthographic projections of channel regions of the first transistor T1 to the eighth transistor T8 on the base substrate, signal crosstalk caused by data voltage jump of the data signal line 72 may be avoided, an influence of the data voltage jump on the first transistor T1 to the eighth transistor T8 may be avoided, working stability of a pixel drive circuit may be improved, and a display effect may be improved.

In an exemplary implementation mode, the anode connection electrode 73 may be in a shape of a strip extending along the second direction Y, the anode connection electrode 73 is connected with the fourth connection electrode 54 through the twenty-third via V23, and the anode connection electrode 73 is configured to be connected with a subsequently formed anode. Since the fourth connection electrode 54 is connected with the second region of the sixth active layer (also the second region of the seventh active layer) through a via, it may be achieved that a pixel drive circuit outputs a drive current to a light emitting device.

In an exemplary implementation mode, the fourth conductive layer may further include a second connection line 82. A shape of the second connection line 82 may be a straight line or a polyline of which a main body portion extends along the second direction Y. In the first direction X, the second connection line 82 may be disposed between first power supply lines 71 of some adjacent unit columns, and in the second direction Y, second connection lines 82 may be disposed at intervals. One second connection line 82 may be connected with the first connection sub-block 83-1 through one twenty-fourth via V24, and another second connection line 82 may be connected with the second connection sub-block 83-2 through another twenty-fourth via V24, thus achieving a connection between two second connection lines 82.

In an exemplary implementation mode, a second connection line 82 in at least one circuit unit may be provided with a second fracture K2, and the second fracture K2 may sever the second connection line 82, so that second connection lines 82 at two sides of the second fracture K2 are insulated from each other.

In an exemplary implementation mode, an orthographic projection of at least one second fracture K2 on the base substrate is at least partially overlapped with an orthographic projection of the second initial connection block 42-1 on the base substrate.

In an exemplary implementation mode, an orthographic projection of the second fracture K2 on the base substrate may be located within a range of an orthographic projection of the second initial connection block 42-1 on the base substrate, so that the second initial connection block 42-1 may raise the second fracture K2 from below, which may effectively eliminate a film layer difference in different regions, facilitate shadow elimination, and avoid poor appearance of the display substrate.

In an exemplary implementation mode, the second connection line 82 may include a third connection sub-line 82-3 located at a side of the second fracture K2 in the second direction Y and a fourth connection sub-line 82-4 located at a side of the second fracture K2 in an opposite direction of the second direction Y, respectively, and the third connection sub-line 82-3 is configured to be connected with a data leading-out line in a bonding region, and the fourth connection sub-line 82-4 is configured as a second dummy line.

In an exemplary implementation mode, the fourth connection sub-line 82-4, which is used as the second dummy line, may not be connected with any signal line, or may be connected with a first power supply line, or may be connected with a second power supply line, the present disclosure is not limited here.

In an exemplary implementation mode, two circuit units may be spaced between adjacent second connection lines 82 in the first direction X. For example, a second connection line 82 may be disposed between first power supply lines 71 of the (N-1)-th unit column and the N-th unit column. For another example, a second connection line 82 may be disposed between first power supply lines 71 of the (N+1)-th unit column and the (N+2)-th unit column. For another example, a second connection line 82 may be disposed between first power supply lines 71 of the (N+3)-th unit column and the (N+4)-th unit column. For another example, a second connection line 82 may be disposed between first power supply lines 71 of the (N+5)-th unit column and the (N+6)-th unit column. For another example, a second connection line 82 may be disposed between first power supply lines 71 of the (N+7)-th unit column and the (N+8)-th unit column.

In an exemplary implementation mode, since a data connection electrode 83 disposed between the (N-1)-th unit column and the N-th unit column is connected with a first connection sub-line 81-1 through a data connection block 84, the first connection sub-line 81-1 is configured to be connected with a data signal line in the display region, and a second connection line 82 is configured to be connected with a data leading-out line in the bonding region, it is achieved a mutual connection between a first connection line 81 of which a main body portion extends along the first direction X and the second connection line 82 of which a main body portion extends along the second direction Y. The data leading-out line in the bonding region is connected with the data signal line in the display region through the first connection line 81 and the second connection line 82.

In an exemplary implementation mode, the second connection line 82 may be disposed between adjacent first power supply lines 71, and the first power supply line 71 having a constant potential may shield an influence of data voltage jump of the second connection line 82 on a key node in a pixel drive circuit, improve working stability of the pixel drive circuit, and improve a display effect.

In an exemplary implementation mode, the fourth conductive layer may further include a first initial connection electrode 91. The first initial connection line 91 may be in a shape of a straight line or a polyline of which a main body portion extends along the second direction Y, may be disposed between data signal lines 72 of some adjacent unit columns, and the first initial connection line 91 may be connected with the sixth connection electrode 56 through the twenty-fifth via V25. Since the sixth connection electrode 56 is connected with the first initial connection block 41-1, and the first initial connection block 41-1 is connected with the first initial signal line 41, it is achieved that the first initial signal line 41 extending along the first direction X and the first initial connection line 91 extending along the second direction Y form a mesh communication structure for transmitting a first initial signal. Therefore, a resistance of the first initial signal line may be reduced effectively, voltage drop of the first initial signal may be reduced, uniformity of the first initial signal in the display substrate may be improved effectively, uniformity of display may be improved effectively, and display attribute and display quality may be improved.

In an exemplary implementation mode, a first initial signal line 41 may be disposed in each unit row, first initial connection lines 91 may be disposed in some unit columns, and eight circuit units may be spaced between adjacent first initial connection lines 91 in the first direction X. For example, a first initial connection line 91 may be disposed between data signal lines 72 of the N-th unit column and the (N+1)-th unit column. For another example, a first initial connection line 91 may be disposed between data signal lines 72 of the (N+8)-th unit column and the (N+9)-th unit column.

In an exemplary implementation mode, the fourth conductive layer may further include a second initial connection line 92. The second initial connection line 92 may be in a shape of a straight line or a polyline of which a main body portion extends along the second direction Y, and may be disposed between data signal lines 72 of some adjacent unit columns, and the second initial connection line 92 may be connected with the connection electrode block 58-2 through the twenty-sixth via V26. Since the connection electrode block 58-2 is connected with the connection electrode strip 58-1 and the connection electrode strip 58-1 is connected with the second initial signal lines 42, it is achieved that the second initial signal line 42 extending along the first direction X and the second initial connection line 92 extending along the second direction Y form a mesh communication structure for transmitting a second initial signal, a resistance of a second initial signal line may be reduced effectively, voltage drop of the second initial signal may be reduced, uniformity of the second initial signal in the display substrate may be improved effectively, uniformity of display may be improved effectively, and display attribute and display quality may be improved.

In an exemplary implementation mode, a second initial signal line 42 may be disposed in each unit row, second initial connection lines 92 may be disposed in some unit columns, and four circuit units may be spaced between adjacent second initial connection lines 92 in the first direction X. For example, a second initial connection line 92 may be disposed between data signal lines 72 of the (N+2)-th unit column and the (N+3)-th unit column. For another example, a second initial connection line 92 may be disposed between data signal lines 72 of the (N+6)-th unit column and the (N+7)-th unit column.

In an exemplary implementation mode, the fourth conductive layer may further include a third initial connection line 93. The third initial connection line 93 may be in a shape of a straight line or a polyline of which a main body portion extends along the second direction Y, and may be disposed between data signal lines 72 of some adjacent unit columns, and the third initial connection line 93 may be connected with the seventh connection electrode 57 through the twenty-seventh via V27. Since the seventh connection electrode 57 is connected with the third initial connection block 43-1 and the third initial connection block 43-1 is connected with the third initial signal line 43, it is achieved that the third initial signal line 43 extending along the first direction X and the third initial connection line 93 extending along the second direction Y form a mesh communication structure for transmitting a third initial signal, a resistance of a third initial signal line may be reduced effectively, voltage drop of the third initial signal may be reduced, uniformity of the third initial signal in the display substrate may be improved effectively, uniformity of display may be improved effectively, and display attribute and display quality may be improved.

In an exemplary implementation mode, a third initial signal line 43 may be disposed in each unit row, third initial connection lines 93 may be disposed in some unit columns, and eight circuit units may be spaced between adjacent third initial connection lines 93 in the first direction X. For example, a third initial connection line 93 may be disposed between data signal lines 72 of the (N+4)-th unit column and the (N+5)-th unit column. For another example, a third initial connection line 93 may be disposed between data signal lines 72 of the (N+12)-th unit column and the (N+13)-th unit column.

In an exemplary implementation mode, a first initial connection line 91, a second initial connection line 92, a third initial connection line 93, and a second initial connection line 92 may be periodically disposed in the first direction X, two second initial connection lines 92 and one third initial connection line 93 may be disposed between two adjacent first initial connection lines 91 in the first direction X, one first initial connection line 91 or one third initial connection line 93 may be disposed between two adjacent second initial connection lines 92 in the first direction X. One first initial connection line 91 and two second initial connection lines 92 may be disposed between two adjacent third initial connection line 93 in the first direction X. In the first direction X, a first initial connection line 91 may be disposed between two second initial connection lines 92, a second initial connection line 92 may be disposed between a first initial connection line 91 and a third initial connection line 93, and a third initial connection line 93 may be disposed between two second initial connection lines 92.

In an exemplary implementation mode, the first initial connection line 91 and the second initial connection line 92 may also fill the twenty-eighth via V28, i.e., the first initial connection line 91 and the second initial connection line 92 are at least partially disposed within the dummy via. Since only the first planarization layer is removed in the twenty-eighth via V28 and the seventh connection electrode 57 is still covered with the fifth insulation layer, or only the first planarization layer with part of thickness is removed in the twenty-eighth via V28 and the seventh connection electrode 57 is still covered with the first planarization layer, the first initial connection line 91 and the second initial connection line 92 are not connected with the seventh connection electrode 57.

In an exemplary implementation mode, morphology presented by filling the twenty-eighth via V28 with the first initial connection line 91 and the second initial connection line 92 may be substantially the same as morphology presented by connecting the seventh connection electrode 57 through the twenty-seventh via V27 with the third initial connection line 93, which may not only enable different regions to achieve a same display effect under transmitted and reflected light, achieve shadow elimination, effectively avoid occurrence of poor appearance of the display substrate and occurrence of screen-off watermark (mura), improve display attribute and display quality, but also improve uniformity of a subsequently formed anode.

In an exemplary implementation mode, the first initial connection line 91 and the third initial connection line 93 may also fill the twenty-ninth via V29, i.e., the first initial connection line 91 and the third initial connection line 93 are at least partially disposed within the dummy via. Since only the first planarization layer is removed in the twenty-ninth via V29 and the dummy connection electrode 59 is still covered with the fifth insulation layer, or only the first planarization layer with part of thickness is removed in the twenty-ninth via V29 and the dummy connection electrode 59 is still covered with the first planarization layer, the first initial connection line 91 and the third initial connection line 93 are not connected with the dummy connection electrode 59.

In an exemplary implementation mode, morphology presented by filling the twenty-ninth via V29 with the first initial connection line 91 and the third initial connection line 93 may be substantially the same as morphology presented by connecting the eighth connection electrode 58 through the twenty-sixth via V26 with the second initial connection line 92, which may not only enable different regions to achieve a same display effect under transmitted and reflected light, achieve shadow elimination, effectively avoid occurrence of poor appearance of the display substrate and occurrence of screen-off watermark (mura), improve display attribute and display quality, but also improve uniformity of a subsequently formed anode.

In an exemplary implementation mode, the first initial connection line 91, the second initial connection line 92, and the third initial connection line 93 are disposed between adjacent data signal lines 72, and the first initial connection line 91, the second initial connection line 92, and the third initial connection line 93 having a constant potential may shield an influence between data signal lines 72, improve working stability of a pixel drive circuit, and improve a display effect.

In an exemplary implementation mode, patterns of fourth conductive layers (except for the second fracture) of adjacent unit columns may be disposed in mirror symmetry with respect to a column center line. For example, positions and shapes of fourth conductive layers in the N-th unit column and the (N+1)-th unit column may be disposed in mirror symmetry with respect to a column center line. For another example, positions and shapes of fourth conductive layers in the (N+1)-th unit column and the (N+2)-th unit column may be disposed in mirror symmetry with respect to a column center line.

In an exemplary implementation mode, positions and shapes of fourth conductive layers of adjacent unit rows may be substantially the same.

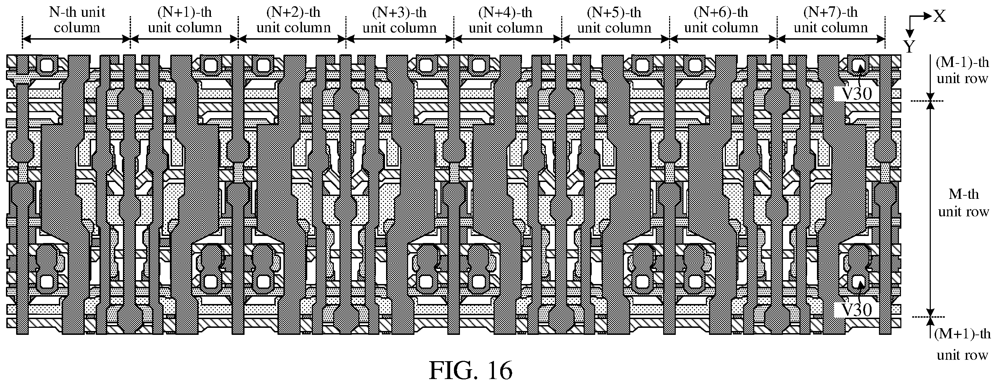

(8) A pattern of a second planarization layer is formed. In an exemplary implementation mode, forming the pattern of the second planarization layer may include: coating a second planarization thin film on the base substrate on which the aforementioned patterns are formed, and patterning the second planarization thin film through a patterning process to form a second planarization layer covering the pattern of the fourth conductive layer, herein, the second planarization layer is provided with a plurality of anode vias V30, as shown in FIG. 16.

In an exemplary implementation mode, an orthographic projection of an anode via V30 of each circuit unit in the display substrate on the base substrate is located within a range of an orthographic projection of the anode connection electrode 73 on the base substrate, the second planarization layer within the anode via V30 is removed to expose a surface of the anode connection electrode 73, and the anode via V30 is configured such that an anode formed subsequently is connected with the anode connection electrode 73 through the via.

So far, a drive structure layer according to a present embodiment is prepared on the base substrate. In a plane parallel to the display substrate, the drive structure layer may include a plurality of circuit units, and each circuit unit may include a pixel drive circuit, and a first scan signal line, a second scan signal line, a third scan signal line, a light emitting signal line, a first initial signal line, a second initial signal line, a third initial signal line, a first power supply line, and a data signal line which are connected with the pixel drive circuit.

In a direction perpendicular to the display substrate, the drive structure layer may include a first insulation layer, a semiconductor layer, a second insulation layer, a first conductive layer, a third insulation layer, a second conductive layer, a fourth insulation layer, a third conductive layer, a fifth insulation layer, a first planarization layer, a fourth conductive layer, and a second planarization layer which are disposed sequentially on the base substrate. The semiconductor layer may include at least active layers of a plurality of poly silicon transistors, the first conductive layer may include at least a first scan signal line, a second scan signal line, a third scan signal line, a light emitting signal line, and a first electrode plate of a storage capacitor, the second conductive layer may include at least a first initial signal line, a third initial signal line, and a second electrode plate of the storage capacitor, the third conductive layer may include at least a first connection line, a second initial signal line, and a plurality of connection electrodes, and the fourth conductive layer may include at least a first power supply line, a second connection line, and a data signal line.

In some other implementation modes, the first initial signal line, the second initial signal line, and the third initial signal line may be disposed in at least one of the second conductive layer and the third conductive layer, and the present disclosure is not limited here. For example, the second initial signal line may be disposed in the second conductive layer, and the first initial signal line and the third initial signal line may be disposed in the third conductive layer. For another example, the first initial signal line, the second initial signal line, and the third initial signal line may all be disposed in the second conductive layer. For another example, the first initial signal line, the second initial signal line, and the third initial signal line may all be disposed in the third conductive layer.

In an exemplary implementation mode, the base substrate may be a flexible base substrate, or a rigid base substrate. The rigid base substrate may include, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation mode, the flexible base substrate may include a first flexible material layer, a first inorganic material layer, a semiconductor layer, a second flexible material layer, and a second inorganic material layer stacked on a glass carrier plate. Materials of the first flexible material layer and the second flexible material layer may be Polyimide (PI), Polyethylene Terephthalate (PET), or a surface-treated polymer soft film, etc., and materials of the first inorganic material layer and the second inorganic material layer may be Silicon Nitride (SiNx), Silicon Oxide (SiOx), or the like, for improving water and oxygen resistance of the base substrate. The first inorganic material layer and the second inorganic material layer may also be referred to as barrier layers, and a material of the semiconductor layer may be amorphous silicon (a-si).

In an exemplary implementation mode, the first insulation layer, the second insulation layer, the third insulation layer, the fourth insulation layer, and the fifth insulation layer may be made of any one or more of Silicon Oxide (SiOx), Silicon Nitride (SiNx), and Silicon Oxynitride (SiON), and may be a single layer, a multi-layer, or a composite layer. The first conductive layer, the second conductive layer, the third conductive layer, and the fourth conductive layer may be made of a metal material such as Argentum (Ag), Copper (Cu), Aluminum (Al), Titanium (Ti), or Molybdenum (Mo), or may be made of an alloy material composed of metals, such as an Aluminum-Neodymium alloy (AlNd) or a Molybdenum-Niobium alloy (MoNb), and may be of a single-layer structure or a multi-layer composite structure, such as Ti/Al/Ti. The first planarization layer and the second planarization layer may be made of an organic material such as resin or polyimide.

In an exemplary implementation mode, after preparation of the drive structure layer is completed, a light emitting structure layer is prepared on the drive structure layer, and a preparation process of the light emitting structure layer may include following operations.

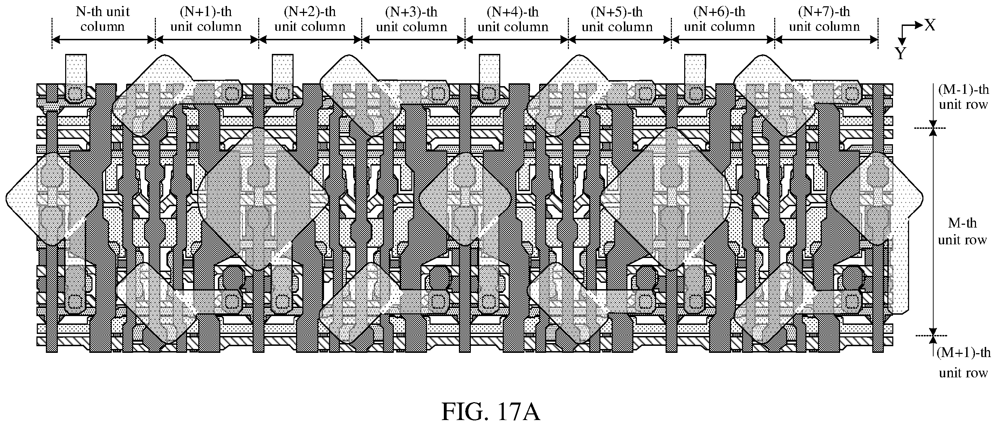

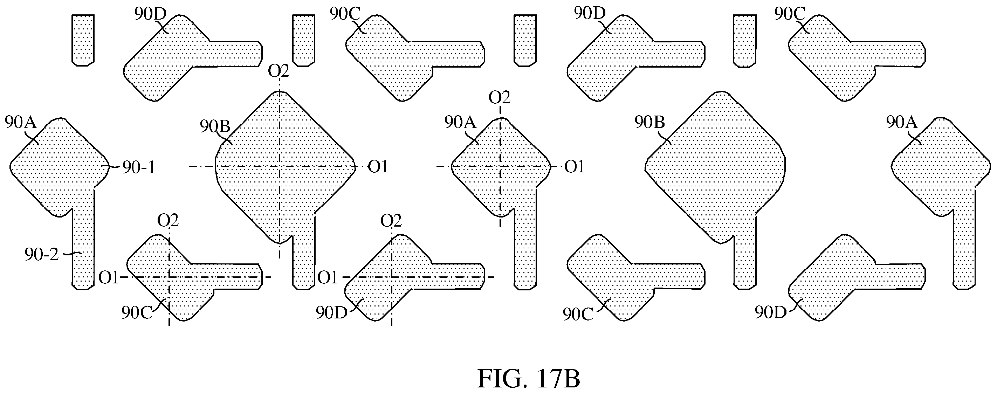

(9) A pattern of an anode conductive layer is formed. In an exemplary implementation mode, forming the pattern of the anode conductive layer may include: depositing an anode conductive thin film on the base substrate on which the aforementioned patterns are formed, and patterning the anode conductive thin film using a patterning process to form an anode conductive layer disposed on the second planarization layer, wherein the anode conductive layer at least includes patterns of a plurality of anodes, as shown in FIG. 17A and FIG. 17B, and FIG. 17B is a schematic plan view of the anode conductive layer in FIG. 17A.

In an exemplary implementation mode, patterns of the plurality of anodes may include a first anode 90A located in a red light emitting unit emitting red light, a second anode 90B located in a blue light emitting unit emitting blue light, a third anode 90C located in a first green light emitting unit emitting green light, and a fourth anode 90D located in a second green light emitting unit emitting green light, and the first anode 90A, the second anode 90B, the third anode 90C, and the fourth anode 90D may be connected with anode connection electrodes 73 of circuit units where these anodes are located through anode vias V30, respectively.

In an exemplary implementation mode, at least one of the first anode 90A, the second anode 90B, the third anode 90C, and the fourth anode 90D may include a main body portion 90-1 and a connection portion 90-2 connected with each other, the main body portion 90-1 may be in a rhombus shape, a corner portion of the rhombus shape may be provided with an arc-shaped chamfer, the connection portion 90-2 may be in a strip shape, a first end of the connection portion 90-2 is connected with the main body portion 90-1, and a second end of the connection portion 90-2 is connected with an anode connection electrode 73 through an anode via V30 after extending toward a direction away from the main body portion 90-1.

In an exemplary implementation mode, orthographic projections of a main body portion of the first anode 90A and a main body portion of the second anode 90B on the base substrate are at least partially overlapped with an orthographic projection of a second connection line 82 on the base substrate, while orthographic projections of a main body portion of the third anode 90C and a main body portion of the fourth anode 90D on the base substrate are not overlapped with the orthographic projection of the second connection line 82 on the base substrate, that is, the second connection line 82 is disposed only below anodes of the red light emitting unit and the blue light emitting unit.

In an exemplary implementation mode, orthographic projections of the main body portion of the third anode 90C and the main body portion of the fourth anode 90D on the base substrate are at least partially overlapped with an orthographic projection of an initial connection line on the base substrate, while orthographic projections of the main body portion of the first anode 90A and the main body portion of the second anode 90B on the base substrate are not overlapped with the orthographic projection of the initial connection line on the base substrate, that is, the initial connection line is disposed only below anodes of the first green light emitting unit and the second green light emitting unit. Herein, the initial connection line may be the first initial connection line 91, or the second initial connection line 92, or the third initial connection line 93.

In an exemplary implementation mode, at least one of the first anode 90A, the second anode 90B, the third anode 90C, and the fourth anode 90D may have a first center line O1 and a second center line O2, the first center line O1 may be a straight line passing through a geometric center of a main body portion of a corresponding anode and extending along the first direction X, and the second center line O2 may be a straight line passing through a geometric center of a main body portion of a corresponding anode and extending along the second direction Y.

In an exemplary implementation mode, each of orthographic projections of the main body portion of the first anode 90A and the main body portion of the second anode 90B on the base substrate is at least partially overlapped with orthographic projections of three signal lines on the base substrate. The three signal lines may be two first power supply lines 71 and one second connection line 82 located in the fourth conductive layer, the second connection line 82 may be located between the two first power supply lines 71, an orthographic projection of the second connection line 82 on the base substrate is at least partially overlapped with an orthographic projection of the second center line O2 on the base substrate, and positions of the two first power supply lines 71 may be disposed substantially symmetrically with respect to the second connection line 82. In this way, quantities of signal lines in the SD2 layer below the main body portion of the first anode 90A and the main body portion of the second anode 90B at a plurality of positions are substantially the same, and signal lines below each anode are symmetrically disposed, so that flatness and uniformity of the first anode 90A and the second anode 90B may be guaranteed, which may not only ensure that light emitting performance of two light emitting devices is basically the same, improve asymmetry of left and right color cast, but also avoid defects such as screen-off watermark caused by a height difference in anodes, thus improving quality of the display substrate.

In an exemplary implementation mode, each of orthographic projections of the main body portion of the third anode 90C and the main body portion of the fourth anode 90D on the base substrate is at least partially overlapped with orthographic projections of three signal lines on the base substrate. The three signal lines may be two data signal lines 72 and one initial connection line located in the fourth conductive layer, the initial connection line may be located between the two data signal lines 72, an orthographic projection of the initial connection line on the base substrate is at least partially overlapped with an orthographic projection of the second center line O2 on the base substrate, and positions of the two data signal lines 72 may be disposed substantially symmetrically with respect to the initial connection line. Herein, the initial connection line may be the first initial connection line 91, or the second initial connection line 92, or the third initial connection line 93. In this way, quantities of signal lines in the SD2 layer below the main body portion of the third anode 90C and the main body portion of the fourth anode 90D at a plurality of positions are substantially the same, and signal lines below each anode are symmetrically disposed, so that flatness and uniformity of the third anode 90C and the fourth anode 90D may be guaranteed, which may not only ensure that light emitting performance of two light emitting devices is basically the same, improve asymmetry of left and right color cast, but also avoid defects such as screen-off watermark caused by a height difference in anodes, thus improving quality of the display substrate.

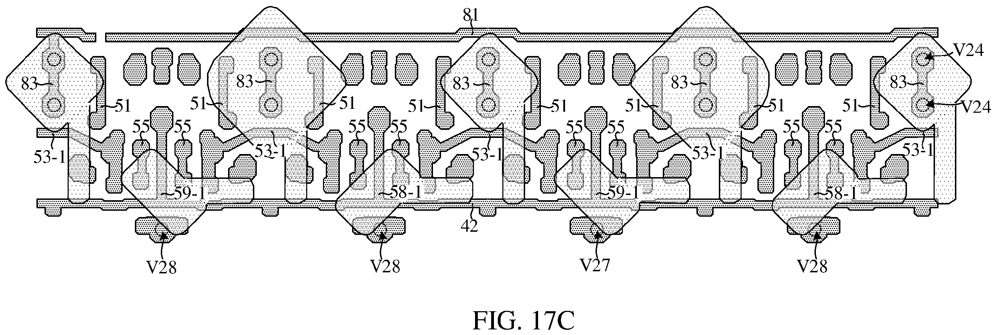

FIG. 17C is a schematic diagram of a positional relationship between the anode conductive layer and the third conductive layer in FIG. 17A. As illustrated in FIG. 17C, the first anode 90A, the second anode 90B, the third anode 90C, and the fourth anode 90D have overlapping relationships with signal lines and a plurality of electrodes in the third conductive layer.

In an exemplary implementation mode, each of orthographic projections of the main body portion of the first anode 90A and the main body portion of the second anode 90B on the base substrate is at least partially overlapped with orthographic projections of two transverse lines on the base substrate. The two transverse lines may be the first connection line 81 and the electrode connection line 53-1 located in the third conductive layer, the first connection line 81 may be located at one side of the first center line O1 and the electrode connection line 53-1 may be located at the other side of the first center line O1 in the second direction Y, and positions of the first connection line 81 and the electrode connection line 53-1 may be disposed substantially symmetrically with respect to the first center line O1. In this way, quantities of transverse lines in the SD1 layer below the main body portion of the first anode 90A and the main body portion of the second anode 90B at a plurality of positions are substantially the same, and transverse lines below each anode are symmetrically disposed. This may ensure flatness and uniformity of the first anode 90A and the second anode 90B, which may not only ensure that light emitting performance of two light emitting devices is substantially identical and improve asymmetry of upper and lower color cast, but also avoid defect such as screen-off watermark caused by a height difference in anodes, thereby improving quality of the display substrate.

In an exemplary implementation mode, each of orthographic projections of the main body portion of the first anode 90A and the main body portion of the second anode 90B on the base substrate is at least partially overlapped with orthographic projections of three vertical electrodes on the base substrate. The three vertical electrodes may be two first connection electrodes 51 and one data connection electrode 83 located in the third conductive layer, and the data connection electrode 83 may be located between the two first connection electrodes 51. An orthographic projection of the data connection electrode 83 on the base substrate is at least partially overlapped with an orthographic projection of the second center line O2 on the base substrate, and positions of the two first connection electrodes 51 may be disposed substantially symmetrically with respect to the data connection electrode 83. In this way, quantities of vertical electrodes in the SD1 layer below the main body portion of the first anode 90A and the main body portion of second anodes 90B at a plurality of positions is substantially the same, and vertical electrodes below each anode are symmetrically disposed. This may ensure flatness and uniformity of the first anode 90A and the second anode 90B, which may not only ensure that light emitting performance of two light emitting devices is substantially identical and improve asymmetry of left and right color cast, but also avoid defects such as screen-off watermark caused by a height difference in anodes, thereby improving quality of the display substrate.

In an exemplary implementation mode, each of orthographic projections of the main body portion of the third anode 90C and the main body portion of the fourth anode 90D on the base substrate is at least partially overlapped with an orthographic projection of one transverse line on the base substrate, the transverse line may be the second initial signal line 42 located in the third conductive layer. In this way, quantities of transverse lines in the SD1 layer below the main body portion of the third anode 90C and the main body portion of the fourth anode 90D at a plurality of positions are substantially the same, which may ensure uniformity of the third anode 90C and the fourth anode 90D, and may ensure light emitting performance of two light emitting devices is substantially the same.

In an exemplary implementation mode, each of orthographic projections of the main body portion of the third anode 90C and the main body portion of the fourth anode 90D on the base substrate is at least partially overlapped with orthographic projections of three vertical electrodes on the base substrate. The three vertical electrodes may be two fifth connection electrodes 55 and one connection electrode strip 58-1 located in the third conductive layer, the connection electrode strip 58-1 may be located between the two fifth connection electrodes 55. An orthographic projection of the connection electrode strip 58-1 on the base substrate is at least partially overlapped with an orthographic projection of the second center line O2 on the base substrate, and the two fifth connection electrodes 55 may be disposed substantially symmetrically with respect to the connection electrode strip 58-1. Or, the three vertical electrodes may be a dummy electrode strip 59-1 of one dummy connection electrode 59 and two fifth connection electrodes 55 located in the third conductive layer, the dummy electrode strip 59-1 may be located between the two fifth connection electrodes 55. An orthographic projection of the dummy electrode strip 59-1 on the base substrate is at least partially overlapped with an orthographic projection of the second center line O2 on the base substrate, and the two fifth connection electrodes 55 may be disposed substantially symmetrically with respect to the dummy electrode strip 59-1. In this way, quantities of vertical electrodes in the SD1 layer below the main body portion of the third anode 90C and the main body portion of the fourth anode 90D at a plurality of positions are substantially the same, and vertical electrodes below each anode are symmetrically disposed, so that flatness and uniformity of the third anode 90C and the fourth anode 90D may be ensured, which may ensure that light emission performance of two light emitting devices is substantially the same, and improve asymmetry of left and right color cast, but also avoid defects such as screen-off watermark caused by a height difference in anodes, and improve quality of the display substrate.

In an exemplary implementation mode, orthographic projections of the main body portion of the first anode 90A and the main body portion of the second anode 90B on the base substrate may contain an orthographic projection of the data connection electrode 83 on the base substrate.

In an exemplary implementation mode, an orthographic projection of the data connection electrode 83 on the base substrate may be disposed substantially symmetrically with respect to an orthographic projection of the first center line O1 on the base substrate, and the orthographic projection of the data connection electrode 83 on the base substrate may be disposed substantially symmetrically with respect to an orthographic projection of the second center line O2 on the base substrate.

In an exemplary implementation mode, orthographic projections of the first connection sub-block 83-1, the second connection sub-block 83-2, and the connection sub-strip 83-3 in the data connection electrode 83 on the base substrate are at least partially overlapped with an orthographic projection of the second center line O2 on the base substrate.

In an exemplary implementation mode, orthographic projections of the first connection sub-block 83-1 and the second connection sub-block 83-2 in the data connection electrode 83 on the base substrate may be disposed substantially symmetrically with respect to an orthographic projection of the first center line O1 on the base substrate. For a twenty-fourth via that achieves a connection between the second connection line 82 and the first connection sub-block 83-1 and a twenty-fourth via that achieves a connection between the second connection line 82 and the second connection sub-block 83-2, orthographic projections of the two twenty-fourth vias on the base substrate may be disposed substantially symmetrically with respect to the orthographic projection of the first center line O1 on the base substrate.

In an exemplary implementation mode, an orthographic projection of the main body portion of the third anode 90C on the base substrate is at least partially overlapped with an orthographic projection of the twenty-seventh via V27 (connection via) on the base substrate, and an orthographic projection of the main body portion of the fourth anode 90D on the base substrate is at least partially overlapped with an orthographic projection of the twenty-eighth via V28 (dummy via) on the base substrate. Or, an orthographic projection of the main body portion of the third anode 90C on the base substrate is at least partially overlapped with an orthographic projection of the twenty-eighth via V28 (dummy via) on the base substrate, and an orthographic projection of the main body portion of the fourth anode 90D on the base substrate is at least partially overlapped with an orthographic projection of the twenty-seventh via V27 (connection via) on the base substrate. In the present disclosure, first planarization layer vias (PLN vias) are disposed below the main body portion of the third anode 90C and the main body portion of the fourth anode 90D at a plurality of positions by disposing dummy vias. This may not only improve uniformity of the third anode 90C and the fourth anode 90D, but also enable different regions to achieve a same display effect under transmitted and reflected light, achieve shadow elimination, effectively avoid poor appearance of the display substrate and occurrence of screen-off watermark, and improve display attribute and display quality.

In some other implementation modes, an orthographic projection of the main body portion of the third anode 90C on the base substrate is at least partially non-overlapped with an orthographic projection of the twenty-seventh via V27 (connection via) on the base substrate, and an orthographic projection of the main body portion of the fourth anode 90D on the base substrate is at least partially non-overlapped with an orthographic projection of the twenty-eighth via V28 (dummy via) on the base substrate. Or, an orthographic projection of the main body portion of the third anode 90C on the base substrate is at least partially non-overlapped with an orthographic projection of the twenty-eighth via V28 (dummy via) on the base substrate, and an orthographic projection of the main body portion of the fourth anode 90D on the base substrate is at least partially non-overlapped with an orthographic projection of the twenty-seventh via V27 (connection via) on the base substrate, and the present disclosure is not limited here.

In an exemplary implementation mode, the anode conductive layer may be of a single-layer structure, such as Indium Tin Oxide (ITO) or Indium Zinc Oxide (IZO), or may be of a multi-layer composite structure, such as ITO/Ag/ITO.

In an exemplary implementation mode, a subsequent preparation process may include: forming a pixel definition layer first, wherein the pixel definition layer is provided with a plurality of pixel openings, and the plurality of pixel openings expose a first anode, a second anode, a third anode, and a fourth anode, respectively; subsequently, forming an organic emitting layer by using an evaporation or inkjet printing process, then forming a cathode on the organic emitting layer, and then forming an encapsulation structure layer, wherein the encapsulation structure layer may include a first encapsulation layer, a second encapsulation layer, and a third encapsulation layer that are stacked, the first encapsulation layer and the third encapsulation layer may be made of an inorganic material, the second encapsulation layer may be made of an organic material, and the second encapsulation layer is disposed between the first encapsulation layer and the third encapsulation layer, which may ensure that external water vapor cannot enter the light emitting structure layer.

An exemplary embodiment of the present disclosure provides a display substrate. By adopting a mirror-symmetric design of pixel drive circuits and sharing of circuit nodes, first transistors T1 in adjacent unit columns are mirror-disposed and share a first electrode of a first transistor T1, seventh transistors T7 in adjacent unit columns are mirror-disposed and share a first electrode of a seventh transistor T7, and eighth transistors T8 in adjacent unit columns are mirror-disposed and share a first electrode of an eighth transistor T8, which may effectively reduce layout space, reduce quantities of vias and connection electrodes, reduce an occupied area of a pixel drive circuit, and be beneficial to achieve a high resolution.

In the embodiment of the present disclosure, by disposing a first connection line and a second connection line in a display region, a data leading-out line of a bonding region is connected with a data signal line through the first connection line and the second connection lines, so that a fan-shaped oblique line does not need to be disposed in a leading-out line region, which effectively reduces a length of the leading-out line region, greatly reduces a width of a lower bezel, and increases a screen-to-body ratio, which is beneficial to achieving full-screen display.

In the embodiment of the present disclosure, by disposing a first transistor T1 and a second transistor T2 having a double-gate structure, leakage of the first transistor T1 and the second transistor T2 may be effectively reduced, which is beneficial to meet a demand of low-frequency display.

In the embodiment of the present disclosure, by disposing a first shield electrode and a second shield electrode, the first shield electrode forms a coupling capacitance with a first active layer between two gate electrodes in the first transistor T1 and is connected with a third initial signal line, and the second shield electrode forms a coupling capacitance with a second active layer between two gate electrodes in the second transistor T2, and is connected with a first initial signal line, which, on one hand, may shield a node between two gate electrodes in the first transistor T1 and the second transistor T2, avoid an influence of data voltage jump on the first transistor T1 and the second transistor T2, reduce an influence of the data voltage jump on normal working of a pixel drive circuit, and on the other hand, utilizes a coupling capacitance to further reduce leakage of the first transistor T1 and the second transistor T2, thereby improving a display effect.

In the embodiment of the present disclosure, by disposing a third shield electrode, the third shield electrode is disposed between a second region of a first active layer in a semiconductor layer and a first connection line in a third conductive layer, and is connected with the first initial signal line, the third shield electrode may shield the first connection line, avoid an influence of data voltage jump in the first connection line on the first transistor T1 and the second transistor T2, reduce an influence of the data voltage jump on normal working of the pixel drive circuit, and improve the display effect.

In the embodiment of the present disclosure, by disposing a fourth shield electrode, the fourth shield electrode is disposed between a first node N1 and a data signal line and is connected with the first initial signal line, an influence of the data signal line on the first node N1 may be avoided, an influence of data voltage jump on normal working of the pixel drive circuit may be reduced, and the display effect may be improved.

In the embodiment of the present disclosure, the first initial signal line with a main body portion extending along a first direction X and a first initial connection line with a main body portion extending along a second direction Y are disposed, and the first initial signal line and the first initial connection line are connected with each other to form a mesh communication structure for transmitting a first initial signal on the display substrate, so that not only a resistance of the first initial signal line may be effectively reduced and a voltage drop of the first initial signal may be reduced, but also uniformity of the first initial signal in the display substrate may be effectively improved, uniformity of display may be effectively improved, and display quality may be improved.

In the embodiment of the present disclosure, a second initial signal line with a main body portion extending along the first direction X and a second initial connection line with a main body portion extending along the second direction Y are disposed, and the second initial signal line and the second initial connection line are connected with each other to form a mesh communication structure for transmitting a second initial signal on the display substrate, so that not only a resistance of the second initial signal line may be effectively reduced and a voltage drop of the second initial signal may be reduced, but also uniformity of the second initial signal in the display substrate may be effectively improved, uniformity of display may be effectively improved, and display quality may be improved.

In the embodiment of the present disclosure, a third initial signal line with a main body portion extending along the first direction X and a third initial connection line with a main body portion extending along the second direction Y are disposed, and the third initial signal line and the third initial connection line are connected with each other to form a mesh communication structure for transmitting a third initial signal on the display substrate, so that not only a resistance of the third initial signal line may be effectively reduced and a voltage drop of the third initial signal may be reduced, but also uniformity of the third initial signal in the display substrate may be effectively improved, uniformity of display may be effectively improved, and display quality may be improved.

In the embodiment of the present disclosure, by disposing the second connection line below anodes of a red light emitting unit and a blue light emitting unit, and disposing an initial connection line below anodes of a first green light emitting unit and a second green light emitting unit, it may be ensured that light emitting performance of a plurality of light emitting devices is substantially the same.

In the embodiment of the present disclosure, by disposing each of orthographic projections of a main body portion of a first anode and a main body portion of a second anode on the base substrate is at least partially overlapped with orthographic projections of two transverse lines on the base substrate, is at least partially overlapped with orthographic projections of three vertical electrodes on the base substrate, and is at least partially overlapped with orthographic projections of three signal lines on the base substrate, metal lines below the first anode and the second anode are basically the same, and metal lines below each anode are symmetrically disposed, which may ensure flatness and uniformity of the first anode and the second anode. This not only may ensure that light emitting performance of two light emitting devices is basically the same, may improve asymmetry of left and right color cast, but also may avoid defects such as screen-off watermark caused by a height difference in anodes, thus improving quality of the display substrate.

In the embodiment of the present disclosure, by disposing each of orthographic projections of a main body portion of a third anode and a main body portion of a fourth anode on the base substrate is at least partially overlapped with an orthographic projection of one transverse line on the base substrate, and is at least partially overlapped with orthographic projections of three vertical electrodes on the base substrate, and is at least partially overlapped with orthographic projections of three signal lines on the base substrate, metal lines below the third anode and the fourth anode are basically the same, and metal lines below each anode are symmetrically disposed, which may ensure flatness and uniformity of the third anode and the fourth anode. This not only may ensure that light emitting performance of two light emitting devices is basically the same, may improve asymmetry of left and right color cast, but also may avoid defects such as screen-off watermark caused by a height difference in anodes, thus improving quality of the display substrate.

In the embodiment of the present disclosure, by disposing a dummy via, first planarization layer vias are disposed below the third anode and the fourth anode 90D at a plurality of positions, which not only may improve uniformity of the third anode and the fourth anode, but also may enable different regions to achieve a same display effect under transmitted and reflected light, achieve shadow elimination, effectively avoid occurrence of poor appearance of the display substrate and occurrence of screen-off watermark, and improve display attribute and display quality.

The present disclosure achieves a combination of an 8T1C pixel drive circuit structure and a 2SD FIP through the above structure, which may not only improve flicker of low-frequency display, but also reduce a width of a lower bezel and improve a screen-to-body ratio. By optimizing a layout of pixel drive circuits, the present disclosure may not only improve the upper and lower color cast and the left and right color cast, but also reduce an occupied area of a pixel drive circuit, thereby improving a resolution and a transmittance.

The preparation process of the embodiment of the present disclosure may be compatible well with existing preparation processes, is simple in process implementation, is easy to implement, and has a high production efficiency, a low production cost, and a high yield.

The structure shown and mentioned above in the present disclosure and the preparation process therefor are merely an exemplary description. In an exemplary implementation mode, corresponding structures may be altered and the patterning processes may be added or reduced according to actual needs.

In an exemplary implementation mode, the display substrate according to the present disclosure may be applied to a display apparatus with a pixel drive circuit, such as an OLED, quantum dot display (QLED), light emitting diode display (Micro LED or Mini LED), or Quantum Dot Light Emitting Diode display (QDLED), which is not limited here in the present disclosure.

The present disclosure also provides another display substrate. In an exemplary implementation mode, the display substrate includes a plurality of circuit units forming a plurality of unit rows and a plurality of unit columns, and at least one circuit unit includes a pixel drive circuit and at least one initial signal line. The pixel drive circuit includes at least one initialization transistor, and the initial signal line is connected with the initialization transistor through a connection electrode. In at least one unit row, two initialization transistors in adjacent circuit units are connected with the connection electrode through a same via, or two connection electrodes in adjacent circuit units are connected with the initial signal line through a same via.

In an exemplary implementation mode, the at least one initial signal line may include a first initial signal line, and the at least one initialization transistor may include a first transistor as a first initialization transistor. The first transistor includes at least a first active layer, and the first initial signal line is connected with a first region of the first active layer through a sixth connection electrode. Herein, pixel drive circuits in adjacent circuit units share the first region of the first active layer, the pixel drive circuits in the adjacent circuit units share the sixth connection electrode, and the sixth connection electrode is connected with first regions of two first active layers in the adjacent circuit units through a same via.

In an exemplary implementation mode, the at least one initial signal line may include a second initial signal line, and the at least one initialization transistor may include a seventh transistor as the second initialization transistor. The seventh transistor includes at least a seventh active layer, and the second initial signal line is connected with a first region of the seventh active layer through a second initial connection block. Herein, pixel drive circuits in adjacent circuit units share the first region of the seventh active layer, the pixel drive circuits in the adjacent circuit units share the second initial connection block, and the second initial connection block is connected with first regions of two seventh active layers in the adjacent circuit units through a same via.

In an exemplary implementation mode, the at least one initial signal line may include a third initial signal line, and the at least one initialization transistor may include an eighth transistor as the third initialization transistor. The eighth transistor includes at least an eighth active layer, and the third initial signal line is connected with a first region of the eighth active layer through a seventh connection electrode. Herein, seventh connection electrodes in adjacent circuit units are of an interconnected integral structure, pixel drive circuits in adjacent circuit units share the seventh connection electrodes, and the third initial signal line is connected with two seventh connection electrodes in the adjacent circuit units through a same via.

The present disclosure also provides a preparation method of a display substrate, for manufacturing the display substrate according to the foregoing embodiments. In an exemplary implementation mode, the preparation method may include: forming a drive structure layer on a base substrate, wherein the drive structure layer includes a plurality of circuit units forming a plurality of unit rows and a plurality of unit columns, and at least one circuit unit includes a pixel drive circuit, a first initial signal line, a second initial signal line, and a third initial signal line, the pixel drive circuit includes at least a first transistor as a first initialization transistor, a seventh transistor as a second initialization transistor, and an eighth transistor as a third initialization transistor, the first initial signal line is connected with a first electrode of the first transistor, the second initial signal line is connected with a first electrode of the seventh transistor, and the third initial signal line is connected with a first electrode of the eighth transistor; in at least one unit row, pixel drive circuits in at least two adjacent circuit units share the first electrode of the first transistor, the pixel drive circuits in at least two adjacent circuit units share the first electrode of the seventh transistor, and the pixel drive circuits in at least two adjacent circuit units share the first electrode of the eighth transistor; and forming, on the drive structure layer, a light emitting structure layer.

The present disclosure also provides a display apparatus which includes the aforementioned display substrate. The display apparatus may be any product or component with a display function, such as a mobile phone, a tablet computer, a television, a display, a laptop computer, a digital photo frame, and a navigator, which is not limited in the embodiments of the present invention.

Although implementation modes disclosed in the present disclosure are as above, it should be noted that the above implementation modes are exemplary only rather than restrictive. Therefore, the present disclosure is not limited to what is specifically shown and described here. Various modifications, substitutions, or omissions may be made in forms and details of implementation without departing from the scope of the present disclosure.

## Claims

1. A display substrate, comprising a drive structure layer disposed on a base substrate and a light emitting structure layer disposed at a side of the drive structure layer away from the base substrate, wherein the drive structure layer comprises a plurality of circuit units forming a plurality of unit rows and a plurality of unit columns, at least one circuit unit comprises a pixel drive circuit, a first initial signal line, a second initial signal line, and a third initial signal line; the pixel drive circuit comprises at least a first transistor as a first initialization transistor, a seventh transistor as a second initialization transistor, and an eighth transistor as a third initialization transistor, the first initial signal line is connected with a first electrode of the first transistor, the second initial signal line is connected with a first electrode of the seventh transistor, and the third initial signal line is connected with a first electrode of the eighth transistor; in at least one unit row, pixel drive circuits in at least two adjacent circuit units share the first electrode of the first transistor, the pixel drive circuits in at least two adjacent circuit units share the first electrode of the seventh transistor, and the pixel drive circuits in at least two adjacent circuit units share the first electrode of the eighth transistor.

2. The display substrate according to claim 1, wherein the first transistor comprises at least a first active layer, and the first initial signal line is connected with a first region of the first active layer through a sixth connection electrode; in at least one unit row, pixel drive circuits in adjacent circuit units share the sixth connection electrode.

3. The display substrate according to claim 1, wherein the seventh transistor comprises at least a seventh active layer, and the second initial signal line is connected with a first region of the seventh active layer through a second initial connection block; in at least one unit row, pixel drive circuits in adjacent circuit units share the second initial connection block.

4. The display substrate according to claim 1, wherein the eighth transistor comprises at least an eighth active layer, and the third initial signal line is connected with a first region of the eighth active layer through a seventh connection electrode; in at least one unit row, pixel drive circuits in adjacent circuit units share the seventh connection electrode.

5. The display substrate according to claim 1, wherein the first initial signal line, the second initial signal line, and the third initial signal line extend along a first direction, and the drive structure layer further comprises a first initial connection line, a second initial connection line, and a third initial connection line extending along a second direction, the first direction intersects with the second direction; the first initial connection line is connected with the first initial signal line through a sixth connection electrode to form a mesh communication structure for transmitting a first initial signal, or the second initial connection line is connected with the second initial signal line through an eighth connection electrode to form a mesh communication structure for transmitting a second initial signal, or the third initial connection line is connected with the third initial signal line through a seventh connection electrode to form a mesh communication structure for transmitting a third initial signal.

6. The display substrate according to claim 5, wherein the first initial connection line, the second initial connection line, and the third initial connection line are respectively disposed between adjacent unit columns, and the first initial connection line, the second initial connection line, the third initial connection line, and the second initial connection line are periodically disposed in the first direction.

7. The display substrate according to claim 5, wherein the light emitting structure layer comprises at least a plurality of red light emitting units that emit red light, a plurality of blue light emitting units that emit blue light, a plurality of first green light emitting units that emit green light, and a plurality of second green light emitting units that emit green light, a red light emitting unit of the red light emitting units comprises at least a first anode, a blue light emitting unit of the blue light emitting units comprises at least a second anode, a first green light emitting unit of the first green light emitting units comprises at least a third anode, and a second green light emitting unit of the second green light emitting units comprises at least a fourth anode; at least one of the first anode, the second anode, the third anode, and the fourth anode comprises a main body portion and a connection portion that are connected with each other; a first end of the connection portion is connected with the main body portion, and a second end of the connection portion is connected with an anode connection electrode in the pixel drive circuit through an anode via; orthographic projections of a main body portion of the third anode and a main body portion of the fourth anode on the base substrate are at least partially overlapped with an orthographic projection of the first initial connection line on the base substrate, or orthographic projections of a main body portion of the third anode and a main body portion of the fourth anode on the base substrate are at least partially overlapped with an orthographic projection of the second initial connection line on the base substrate, or orthographic projections of a main body portion of the third anode and a main body portion of the fourth anode on the base substrate are at least partially overlapped with an orthographic projection of the third initial connection line on the base substrate.

8. The display substrate according to claim 5, wherein in a direction perpendicular to the base substrate, the drive structure layer comprises at least a first conductive layer disposed on the base substrate, a second conductive layer disposed at a side of the first conductive layer away from the base substrate, a third conductive layer disposed at a side of the second conductive layer away from the base substrate, and a fourth conductive layer disposed at a side of the third conductive layer away from the base substrate, the first initial signal line, the second initial signal line, and the third initial signal line are respectively disposed in at least one layer of the second conductive layer and the third conductive layer, and the first initial connection line, the second initial connection line, and the third initial connection line are disposed in the fourth conductive layer.

9. The display substrate according to claim 8, wherein the drive structure layer further comprises a first planarization layer disposed at a side of the third conductive layer away from the base substrate, and the fourth conductive layer is disposed at a side of the first planarization layer away from the base substrate; the at least one circuit unit further comprises a connection via, and the third initial connection line is connected with the seventh connection electrode through the connection via; at least another circuit unit further comprises a dummy via, and the first initial connection line and/or the second initial connection line are at least partially disposed within the dummy via.

10. The display substrate according to claim 9, wherein the light emitting structure layer comprises at least a plurality of red light emitting units that emit red light, a plurality of blue light emitting units that emit blue light, a plurality of first green light emitting units that emit green light, and a plurality of second green light emitting units that emit green light, a red light emitting unit of the red light emitting units comprises at least a first anode, a blue light emitting unit of the blue light emitting units comprises at least a second anode, a first green light emitting unit of the first green light emitting units comprises at least a third anode, and a second green light emitting unit of the second green light emitting units comprises at least a fourth anode; at least one of the first anode, the second anode, the third anode, and the fourth anode comprises a main body portion and a connection portion that are connected with each other; a first end of the connection portion is connected with the main body portion, and a second end of the connection portion is connected with an anode connection electrode in the pixel drive circuit through an anode via; an orthographic projection of a main body portion of the third anode on the base substrate is at least partially overlapped with an orthographic projection of the connection via on the base substrate and an orthographic projection of a main body portion of the fourth anode on the base substrate is at least partially overlapped with an orthographic projection of the dummy via on the base substrate, or an orthographic projection of a main body portion of the third anode on the base substrate is at least partially overlapped with an orthographic projection of the dummy via on the base substrate and an orthographic projection of a main body portion of the fourth anode on the base substrate is at least partially overlapped with an orthographic projection of the connection via on the base substrate.

11. The display substrate according to claim 9, wherein the light emitting structure layer comprises at least a plurality of red light emitting units that emit red light, a plurality of blue light emitting units that emit blue light, a plurality of first green light emitting units that emit green light, and a plurality of second green light emitting units that emit green light, a red light emitting unit of the red light emitting units comprises at least a first anode, a blue light emitting unit of the blue light emitting units comprises at least a second anode, a first green light emitting unit of the first green light emitting units comprises at least a third anode, and a second green light emitting unit of the second green light emitting units comprises at least a fourth anode; at least one of the first anode, the second anode, the third anode, and the fourth anode comprises a main body portion and a connection portion that are connected with each other; a first end of the connection portion is connected with the main body portion, and a second end of the connection portion is connected with an anode connection electrode in the pixel drive circuit through an anode via; an orthographic projection of a main body portion of the third anode on the base substrate is at least partially non-overlapped with an orthographic projection of the connection via on the base substrate and an orthographic projection of a main body portion of the fourth anode on the base substrate is at least partially non-overlapped with an orthographic projection of the dummy via on the base substrate, or an orthographic projection of a main body portion of the third anode on the base substrate is at least partially non-overlapped with an orthographic projection of the dummy via on the base substrate and an orthographic projection of a main body portion of the fourth anode on the base substrate is at least partially non-overlapped with an orthographic projection of the connection via on the base substrate.

12. The display substrate according to claim 5, wherein the eighth connection electrode comprises a connection electrode strip and a connection electrode block, the connection electrode strip has a strip shape extending along the second direction, and the connection electrode block has a block shape, a first end of the connection electrode strip is connected with the second initial signal line, a second end of the connection electrode strip extends along a direction away from the second initial signal line, and is connected with the connection electrode block, the second initial connection line is connected with the connection electrode block through a via; the at least one circuit unit further comprises a dummy electrode strip, a first end of the dummy electrode strip is connected with the second initial signal line, a second end of the dummy electrode strip extends along the direction away from the second initial signal line; the connection electrode strip and the dummy electrode strip are alternately disposed in the first direction.

13. The display substrate according to claim 12, wherein the at least one circuit unit further comprises a dummy electrode block and a dummy via, the dummy electrode block is in a block shape and is connected with the second end of the dummy electrode strip, and an orthographic projection of the dummy via on the base substrate is within a range of an orthographic projection of the dummy electrode block on the base substrate, and the first initial connection line and/or the third initial connection line are at least partially disposed within the dummy via.

14. The display substrate according to claim 13, wherein the connection electrode block and the dummy electrode block are located on one straight line extending along the first direction.

15. The display substrate according to claim 12, wherein the light emitting structure layer comprises at least a plurality of red light emitting units that emit red light, a plurality of blue light emitting units that emit blue light, a plurality of first green light emitting units that emit green light, and a plurality of second green light emitting units that emit green light, a red light emitting unit of the red light emitting units comprises at least a first anode, a blue light emitting unit of the blue light emitting units comprises at least a second anode, a first green light emitting unit of the first green light emitting units comprises at least a third anode, and a second green light emitting unit of the second green light emitting units comprises at least a fourth anode; at least one of the first anode, the second anode, the third anode, and the fourth anode comprises a main body portion and a connection portion that are connected with each other; a first end of the connection portion is connected with the main body portion, and a second end of the connection portion is connected with an anode connection electrode in the pixel drive circuit through an anode via; an orthographic projection of a main body portion of the third anode on the base substrate is at least partially overlapped with an orthographic projection of the connection electrode strip on the base substrate and an orthographic projection of a main body portion of the fourth anode on the base substrate is at least partially overlapped with an orthographic projection of the dummy electrode strip on the base substrate, or an orthographic projection of a main body portion of the third anode on the base substrate is at least partially overlapped with an orthographic projection of the dummy electrode on the base substrate and an orthographic projection of a main body portion of the fourth anode on the base substrate is at least partially overlapped with an orthographic projection of the connection electrode strip on the base substrate.

16. The display substrate according to claim 1, wherein the pixel drive circuit further comprises a second transistor as a compensation transistor and a third transistor as a drive transistor, a first electrode of the second transistor is connected with a second electrode of the first transistor and a gate electrode of the third transistor, respectively, and a second electrode of the second transistor is connected with a second electrode of the third transistor; the first transistor and the second transistor are of a dual-gate structure.

17. The display substrate according to claim 1, wherein the drive structure layer further comprises a plurality of data signal lines extending along a second direction, a plurality of first connection lines extending along a first direction, and a plurality of second connection lines extending along the second direction, the first direction intersects with the second direction; at least one data signal line is connected with a plurality of pixel drive circuits of one unit column, first ends of the plurality of first connection lines are correspondingly connected with the plurality of data signal lines, and second ends of the plurality of first connection lines are correspondingly connected with the plurality of second connection lines.

18. The display substrate according to claim 17, wherein the light emitting structure layer comprises at least a plurality of red light emitting units that emit red light, a plurality of blue light emitting units that emit blue light, a plurality of first green light emitting units that emit green light, and a plurality of second green light emitting units that emit green light, a red light emitting unit of the red light emitting units comprises at least a first anode, a blue light emitting unit of the blue light emitting units comprises at least a second anode, a first green light emitting unit of the first green light emitting units comprises at least a third anode, and a second green light emitting unit of the second green light emitting units comprises at least a fourth anode; at least one of the first anode, the second anode, the third anode, and the fourth anode comprises a main body portion and a connection portion that are connected with each other; a first end of the connection portion is connected with the main body portion, and a second end of the connection portion is connected with an anode connection electrode in the pixel drive circuit through an anode via; orthographic projections of a main body portion of the first anode and a main body portion of the second anode on the base substrate are at least partially overlapped with an orthographic projection of a second connection line of the second connection lines on the base substrate.

19. The display substrate according to claim 18, wherein the drive structure layer further comprises a data connection electrode, and the second connection line is connected with the data connection electrode through a via; an orthographic projection of the data connection electrode on the base substrate is within a range of an orthographic projection of the main body portion of the first anode on the base substrate, and/or the orthographic projection of the data connection electrode on the base substrate is within a range of an orthographic projection of the main body portion of the second anode on the base substrate.

20. A display substrate, comprising a plurality of circuit units forming a plurality of unit rows and a plurality of unit columns, wherein at least one circuit unit comprises a pixel drive circuit and at least one initial signal line; the pixel drive circuit comprises at least one initialization transistor, and the initial signal line is connected with the initialization transistor through a connection electrode; in at least one unit row, two initialization transistors in adjacent circuit units are connected with the connection electrode through a same via, or two connection electrodes in adjacent circuit units are connected with the initial signal line through a same via.

21. A display apparatus, comprising a display substrate according to any one of claims 1 to 19.

22. A preparation method of a display substrate, comprising:
forming a drive structure layer on a base substrate; wherein the drive structure layer comprises a plurality of circuit units forming a plurality of unit rows and a plurality of unit columns, and at least one circuit unit comprises a pixel drive circuit, a first initial signal line, a second initial signal line, and a third initial signal line; the pixel drive circuit comprises at least a first transistor as a first initialization transistor, a seventh transistor as a second initialization transistor, and an eighth transistor as a third initialization transistor, wherein the first initial signal line is connected with a first electrode of the first transistor, the second initial signal line is connected with a first electrode of the seventh transistor, and the third initial signal line is connected with a first electrode of the eighth transistor; in at least one unit row, pixel drive circuits in at least two adjacent circuit units share the first electrode of the first transistor, the pixel drive circuits in at least two adjacent circuit units share the first electrode of the seventh transistor, and the pixel drive circuits in at least two adjacent circuit units share the first electrode of the eighth transistor; and
forming, on the drive structure layer, a light emitting structure layer.
